# EUROPEAN PATENT APPLICATION

(11) **EP 4 654 401 A1**
(43) Date of publication of application: **26.11.2025**
(21) Application number: 24744306.2
(22) Date of filing: 17.01.2024
(51) Int. Cl.: H01S 5/026, H01S 5/183

(54) **PACKAGING STRUCTURE**

(30) Priority: 19.01.2023 US 202363480544 P; 18.05.2023 US 202363502936 P; 12.09.2023 US 202363581995 P
(71) Applicant: Ireach Corporation, Hsinchu Taiwan 300 (TW)
(72) Inventor: CHUNG, Hsin-Chan, Hsinchu Taiwan 300 (CN); HSU, Tzu-Chieh, Hsinchu Taiwan 300 (CN); LU, Chun-Yi, Hsinchu Taiwan 300 (CN); LI, Jun-Yi, Hsinchu Taiwan 300 (CN); CHEN, Shou-Lung, Hsinchu Taiwan 300 (CN); HUANG, Kuan-Chih, Hsinchu Taiwan 300 (CN); YANG, Hsiu-Ju, Hsinchu Taiwan 300 (CN)
(74) Representative: Murgitroyd & Company
(86) International application number: PCT/CN2024/072782
(87) International publication number: WO 2024/153132

(57) **Abstract**

A packaging structure, comprising a light-emitting epitaxial structure (2100), a light receiving structure (2200), a first conductive structure (2100P), a second conductive structure (2200N), and a third conductive structure (2400). The light-emitting epitaxial structure (2100) comprises, which are stacked successively, an upper distributed Bragg reflector (2100U), an active structure (2100A) and a lower distributed Bragg reflector (2100L). The light receiving structure (2200) is located below the active structure (2100A) and is in contact with the light-emitting epitaxial structure (2100). The first conductive structure (2100P) is in contact with the upper distributed Bragg reflector (2100U) and extends to cover the lower surface (2200B) of the light receiving structure (2200), the second conductive structure (2200N) is in contact with the lower surface (2200B) of the light receiving structure (2200), and the third conductive structure (2400) is in contact with the upper surface (2100LT) of the lower distributed Bragg reflector (2100L) and extends to cover the lower surface (2200B) opposite to the upper surface (2100LT). The first conductive structure (2100P) is insulated from the second conductive structure (2200N), the first conductive structure (2100P) is insulated from the third conductive structure (2400), and the second conductive structure (2200N) is insulated from the third conductive structure (2400).

## Description

### TECHNICAL FIELD

The present application relates to a packaging structure, and in particular to a packaging structure of an optoelectronic device.

### BACKGROUND OF THE INVENTION

Vertical Cavity Surface Emitting Laser (VCSEL) is a type of semiconductor laser component. Due to its structural advantage of emitting light from the epitaxial surface, and with the emergence of more application needs such as various Internet of Things products, smart electronic products and smart sensing products and driven by market demand, VCSEL components have gradually expanded from the network communication product market to various smart products (for example, optical communication light source modules, proximity sensors in smart tablet phones and smart headphones, depth, distance and 3D sensors, lidar sensors for advanced driver assistance systems, micro-projection display light sources or panels, eye trackers in interactive devices, integrated optical circuits, etc.).

In most of the aforementioned current application products, due to various requirements in product development and product use (for example, low cost, light weight for portability, miniaturization, high integration and matching with other components, strict environmental reliability in automotive applications, long product life, low power consumption, long usage time, high-frequency electrical drive operation, etc.), more and more VCSEL devices adopt flip-chip packaging technology to meet the aforementioned requirements and specifications.

### SUMMARY OF THE INVENTION

In view of this, the present application provides packaging structures in different embodiments.

In some embodiments, a packaging structure is provided, comprising a light-emitting epitaxial structure, a light-receiving structure, a first conductive structure, a second conductive structure, and a third conductive structure. The light-emitting epitaxial structure comprises an upper Distributed Bragg Reflector (DBR), an active structure, and a lower DBR stacked in sequence. The light-receiving structure is located under the active structure and contacts the light-emitting epitaxial structure. The first conductive structure contacts the upper DBR and extends to cover the lower surface of the light-receiving structure. The second conductive structure contacts the light-receiving structure on the lower surface. The third conductive structure contacts the upper surface of the lower DBR and extends to cover the lower surface relative to the upper surface. The first conductive structure is insulated from the second conductive structure, and the first conductive structure is insulated from the third conductive structure. The second conductive structure is insulated from the third conductive structure.

In some embodiments, the upper DBR includes a P-type semiconductor structure, and the lower DBR includes an N-type semiconductor structure.

In some embodiments, the first conductive structure is a P-electrode of the light-emitting epitaxial structure.

In some embodiments, the second conductive structure is an N-electrode of the light receiving structure.

In some embodiments, the third conductive structure is a common electrode of the light-emitting epitaxial structure and the light-receiving structure.

In some embodiments, the light receiving structure is integrally formed as a part of the lower DBR.

In some embodiments, the packaging structure further includes a transparent substrate, which is bonded to the light-emitting epitaxial structure via a first adhesive layer, wherein the transparent substrate and the first adhesive layer are transparent to the light emitted by the light-emitting epitaxial structure.

**In** some embodiments, the light receiving structure is bonded to the lower DBR via a second adhesive layer.

**In** some embodiments, the second adhesive layer is conductive.

**In** some embodiments, the packaging structure further includes another DBR located under the light receiving structure.

In some embodiments, a singularization method of an epitaxial wafer is provided, wherein the epitaxial wafer comprises a semiconductor stacking layer and a base layer, wherein the semiconductor stacking layer is located on an upper surface of the base layer, wherein the base layer can be made of sapphire, glass or a III-V compound. The method comprises: a processing step, a cutting step and a splitting step. Processing step: using a stealth cutting process technology to process a portion of the inner region of the base layer from the upper surface of the epitaxial wafer, and forming a processing area in the portion of the inner region of the base layer, wherein the processing area comprises at least one row of breaking points, the extension direction of the at least one row of breaking points is substantially parallel to the extension direction of the lower surface of the epitaxial wafer, and the distance between the processing area and the upper surface of the epitaxial wafer does not exceed 60 microns. Cutting step: using a laser lift-off technology or a wheel knife cutting technology to cut another portion of the base layer from the lower surface of the epitaxial wafer, and forming a cutting street in the other portion of the base layer, wherein the cutting street has a cutting width and a cutting depth, the cutting width is less than 20 microns, and the cutting depth is 30 microns. Splitting step: using a splitting technique on the cutting street to split the epitaxial wafer into a plurality of semiconductor lasers.

In some embodiments, a method for singulating an epitaxial wafer is provided, wherein the epitaxial wafer comprises a semiconductor stacking layer and a base layer, wherein the semiconductor stacking layer is located on an upper surface of the base layer, wherein the base layer can be made of sapphire, glass, or a III-V compound. The method comprises: a cutting step and a cleaving step. The cutting step: using a laser lift-off technique or a wheel knife cutting technique to separate the base layer from the lower surface of the epitaxial wafer. A portion of the layer is cut to form a cutting street in the portion of the base layer, wherein the cutting street has a cutting width and a cutting depth, the cutting width is less than 10 microns, and the cutting depth does not exceed 90 microns. A splitting step: using a splitting technique on the cutting street to split the epitaxial wafer into a plurality of semiconductor lasers.

In some embodiments, the stealth cutting technique is achieved using a laser having a wavelength of 1064 nanometers.

In some embodiments, the III-V compound can be GaAs ' InP or GaSb.

In some embodiments, a semiconductor laser is provided, comprising a base layer, an epitaxial structure located on the base layer, an insulating layer, a first electrode, and a second electrode. The epitaxial structure comprises an upper reflector, a lower reflector, and an active area between the upper reflector and the lower reflector. The upper reflector, the active area, and the lower reflector are stacked on the base layer. The second electrode is on the epitaxial structure and electrically connected to the semiconductor layer of the upper reflector. The first electrode is on the base layer and electrically connected to the semiconductor layer of the upper reflector. The second electrode comprises at least one metal layer and a P-type contact layer, connecting the P-type semiconductor layer of the upper reflector, and the first electrode comprises at least one metal layer connected to the base layer and electrically connected to the N-type semiconductor layer of the lower reflector. The insulating layer is located between the epitaxial structure and the second electrode, and extends to the side of the epitaxial structure to prevent the second electrode from directly contacting the active area and the lower reflector. Wherein, the side surface of the base layer has at least one row of breaking points.

In some embodiments, the semiconductor laser may be a vertical cavity surface emitting laser of a vertical chip structure or a flip chip vertical cavity surface emitting laser.

In some embodiments, a VCSEL chip is provided, comprising a base layer, an epitaxial structure located on the base layer, an insulating layer, a first electrode, and a second electrode. The epitaxial structure comprises an upper reflector, a lower reflector, and an active area between the upper reflector and the lower reflector. The upper reflector, the active area, and the lower reflector are stacked on the base layer. The second electrode is on the epitaxial structure and electrically connected to the semiconductor layer of the upper reflector. The first electrode is on the base layer and electrically connected to the semiconductor layer of the upper reflector. The second electrode comprises at least one metal layer and a P-type contact layer, connected to the P-type semiconductor layer of the upper reflector, and the first electrode comprises at least one metal layer connected to the base layer and electrically connected to the N-type semiconductor layer of the lower reflector. The insulating layer is located between the epitaxial structure and the second electrode, and extends to the side of the epitaxial structure to prevent the second electrode from directly contacting the active area and the lower reflector.

In some embodiments, at least one region of the second electrode has at least one set of patterns to indicate the relative position of the VCSEL chip on an epitaxial wafer. In some embodiments, the at least one region is at least one side or at least one corner of the second electrode.

In some other embodiments, at least one region of the insulating layer has at least one set of patterns for Indicating the relative position of the VCSEL chip on an epitaxial wafer. In some embodiments, the at least one region is at least one side or at least one corner of the insulating layer.

Furthermore, in some embodiments, at least two of a region of the insulating layer of the epitaxial structure and a region of the second electrode respectively have at least one set of patterns for indicating the relative position of the VCSEL chip on an epitaxial wafer in the horizontal direction and the vertical direction.

In some embodiments, a semiconductor laser chip is provided, including a base layer and a semiconductor stack layer formed on the base layer, wherein the base layer has a stepped structure on a side opposite to the semiconductor stack layer.

In some embodiments, the packaging structure of the optoelectronic unit is further formed with an upper electrode and a lower electrode, the upper electrode is formed on the semiconductor stack layer of the VCSEL chip, and the lower electrode is formed on the bottom surface of the semiconductor stack layer of the VCSEL chip. The upper electrode is electrically connected to the first type semiconductor layer of the semiconductor stack layer, and the lower electrode is electrically connected to the second type semiconductor layer of the semiconductor stack layer through the base layer.

In some embodiments, a VSCEL chip is provided, comprising: a base layer, a semiconductor stacking layer, a first electrode structure, a second electrode structure and an insulating layer. The semiconductor stacking layer is located on the base layer, and the semiconductor stacking layer has a first surface, a second surface and a side surface. The second surface is opposite to the first surface, and the side surface is located between the first surface and the second surface. The semiconductor stacking layer includes a first type semiconductor layer, a second type semiconductor layer and an active layer. The active layer is located between the first type semiconductor layer and the second type semiconductor layer. The base layer is located on the side of the second type semiconductor layer relative to the first type semiconductor layer. The base layer can be a growth substrate for the semiconductor stacking layer, that is, the semiconductor stacking layer grows directly on the base layer. The base layer is conductive, and the base layer has a bottom and a mesa portion extending from the bottom, the mesa portion has a mesa surface (connected to the second surface) and a mesa side surface, and the mesa side surface is connected to the mesa surface. The bottom has a bottom first surface, a bottom second surface and a bottom side surface. The bottom first surface is connected to the mesa side surface, the bottom second surface is opposite to the bottom first surface, and the bottom side surface is located between the bottom first surface and the bottom second surface. The insulating layer is located on the first surface and extends through the side surface, the mesa surface, and the mesa side surface to the bottom first surface. The insulating layer has an opening, and the opening is located on the first surface. The first electrode structure is located in the opening and contacts the first type semiconductor layer. The first electrode structure is further located on the first surface and extends through the side, the platform surface, and the platform side to the bottom first surface. The insulating layer further extends through the bottom first surface to the bottom side. The second type semiconductor layer in the semiconductor stack layer also includes a plateau portion and a lateral extension distributed on the platform surface, and the insulating layer and the first electrode structure are further located on the surface of the plateau portion. The second electrode structure is located on the bottom second surface. Therefore, when the VSCEL chip is subsequently electrically bonded to the electrode pad on the carrier, since the first electrode structure extends to the platform side, the bonding area between the electrode structure on one side of the VSCEL chip and the bonding structure (e.g., solder paste) for bonding to the carrier board can be increased without increasing the size of the VSCEL chip. In this way, when the VSCEL chip is packaged, the chip size can be reduced while maintaining the electrode pad spacing of the carrier board.

In some embodiments, a photoelectric module is provided, comprising a driver chip, a light emitting device and a light receiving device. The driver chip is electrically connected to the light emitting device and the light receiving device.

In one or more embodiments, the light emitting device includes at least one semiconductor light source, such as a semiconductor laser, such as a VCSEL structure.

In one or more embodiments, the light receiving device includes at least one semiconductor sensor, such as a single-photon avalanche diode (SPAD).

In some embodiments, the optoelectronic module further includes a lens assembly mounted on the region of the light receiving device.

In some embodiments, the optoelectronic module can be electrically connected to the circuit board via a ball grid array (BGA) structure. Specifically, in one embodiment, the optoelectronic module further includes a ball grid array structure located on the back side of the driver chip (on the side opposite to the light emitting device and the light receiving device) to electrically connect to the circuit board.

In some embodiments, an optoelectronic module is provided, including a driver chip, a light emitting device and a passive component. The light emitting device can be directly mounted on the driver chip, or the light emitting device can be mounted on a carrier board which is then mounted on the driver chip. The driver chip provides an electrical signal, voltage or current to drive the light emitting device as a light source and electrically connects to a printed circuit board via a ball grid array structure.

**In** some embodiments, a transmitting module is provided, which integrates a light emitting device, a passive component, a driver chip and a carrier. The light emitting device, the passive component and the driver chip are mounted on the carrier. The light emitting device, the passive component and the driver chip can be mounted on the same side or different sides of the carrier. The carrier provides power distribution through multiple through holes and multiple metal layers located between the components (including the driver chip, the light emitting device and the passive component) and is electrically connected to the printed circuit board through a ball grid array structure. The driver chip provides an electrical signal, voltage or current to drive the light emitting device as a light source.

**In** some embodiments, a bottom filling glue may be included between the driver chip and the carrier board, and the bottom filling glue covers the ball grid array structure.

**In** some embodiments, the optoelectronic module further includes a molding material and metal wires. The driver chip is electrically connected to the carrier through the metal wires, and the molding material covers the driver chip and the metal wires.

**In** some embodiments, a light emitting device is provided, comprising: a semiconductor layer, a transparent substrate, a spacer layer, a first patterned layer and a cover layer. The first patterned layer is formed on the upper surface of the spacer layer, and then the cover layer is formed on the first patterned layer.

**In** some embodiments, a light emitting device is provided, comprising: a semiconductor layer, a transparent substrate, a spacer layer, a first patterned layer, a second patterned layer and a cover layer. The first patterned layer is formed on the spacer layer. The second patterned layer is formed between the transparent substrate and the spacer layer.

In some embodiments, a light emitting device is provided, comprising: a semiconductor layer, a transparent substrate, a spacer layer, a first patterned layer, a second patterned layer, a third patterned layer and a cover layer. The first patterned layer is formed on the spacer layer. The second patterned layer is formed between the transparent substrate and the spacer layer. The third patterned layer is formed between the transparent substrate and the semiconductor layer.

In some embodiments, a light emitting device is provided, comprising: a semiconductor layer, a first transparent substrate, a first patterned layer and a covering layer. The first transparent substrate is located on the semiconductor layer, the first patterned layer is formed on the upper surface of the first transparent substrate, and the covering layer is located on the first patterned layer.

In some embodiments, a light emitting device is provided, comprising a semiconductor layer, a first transparent substrate, a first patterned layer, a second patterned layer and a covering layer. The first transparent substrate is located on the semiconductor layer, the second patterned layer is formed between the first transparent substrate and the semiconductor layer, the first patterned layer is formed on the upper surface of the first transparent substrate, and the covering layer is located on the first patterned layer.

In some embodiments, a light emitting device is provided, comprising a semiconductor layer, a first transparent substrate, a second transparent substrate and a first patterned layer. The first transparent substrate is located on the semiconductor layer, the first patterned layer is formed between the two transparent substrates (the first transparent substrate and the second transparent substrate), and the adhesive layer can be further located on one side of the first patterned layer.

In some embodiments, the first patterned layer may be formed on the first transparent substrate or the second transparent substrate. Another adhesive layer may be further located between the first transparent substrate and the second transparent substrate.

In some embodiments, a light emitting device is provided, comprising a semiconductor layer, a first transparent substrate, an adhesive layer, a second transparent substrate and a patterned layer. The first transparent substrate is located on the semiconductor layer, the second transparent substrate is bonded to the first transparent substrate by the adhesive layer, and the patterned layer is formed on the second transparent substrate.

In some embodiments, a light emitting device is provided, comprising a semiconductor layer, a first transparent substrate, an adhesive layer, a second transparent substrate, a patterned layer, and a third transparent substrate. The first transparent substrate is located on the semiconductor layer, the second transparent substrate is bonded to the first transparent substrate using the adhesive layer, the patterned layer is formed on the second transparent substrate, and the third transparent substrate covers the patterned layer.

### BRIEF DESCRIPTION OF THE DRAWINGS

Fig. 1A is a cross-sectional schematic diagram illustrating a packaging structure of an optoelectronic unit according to an embodiment;
Fig. 1B is a schematic cross-sectional view showing a packaging structure of an optoelectronic unit according to an embodiment;
Fig. 1C is a schematic cross-sectional view illustrating a packaging structure of a light emitting sensor package according to an embodiment;
Fig. 1D is a schematic cross-sectional view showing a packaging structure of a light emitting sensor package according to an embodiment;
Fig. 2A is a schematic cross-sectional view showing a packaging structure of an optoelectronic unit according to an embodiment;
Fig. 2B is a schematic cross-sectional view showing a packaging structure of a light emitting sensor package according to an embodiment;
Fig. 3A is a schematic cross-sectional view showing a packaging structure of an optoelectronic device according to an embodiment;
Fig. 3B is a schematic cross-sectional view showing a packaging structure of an optoelectronic device according to an embodiment;
Fig. 3C is a schematic cross-sectional view showing a packaging structure of an optoelectronic device according to an embodiment;
Fig. 4A to 4D are top views illustrating packaging structures of optoelectronic devices according to some embodiments;
Fig. 5 is a schematic cross-sectional view illustrating a packaging structure of an optoelectronic device according to an embodiment;
Fig. 6 is a schematic diagram illustrating an application of a packaging structure of an optoelectronic device according to an embodiment;
Fig. 7A to Fig. 7K are cross-sectional schematic diagrams illustrating multiple steps of a process for manufacturing a packaging structure of an optoelectronic device according to an embodiment;
Fig. 8A is a top view of a portion of a VCSEL wafer taken by an optical microscope;
Fig. 8B is a top view of a portion of a VCSEL wafer taken with an optical microscope;
Fig. 9A to Fig. 9B are schematic diagrams illustrating a conventional VCSEL die singulation process using an ablation laser or a cutting machine from the front side of a thinned VCSEL wafer;
Fig. 10A to Fig. 10C are schematic diagrams illustrating a process method for singulating a thinned VCSEL wafer to cut out a plurality of dies according to one embodiment;
Fig. 11A to Fig. 11D are schematic perspective views illustrating processing steps of a method for singulating an epitaxial wafer according to some embodiments;
Fig. 12A to Fig. 12B are schematic diagrams illustrating a process method for singulating a thinned VCSEL wafer to cut out a plurality of dies according to an embodiment;
Fig. 13A is a schematic cross-sectional view of a VCSEL chip according to an embodiment;
Fig. 13B and Fig. 13C are cross-sectional images of a VCSEL chip taken by an optical microscope;
Fig. 14A is a top view of a VCSEL chip according to an embodiment;
Fig. 14B is a schematic cross-sectional view showing a cross section along the line 14B-14B' of Fig. 14A;
Fig. 15A to Fig. 15B are different schematic diagrams showing a VCSEL chip according to one or more embodiments;
Fig. 15C to Fig. 15D are top views of a VCSEL chip according to one or more embodiments;
Fig. 16 is a top view of a VCSEL chip according to an embodiment;
Fig. 17A to Fig. 17F are cross-sectional schematic diagrams illustrating multiple steps of a manufacturing process of the VCSEL chip shown in Fig. 15B according to one embodiment;
Fig. 18A to Fig. 18G are cross-sectional views showing multiple steps of a manufacturing process of a VCSEL chip along line 16Z-16Z' of Fig. 16 according to an embodiment;
Fig. 19A is a schematic diagram showing a bottom/back surface of an epitaxial wafer of an optoelectronic device according to an embodiment;
Fig. 19B is a schematic cross-sectional view showing a cross section along the line 19X-19X' of Fig. 19A;
Fig. 19C is a schematic cross-sectional view of a semiconductor laser chip cut from the epitaxial wafer of the optoelectronic device shown in Fig. 19A according to one embodiment;
Fig. 19D is a cross-sectional view showing the semiconductor laser chip of Fig. 19C being welded to a carrier;
Fig. 20 is a cross-sectional schematic diagram showing a VCSEL chip mounted on a carrier and welded to an electrode pad of the carrier;
Fig. 21 is a cross-sectional schematic diagram illustrating an optoelectronic module that can be applied as a Time of Flight (ToF) module according to an embodiment;
Fig. 22 is a cross-sectional schematic diagram illustrating a transmitting module according to an embodiment;
Fig. 23A is a cross-sectional schematic diagram illustrating a transmitting module according to an embodiment;
Fig. 23B is a schematic cross-sectional view of a transmitting module according to an embodiment;
Fig. 24A is a schematic cross-sectional view of a light emitting device according to an embodiment;
Fig. 24B is a schematic cross-sectional view of a light emitting device according to an embodiment;
Fig. 24C is a schematic cross-sectional view of a light emitting device according to an embodiment;
Fig. 25A is a schematic cross-sectional view of a light emitting device according to an embodiment;
Fig. 25B is a schematic cross-sectional view of a light emitting device according to an embodiment;
Fig. 25C is a schematic cross-sectional view of a light emitting device according to an embodiment;
Fig. 25D is a schematic cross-sectional view of a light emitting device according to an embodiment;
Fig. 25E is a schematic cross-sectional view of a light emitting device according to an embodiment;
Fig. 26 is a schematic cross-sectional view of a laser element according to an embodiment;
Fig. 27A is a schematic cross-sectional view of a semiconductor light emitting device according to an embodiment;
Fig. 27B is a bottom view of the laser element shown in Fig. 27A;
Fig. 27C is a top view of the laser element shown in Fig. 27A;
Fig. 28 is a schematic cross-sectional view of a semiconductor light emitting device according to an embodiment;
Fig. 29 is a schematic cross-sectional view of a semiconductor light emitting device according to an embodiment;
Fig. 30A to Fig. 30E are schematic diagrams of a top perspective view, a bottom perspective view, and cross-sectional views of different cross sections of a semiconductor light emitting element according to an embodiment, respectively, for illustrating the configuration of a light emitting region and a common electrode structure of the semiconductor light emitting element;
Fig. 31 is a schematic cross-sectional view of a semiconductor light emitting device according to an embodiment;
Fig. 32A is a schematic top perspective view of a semiconductor light emitting device according to an embodiment, and Fig. 32B and Fig. 32C are schematic cross-sectional views taken along line segments 32B-32B' and 32C-32C' in Fig. 32A, respectively;
Fig. 33 is a schematic cross-sectional view of a semiconductor light emitting device according to an embodiment; and
Fig. 34 is a schematic cross-sectional view of a semiconductor laser device according to an embodiment.

### [Symbol Description]

2, 2', 2-1, 2-2, 2-1', 2-2', 5, 6: Optoelectronic unit
2C, 2D, 2D': Light emitting sensing package
3A, 3B, 3C, 4A, 4B, 4C, 4D: Optoelectronic device
510, 511, 512, 520, 521, 522, 523, 524, 525, 526: pattern
620, 621, 622, 623, 624, 625, 626, 627: pattern structure
1100, 24015, 26001, 27010: Transparent substrate
1101: Integrated optical element
1101A, 1101B: Microlens
1200, 2500, 25050, 26002, 27040, 27902B, 27904B, 29504, 29604, 29704, 29804,
29901, 30504A, 30704A, 30901, 31901, 32901: Adhesive layer
1300, 19900, 20900, 23900: Carrier board
1310: First corresponding pad
1320: Second corresponding pad
1330: Third corresponding pad
1400: Housing
1401A, 1401B: Optical element
1500, 1600, 2000: Stacked structure
2000B, 2200B, 10000B, 27206B: Lower surface
2000T, 2100UT, 2100LT, 5100UT, 10000T, 15020T, 16020, 24020T, 25021T, P271: Upper surface
2000V, 2100V: Through hole structure
2000VI, 2100VI: Insulating structure
2100, 2100', 2100-1, 2100-2, 2100-1', 2100-2', 5100, 6100: Light-emitting epitaxial structure
2100A, 2100A', 5100A, 27204, 28126, 29224, 29324: Active structure
2100L, 2100L', 5100L: Lower distributed Bragg reflector
2100L1, 2100L2, 2210', 5100L1, 5100L2: Distributed Bragg reflector structure
2100U, 2100U', 5100U: Upper distributed Bragg reflector
2100e, 2200e, 2200e1, 2200e2, 2200e3, 2400e, 20900e: Electrode pads
2100P, 2100P1, 2100P2, 2200N, 2200N1, 2200N2, 2200N3, 2400, 2401, 2402, 5100P, 5400, 6400, 7100P, 7200N, 7400: Conductive structure
2125, 5125, 7125, 14104, 15104, 16104, 27205, 28125, 29225, 29325, 328251, 328252, 328253, 328254, 33225: Current confinement layer
2125A, 5125A, 7125A, 14104A, 27205A, 28125A, 29225A, 33225A: Current conduction area
2125B, 5125B, 7125B, 14104B, 27205B, 28125B, 29225B, 33225B: Current restriction area
2200, 2200', 2200-1, 2200-2: Light receiving structure
5500, 7700: Conductive base layer
7100: Light emitting epitaxial layer
7100A, 15020A, 16020A, 20010A, 26033, 33204, 34103: Active layer
7100L, 15020L, 16020L, 20010L, 26035, 34102: Second type semiconductor layer
7100M1, 7100M2, 7200M: Mesa structure
7100R: Ring-shaped electrode structure
7100U, 15020U, 16020U, 20010U, 26031, 34101: First type semiconductor layer
7200: Light receiving layer
7409: Electrode structure
7409E: Extended electrode
7901A, 7902A, 20031, 29082A, 29082B, 29084A, 29084B, 32825A1, 32825A2, 32825A3, 32825A4, 33082A, 33082B: Opening
9000: VCSEL Wafer
9000F: Front side
9100: Epitaxial layer
9200: Thinned wafer layer
9300: Bottom metal layer
9900, 10900, 12900: Ablation laser or cutting machine
10000, 11000A, 11000B, 11000C, 11000D, 12000, 19001: Epitaxial wafer
10010, 12010, 13010, 14010, 19100, 20040, 30010, 31010, 32010, 34040: Base layer
10011: Processing area
10012, 13011: Breaking point
10013, 12013: Cutting street
10020, 12020, 19020, 20010, 33200, 34010: Semiconductor stacking layer
10030, 12030: Metal layer
11011A, 11011B, 11011C, 11011D: First processing area
11011A', 11011B', 11011C', 11011D': Second processing area
11012A, 11012B, 11012C, 11012D: First breaking point
11012A', 11012B', 11012C', 11012D': Second breaking point
13000, 14000, 15000, 16000, 20000: VCSEL chip
13020, 14020, 15020, 16020, 27020, 29020, 29030, 31720, 31730: Epitaxial structure
13020A, 14020A: Active region
13020L, 14020L: Lower reflector
13020U, 14020U: Upper reflector
13040, 27702: First electrode
13050, 27704: Second electrode
14030, 14050, 15030, 15050, 16030, 16050: Electrode
15100, 16100, 33900: Growth substrate
13030, 14040, 15040, 16040, 16060, 7901, 7902, 20030, 26036, 26340, 29090, 29082, 29084, 30090, 31090, 31782, 32090, 33082, 33090, 34030: Insulating layer
19000: Semiconductor laser chip
19000B: Bottom surface
19000S: Stepped structure
19001B: Back side
19030: Upper electrode
19040: Lower electrode
20011, 28110A: First surface
20012, 28110B: Second surface
20013, 34013, 34042, E13, E14: Side surface
20020, 28132: First electrode structure
20041: Bottom
20041A: Bottom first surface
20041B: Bottom second surface
20041C: Bottom side surface
20042, 20012A, 20012B, 34102A, 34102B: Plateau portion
20042A: Plateau surface
20042B: Plateau side surface
20050, 28134: Second electrode structure
21000: Optoelectronic module
21010, 22010, 23010: Driver chip
21011: Lens group
21020, 22020, 23020, 24000A, 24000B, 24000C, 25000A, 25000B, 25000C, 25000D, 25000E: Light emitting device
21030: SPAD
21040, 22040: BGA structure
22000, 23000: Transmitter module
22030, 23030: Passive component
23050: Metal wire
23060: Molding material
24010, 25010, 33202, 33206: Semiconductor layer
24020: Spacer layer
24031, 25031: First patterned layer
24032, 25032: Second patterned layer
24033: Third patterned layer
24040, 25040: Cover layer
25021: First transparent substrate
25022: Second transparent substrate
25023: Third transparent base
25030: Patterned layer
26000, 27000: Laser element
26003: Laser unit
26003S: Light-emitting side
26010, 29421, 29422, 30421: Conductive layer
26030: Front conductive structure
26032: Back conductive structure
26032A, 26032B: Detection electrode
26032C, 26032D: Conductive electrode
26034: First channel
26320: Second channel
27032: First insulating layer
27034: First metal connection layer
27050: Second metal connection layer
27060: Second insulating layer
27060A: Side portion
27080: Third insulation layer
27101: Anti-reflection structure
27202, 28121, 30222: First semiconductor structure
27206, 28122: Second semiconductor structure
27206A: End face
27322: First opening
27341a: first protrusion
27341b: Second protrusion
27342: Second opening
27344A, 27344B, 27344C, 27344D: Marking structure
27602a: first opening
27602b: Second opening
27602c: Third opening
27602d: Fourth opening
27603: Fifth opening
27802: First hole
27804: Second hole
27902: First pad structure
27904: Second pad structure
27902A, 27904A, 28123, 29502, 29602, 29702, 29802, 30502A, 30702A: Intermediate layer
28000, 29000, 30000, 31000, 32000, 33000, 34000: semiconductor light emitting element
28110, 29010: Base
28120: Epitaxial stack
28124: Third semiconductor structure
28127: Fourth semiconductor structure
28132A: First portion
28132B: Second portion
28140, 32840, 32850A, 32850B, 32850C, 32850D, 33104: Recess structure
28150, PL: Protective layer
28160: Optical Element
33100: Substrate
29020A, 29030A, 34011: Surface
29040, 30040, 31040, 32040, 33040: Metal connection layer
29040A, 33040A: Connection layer opening
29040B, 30040B: Spacer
29050, 29060, 29070, 29080, 30050A, 30050B, 30060A, 30060B, 30070A, 30070B, 30080A, 30080B, 31750, 31760, 31770, 31780, 33105, 33106, 34020, 34050: Electrode structure
29090A, 29090B, 33090A, 34032: Insulating layer opening
29201, 29301, U33: Through hole
29220, 29320, 33220: Contact structure
29222, 29322: Semiconductor structure
29226, 29326, 30226, 31726, 31736, 32826: Platform structure
29420, 29520, 30420, 31242, 31342, 33420: Electrode connection layer
29821, 31010A, 31010B: Side
29822: Upper portion
30000A, 30000B, 30000C, 30000D: Light emitting area
30040a, 30040b: Portion
31720B, 34041: Surface
32825A: Light emitting hole
A: Plane size
C: Arrow
C271: First boundary
C272: Second boundary
D10, D12: Cutting depth
D019: Depth
D271: First Distance
D272: Second distance
G010, G012: Crack
G019: Groove
G27: Spacing
G271: First spacing
G272: Second spacing
G273: Third spacing
G274: Fourth spacing
L1, L2: Line
L019: Width
L26: Laser beam
LD: Length direction
Lf: Focused light
Lg: Interference light
Lo, Lo1, Lo2, Lo': coherent light
Lr, Lr1, Lr2: reflected light
O14: Light outlet
P27: Columnar structure
P272, PB33: side surface
P291, P292, P293, P294, P30, P3011, P3012, P3013, P3014, P3015, P3016, P3021, P3022, P3023, P3024, P3031, P3032, P311, P312, P33: epitaxial columnar structure S271: First side
S272: Second side
W10, W12: Cutting width
W291, W292, W311, W312: Width
WD: width direction
θ , θ': angle

### DETAILED DESCRIPTION OF THE EMBODIMENTS

The concepts of the present disclosure are depicted by drawings and described by embodiments. In the drawings and description, similar or same parts are denoted by same reference signs. For the sake of illustration, the thickness and shapes of layers are neither the actual dimensions of the components nor proportional thereto in size. Components not shown in the drawings or described herein are well known to persons skilled in the art.

The following description of various embodiments of the present invention is made in conjunction with the accompanying drawings for the purpose of facilitating clear understanding, and should be regarded as exemplary descriptions. The phrases such as "in one embodiment" in this specification are not limited to specific or identical embodiments, and those skilled in the art should recognize that various changes, combinations or adjustments can be made to the various embodiments of the present invention without departing from the scope and spirit of the present invention.

The terms "first", "second", "third", etc. used in this specification are intended to indicate and describe the features of each corresponding embodiment, and do not necessarily have any meaning in order, hierarchy, or precedence (for example, in spatial position, time sequence, step sequence, etc.).

The terms "upper", "lower", "left", "right", "front", "back", "lower", "higher", "top" or "bottom" used in this specification are used to describe the relative relationship in spatial distribution of one element to another element (or one structure to another structure) in each figure. It is understood that if the structure shown in the figure is turned upside down, the elements described as being on the "lower", "below" or "lower" side will become elements on the "upper", "above" or "higher" side.

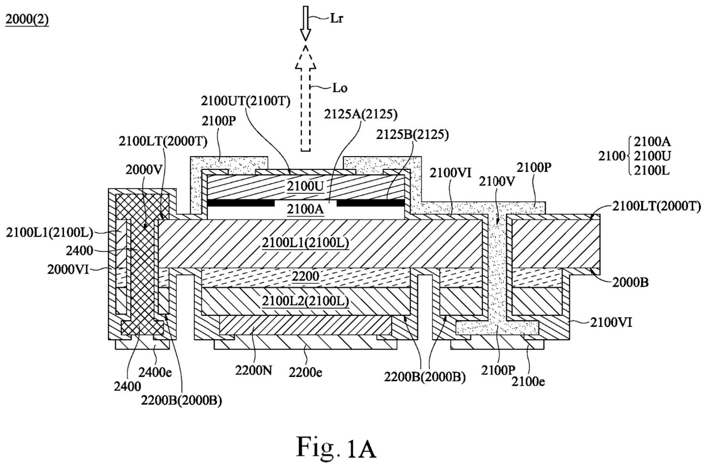

Fig. 1A is a schematic cross-sectional view showing a packaging structure of a optoelectronic unit 2 according to an embodiment, wherein the optoelectronic unit 2 can be used as a self-mixing interferometry (SMI) sensing unit.

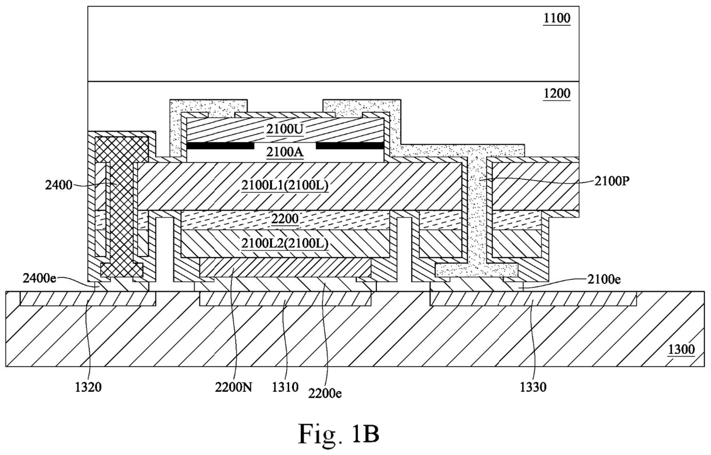

Fig. 1B is a cross-sectional view of a packaging structure of an optoelectronic unit 2 according to an embodiment, wherein the optoelectronic unit 2 shown in Fig. 1A is adhered to a transparent substrate 1100.

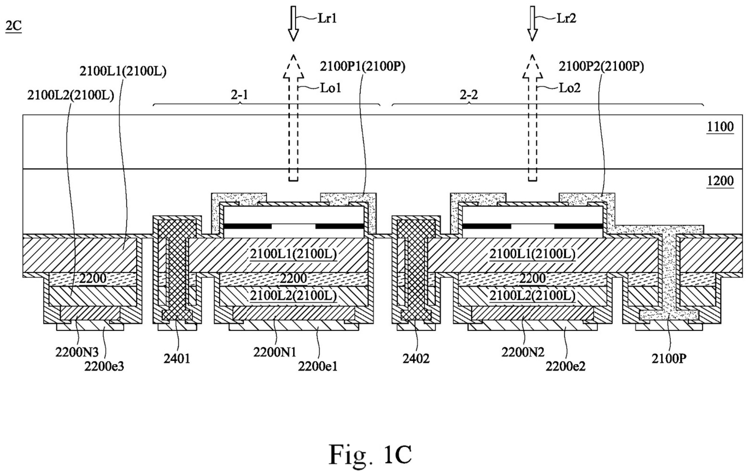

Fig. 1C is a schematic cross-sectional view of a packaging structure of a light emitting sensing package 2C according to an embodiment, which includes a plurality of optoelectronic units 2 as shown in Fig. 1A adhered to a transparent substrate 1100; and the light emitting sensing package 2C can be used as a self-mixing interference sensing device.

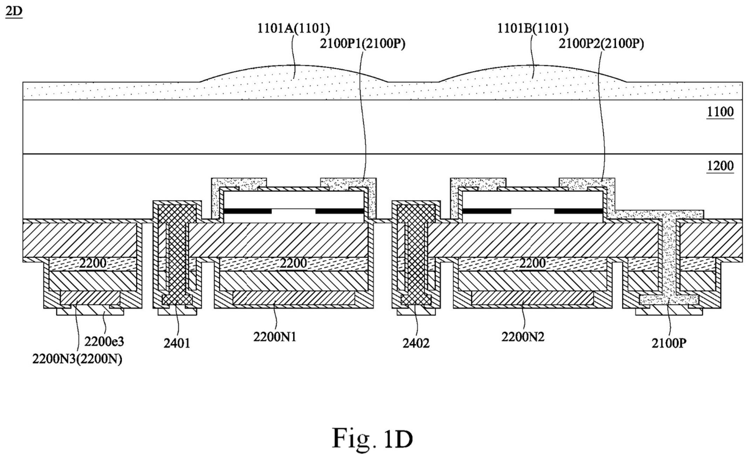

Fig. 1D is a schematic cross-sectional view of a packaging structure of a light emitting sensor package 2D according to an embodiment. Fig. 1D includes a plurality of optoelectronic units 2 as shown in Fig. 1A adhered to a transparent substrate 1100; and the light emitting sensing package 2D can be used as a self-mixing interference sensing device.

According to the embodiment shown in Fig. 1A, the optoelectronic unit 2 includes a light emitting structure and a light receiving structure, and the optoelectronic unit 2 is a stacked structure 2000 including a semiconductor epitaxial structure, a conductive structure, and an insulating structure. The stacked structure 2000 has an upper surface 2000T and a lower surface 2000B relative to the upper surface 2000T. In the embodiment shown in Fig. 1A, the stacked structure 2000 of the optoelectronic unit 2 can be formed by epitaxial growth.

In the embodiment shown in Fig. 1A, the stacked structure 2000 includes a light-emitting epitaxial structure 2100, which corresponds to the light emitting structure of the optoelectronic unit 2. In this embodiment, the light-emitting epitaxial structure 2100 may be a vertical cavity surface emitting laser (VCSEL), which may be a stacked epitaxial structure including an upper distributed Bragg reflector (hereinafter referred to as DBR) 2100U, a lower DBR 2100L, and an active structure 2100A located between the upper DBR 2100U and the lower DBR 2100L.

In the embodiment shown in Fig. 1A, the conductive structure 2100P contacts the upper DBR 2100U at the upper surface 2100UT of the upper DBR 2100U, and then the conductive structure 2100P continues to extend and covers a portion of the lower surface 2000B through the through-hole structure 2100V formed inside the stacked structure 2000. In this embodiment, the insulating structure 2100VI is formed between the conductive structure 2100P and the stacked structure 2000, and the insulating structure 2100VI is used to electrically insulate the conductive structure 2100P from the upper DBR 2100U, and the active structure 2100A from the lower DBR 2100L.

In the embodiment shown in Fig. 1A, the upper DBR 2100U includes a P-type semiconductor structure, and the lower DBR 2100L includes an N-type semiconductor layer structure. In this embodiment, the conductive structure 2100P serves as a P electrode of the light-emitting epitaxial structure 2100.

In the embodiment shown in Fig. 1A, the light receiving structure 2200 is integrally formed as a part of the lower DBR 2100L of the light emitting epitaxial structure 2100 (e.g., VCSEL). In other words, in this embodiment, the lower DBR 2100L includes the DBR structure 2100L1, the light receiving structure 2200, and the DBR structure 2100L2 stacked in sequence.

In the embodiment shown in Fig. 1A, the conductive structure 2200N contacts the light receiving structure 2200 at the lower surface 2200B of the light receiving structure 2200. In one embodiment, the light receiving structure 2200 may be a photodiode, such as an avalanche photodiode (APD) or a PIN photodiode. In the embodiment shown in Fig. 1A, the conductive structure 2200N serves as an N electrode of the light receiving structure 2200.

In the embodiment shown in Fig. 1A, the conductive structure 2400 contacts the DBR structure 2100L1 at the upper surface 2100LT of the lower DBR 2100L, and then the conductive structure 2400 continues to extend and covers a portion of the lower surface 2000B through hole structure 2000V inside the stacked structure 2000. In the embodiment shown in Fig. 1A, the insulating structure 2000VI is located inside the through hole structure 2000V and extends to cover a portion of the lower surface 2000B, and the insulating structure is used to electrically insulate the conductive structure 2400 from the lower DBR 2100L. In the embodiment shown in Fig. 1A, the conductive structure 2400 contacts the DBR structure 2100L1 of the N-type semiconductor, and the lower DBR 2100L of the N-type semiconductor is connected to the upper portion of the light receiving structure 2200. Therefore, the conductive structure 2400 is a common electrode of the light emitting epitaxial structure 2100 and the light receiving structure 2200. In this embodiment, the conductive structure 2400 is simultaneously an N electrode of the light emitting epitaxial structure 2100 and a P electrode of the light receiving structure 2200.

In one embodiment, referring to Fig. 1A, the light-emitting epitaxial structure 2100 may further include a current confinement layer 2125 located between the upper DBR 2100U and the active structure 2100A, and the current confinement layer 2125 includes a current restriction region 2125B and a current conduction region 2125A, and the current conduction region 2125A is surrounded and defined by the current restriction region 2125B. The active structure 2100A may be a single-layer or multi-layer structure, for example, the active structure 2100A includes at least one quantum well layer. In addition, the active structure 2100A may include at least one current confinement layer and/or at least one tunnel junction structure.

In one embodiment, referring to Fig. 1A and Fig. 1B, the transparent substrate 1100 may be adhered to the upper surface 2000T by the adhesive layer 1200, wherein the transparent substrate 1100 and the adhesive layer 1200 are light-transmissive to the light emitted from the active structure 2100A of the light-emitting epitaxial structure 2100. In this embodiment, the electrode pads 2400e, 2200e, and 2100e are respectively formed on the lower surface 2000B, the electrode pad 2400e contacts the conductive structure 2400 for bonding to the second corresponding pad 1320 (as shown in Fig. 1B ) of the carrier 1300, the electrode pad 2200e contacts the conductive structure 2200N for bonding to the first corresponding pad 1310 of the carrier 1300, and the electrode pad 2100e contacts the conductive structure 2100P for bonding to the third corresponding pad 1330 of the carrier 1300. In the embodiment shown in Fig. 1A, the optoelectronic unit 2 is driven to emit coherent light Lo to the first object, and then the reflected light Lr from the first object can be detected by the light receiving structure 2200 of the optoelectronic unit 2 .

In one or more embodiments, referring to Fig. 1B as an example, the optoelectronic unit 2 may be coupled to the controller via the carrier 1300. Then, the light emitting structure of the optoelectronic unit 2 and the light receiving structure of the optoelectronic unit 2 may be enabled to operate separately by the controller via the conductive structure 2100P or the conductive structure 2200N corresponding to the respective structures (light emitting structure or light receiving structure). Alternatively, the light emitting structure of the optoelectronic unit 2 and the light receiving structure of the optoelectronic unit 2 may also be enabled to operate together by the controller via the common electrode (conductive structure 2400) of the emitting device and the light receiving structure.

Fig. 1C illustrates a packaging structure of a light-emitting sensing package 2C according to an embodiment, which includes a plurality of optoelectronic units 2 (optoelectronic unit 2-1 and optoelectronic unit 2-2) as shown in Fig. 1A adhered to a transparent substrate 1100; and the light-emitting sensing package 2C can be used as a self-mixing interference sensing device. In one or more embodiments, the plurality of optoelectronic units 2 of the light-emitting sensing package 2C can be arranged in an array.

In the embodiment shown in Fig. 1C, each stacked structure of the optoelectronic unit 2-1 and the optoelectronic unit 2-2 has a structure that is the same as or similar to the optoelectronic unit 2. In the embodiment shown in Fig. 1C, the conductive structure 2100P1 of the optoelectronic unit 2-1 can be connected to the conductive structure 2100P2 of the optoelectronic unit 2-2 through an interconnection structure (not shown in Fig. 1C). In other words, in this embodiment, the conductive structures 2100P1 and 2100P2 can be connected to form a common electrode (conductive structure 2100P) as a common electrode of the optoelectronic units 2-1 and 2-2. For example, in the embodiment shown in Fig. 1C, the common electrode (conductive structure 2100P) is a common P electrode of the optoelectronic unit of the light-emitting sensing package 2C.

In the embodiment shown in Fig. 1C, the electrode pad 2200e1 of the conductive structure 2200N1 can be connected to the electrode pad 2200e2 of the conductive structure 2200N2 via the common pad (first corresponding pad 1310) of the carrier 1300 (not shown in Fig. 1C ); in other words, in this embodiment, the common pad (first corresponding pad 1310) of the carrier 1300 can be used as a common N electrode electrically connected to the light receiving structure of the light emitting sensor package 2C. In the embodiment shown in Fig. 1C, in addition, the electrode pad 2200e3 of the conductive structure 2200N3 can be connected to the electrode pads 2200e1 and 2200e2 via the common pad (first corresponding pad 1310) of the carrier 1300.

In the embodiment shown in Fig. 1C, the conductive structure 2401 of the optoelectronic unit 2-1 is separated from the conductive structure 2402 of the optoelectronic unit 2-2; in other words, in this embodiment, the conductive structure 2401 and the conductive structure 2402 are substantially electrically separated from each other. Therefore, each of the optoelectronic units 2-1 and 2-2 can be driven/controlled separately. In the embodiment shown in Fig. 1C, the optoelectronic unit 2-1 is driven to emit coherent light Lo1 to a first object, and then the reflected light Lr1 from the first object can be detected by the light receiving structure of the optoelectronic unit 2-1; the optoelectronic unit 2-2 is driven to emit coherent light Lo2 to a second object, and then the reflected light Lr2 from the second object can be detected by the light receiving structure of the optoelectronic unit 2-2.

Specifically, in some embodiments, since the laser light is reflected from the object, it contains implicit information about the state of the object (such as the distance relative to the optoelectronic unit, rotation speed, movement speed, acceleration, etc.). Therefore, the aforementioned information can be obtained by comparing the phase changes between the light of different lasers and performing conversion calculations.

Fig. 1D shows a packaging structure of a light emitting sensor package 2D according to an embodiment, which includes a plurality of optoelectronic units 2 (e.g., optoelectronic units 2-1 and 2-2) as shown in Fig. 1A that are attached to a transparent substrate 1100; and the light-emitting sensing package 2D can be used as a self-mixing interference sensing device. Each stacking structure of the optoelectronic units 2 in the embodiment shown in Fig. 1D has a structure that is the same as or similar to the stacking structure of the optoelectronic unit 2 in the embodiment shown in Fig. 1A.

Please refer to FIGS. 1D and 1C. The structure of the light-emitting sensing package 2D is similar to that of the light-emitting sensing package 2C. The conductive structures 2100P1 and 2100P2 can be connected to form a common electrode (conductive structure 2100P) and serve as a common electrode (e.g., a common P electrode) of the optoelectronic unit; and the conductive structure 2401 and the conductive structure 2402 are substantially electrically separated from each other. Therefore, each of the optoelectronic units shown in Fig. 1D can be driven/controlled separately.

Specifically, in the embodiment shown in Fig. 1D, the conductive structure 2200N1 and the conductive structure 2200N2 are respectively covered by the insulating structure, and the conductive structure 2200N1 and the conductive structure 2200N2 are connected to the conductive structure 2200N3 through the interconnection structure (not shown in Fig. 1D). Therefore, the conductive structure 2200N3 can be used as a common conductive structure, which is connected to the electrode pad 2200e3 that is electrically connected to each of the light receiving structures 2200 as a common electrode. In other words, in the embodiment shown in Fig. 1D, the electrode pad 2200e3 can be used as a common N electrode that electrically connects the light receiving structure 2200 of the light emitting sensing package 2D.

Referring to Fig. 1D as an example, in one or more embodiments, the transparent substrate 1100 may have an integrated optical element 1101. In one or more embodiments, the integrated optical element 1101 may include a plurality of optical elements (e.g., microlenses 1101A and 1101B), and the microlens 1101A corresponds to the optoelectronic unit 2-1 under the microlens 1101A, and the microlens 1101B corresponds to the optoelectronic unit 2-2 under the microlens 1101B. In one or more embodiments, the center position (or optical axis) of the microlens 1101A is misaligned with the center position of the current conduction region in the optoelectronic unit 2-1 thereunder, or/and the center position (or optical axis) of the microlens 1101B is misaligned with the center position of the current conduction region in the optoelectronic unit 2-2 thereunder, but the present application is not limited thereto.

In some embodiments, by staggering the optical element and the current conduction region of each semiconductor laser (i.e., the light outlet corresponding to the semiconductor laser), the light emitted by the semiconductor laser can be offset, thereby changing the field of illumination (FOI) of the optoelectronic device.

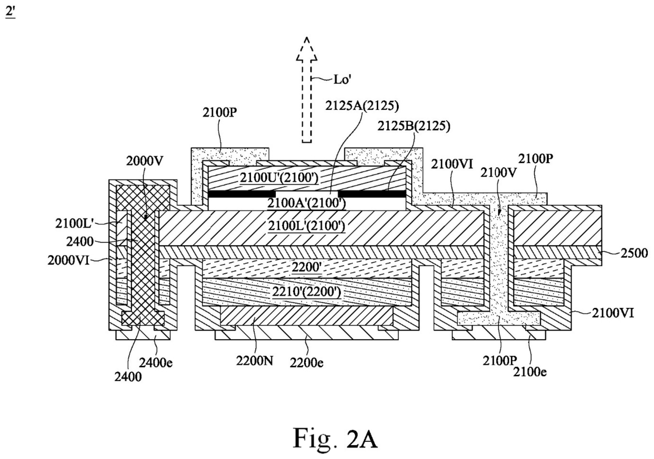

Fig. 2A is a cross-sectional view of a packaging structure of a optoelectronic unit 2' according to an embodiment. The optoelectronic unit 2' can be used as a self-mixing interference (SMI) sensing unit.

Referring to FIGS. 2A and 1A, the optoelectronic unit 2' has a structure similar to the optoelectronic unit 2. In the embodiment shown in Fig. 2A, the optoelectronic unit 2' includes a light-emitting epitaxial structure 2100' and a light-receiving structure 2200'. The light receiving structure 2200' is located below the light emitting epitaxial structure 2100'.

Specifically, unlike the embodiment shown in Fig. 1A (in Fig. 1A, the light receiving structure 2200 is integrally formed as a part of the lower DBR 2100L of the light-emitting epitaxial structure 2100), in the embodiment shown in Fig. 2A, the optoelectronic unit 2' further includes an adhesive layer 2500 located between the light-emitting epitaxial structure 2100' and the light receiving structure 2200', and the upper surface of the light receiving structure 2200' is mostly adhered to the lower surface of the light-emitting epitaxial structure 2100' through the adhesive layer 2500, wherein the adhesive layer 2500 is transparent to the coherent light Lo' emitted by the active structure 2100A' of the light-emitting epitaxial structure 2100'.

In the embodiment shown in Fig. 2A, the light-emitting epitaxial structure 2100' may be a VCSEL, which may be a stacked epitaxial structure including an upper DBR 2100U', a lower DBR 2100L', and an active structure 2100A' located between the upper DBR 2100U' and the lower DBR 2100L'. In the embodiment shown in Fig. 2A, the upper DBR 2100U' includes a P-type semiconductor structure, and the lower DBR 2100L' includes an N-type semiconductor layer structure, and then the conductive structure 2100P (as shown in Fig. 2A) serves as a P-electrode of the light-emitting epitaxial structure 2100'.

In the embodiment shown in Fig. 2A, the next layer 2500 is conductive, so that the conductive structure (as shown in Fig. 2A ) can be electrically connected to the lower DBR 2100L' of the light-emitting epitaxial structure 2100' and the light receiving structure 2200'. Therefore, the conductive structure 2400 is a common electrode of the light-emitting epitaxial structure 2100' and the light receiving structure 2200'. In the embodiment shown in Fig. 2A, the conductive structure 2400 is simultaneously an N electrode of the light-emitting epitaxial structure 2100' and a P electrode of the light receiving structure 2200'.

In the embodiment shown in Fig. 2A, the light receiving structure 2200' further includes a DBR structure 2210' and a conductive structure 2200N (as shown in Fig. 2A) contacting the light receiving structure 2200' on the lower surface of the light receiving structure 2200'. In one embodiment, the light receiving structure 2200' may be a photodiode, such as an avalanche photodiode or a PIN photodiode. In the embodiment shown in Fig. 2A, the conductive structure 2200N serves as an N electrode of the light receiving structure 2200'. In the embodiment shown in Fig. 2A, the light receiving structure 2200' may be formed by a wafer fusion process.

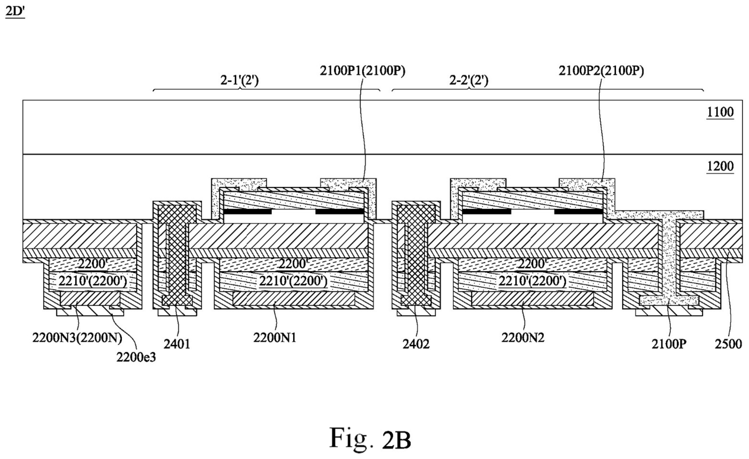

Fig. 2B is a cross-sectional view of a packaging structure of a light-emitting sensing package 2D' according to an embodiment, which includes a plurality of optoelectronic units 2' (optoelectronic unit 2-1' and optoelectronic unit 2-2') as shown in Fig. 2A adhered to a transparent substrate 1100; and the light-emitting sensing package 2D' can be used as a self-mixing interference sensing device. In one or more embodiments, the plurality of optoelectronic units 2' of the light-emitting sensing package 2D' can be arranged in an array.

In the embodiment shown in Fig. 2B, the conductive structure 2100P1 of the optoelectronic unit 2-1' can be connected to the conductive structure 2100P2 of the optoelectronic unit 2-2' through an interconnection structure (not shown in Fig. 2B). In other words, the conductive structures 2100P1 and 2100P2 can be connected to form a common electrode (conductive structure 2100P) (as shown in Fig. 2B) and serve as a common electrode of the optoelectronic units 2-1' and 2-2'. For example, in the embodiment shown in Fig. 2B, the common electrode is a common P electrode of the optoelectronic unit of the light-emitting sensing package 2D'.

In the embodiment shown in Fig. 2B, the conductive structure 2401 of the optoelectronic unit 2-1' is separated from the conductive structure 2402 of the optoelectronic unit 2-2'; in other words, in this embodiment, the conductive structure 2401 and the conductive structure 2402 are substantially electrically separated from each other. Therefore, each of the optoelectronic units 2-1' and 2-2' can be driven/controlled separately.

In the embodiment shown in Fig. 2B, the conductive structure 2200N1 and the conductive structure 2200N2 can be connected to the conductive structure 2200N3 through an internal interconnection structure (not shown in Fig. 2B). Therefore, the conductive structure 2200N3 can serve as a common conductive structure, which is connected to the electrode pad 2200e3 that is electrically connected to each of the light receiving structures 2200' as a common electrode. In other words, in the embodiment shown in Fig. 2B, the electrode pad 2200e3 can serve as a common N electrode that electrically connects the light receiving structures 2200' of the light emitting sensing package 2D'.

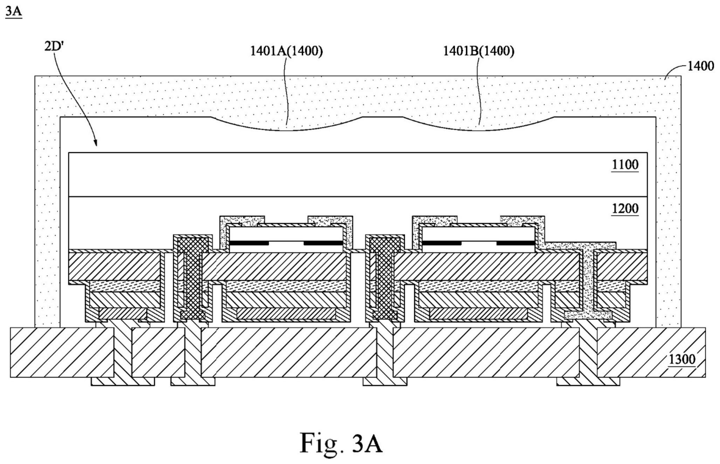

Fig. 3A is a schematic cross-sectional view of a packaging structure of an optoelectronic device 3A according to an embodiment. Referring to Fig. 3A as an example, in one or more embodiments, the optoelectronic device 3A further includes a housing 1400 covering a light-emitting sensing package 2D'. It should be noted that the light-emitting sensing package 2D' can be replaced by any of the aforementioned light-emitting sensing packages, but the present application is not limited thereto.

In one or more embodiments, taking the embodiment shown in Fig. 3A as an example, the housing 1400 may have a plurality of optical elements 1401A, 1401B. In one or more embodiments, taking the embodiment shown in Fig. 3A as an example, the optical elements 1401A, 1401B may have the same or different optical functions. In one embodiment, the optical elements 1401A, 1401B may be used to project light. In another embodiment, the optical elements 1401A, 1401B may be used to focus light. In other embodiments, the optical element 1401A may be used to project light, while the optical element 1401B may be used to focus light. In one embodiment, the optical elements 1401A, 1401B may be used to project light or focus light in different directions, or the optical elements 1401A, 1401B may be used to project light at different angles, thereby expanding the field of view of the optoelectronic device 3A.

In some embodiments, since there may be a containing space between the housing 1400 and the transparent substrate 1100, it may be filled with normal air, or may be filled with inert gas, nitrogen, or maintained in a vacuum, to provide a medium environment with different refractive indices. In other embodiments, an optical element with a concave lens structure may also be formed on the transparent substrate 1100 and then covered with the housing 1400, which may also provide focusing and/or collimation function of the optical element.

In some embodiments, taking the embodiment shown in Fig. 1D or Fig. 3A to Fig. 3C as an example, the aforementioned optical element may include, for example, a diffraction optical element (DOE) structure, a micro lens arraystructure, a metasurface structure or a metalens structure or a combination of the aforementioned various optical element structures. Among them, the metasurface structure is a nanostructure with multiple periodic arrangements.

In one or more embodiments, taking the embodiment shown in Fig. 3A as an example, the carrier 1300 may be a ceramic substrate, a printed circuit board, etc.

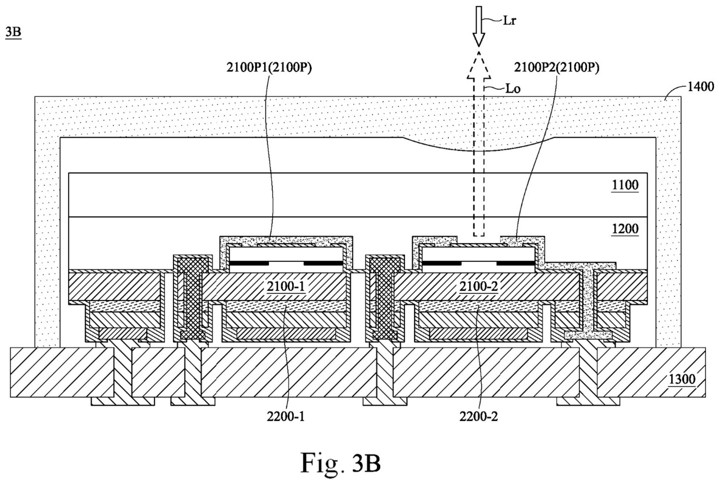

Fig. 3B is a schematic cross-sectional view of a package structure of an optoelectronic device 3B according to an embodiment. The optoelectronic device 3B can be used as a self-mixing interference sensing device with a baseline signal or a reference signal.

In the embodiment shown in Fig. 3B, the conductive structure 2100P1 completely covers the upper surface of the light-emitting epitaxial structure 2100-1 on the left, while the conductive structure 2100P2 does not completely cover the upper surface of the light-emitting epitaxial structure 2100-2 on the right, and the light-emitting epitaxial structure 2100-2 on the right can emit light normally. Therefore, the light emitted from the active structure of the light-emitting epitaxial structure 2100-1 on the left is blocked and reflected downward by the conductive structure 2100P1. Therefore, the signal output by the left light receiving structure 2200-1 can be used as a baseline signal/reference signal of the signal output by the right light receiving structure 2200-2 for self-mixing interference sensing.

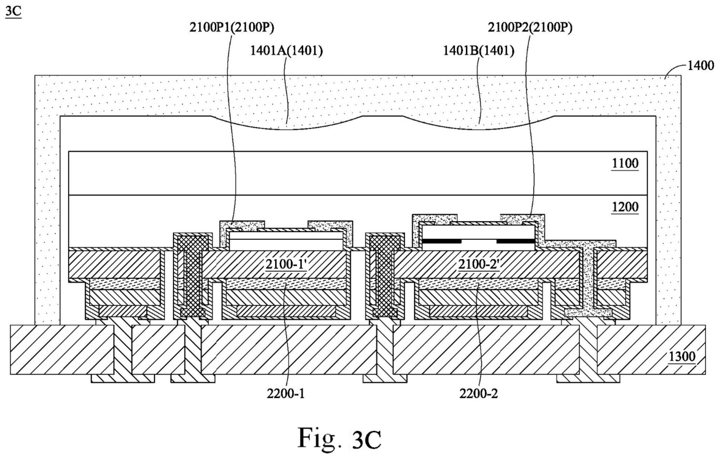

Fig. 3C is a schematic cross-sectional view of a packaging structure of an optoelectronic device 3C according to an embodiment, and the optoelectronic device 3C can be used as a self-mixing interference sensing device. According to the embodiment shown in Fig. 3C, the optoelectronic device 3C includes a plurality of optoelectronic units arranged in an array, wherein the light emitting structure of one or more optoelectronic units can be different from the light emitting structure of other optoelectronic units.

In one or more embodiments, a plurality of optoelectronic units are arranged in an array so that the optoelectronic device can provide a two-dimensionally distributed laser beam. When the two-dimensionally distributed laser beam is irradiated onto an object, the laser light emitted by each optoelectronic unit is reflected by the object, and the reflected beam carries the distance information between the object and the optoelectronic device and the motion state information of the object as described above. And because the optoelectronic device irradiates the object with a two-dimensionally distributed laser beam, each laser beam can irradiate different positions of the object, so that the distance information and motion state information obtained after calculation are more accurate or the three-dimensional contour information of the object can be obtained.

Refering to FIGS. 3C and 3B, the right epitaxial light emitting structure 2100-2' shown in Fig. 3C has the same or similar structure as the right epitaxial light emitting structure 2100-2 shown in Fig. 3B . In the embodiment shown in Fig. 3C, the right epitaxial light emitting structure 2100 - 2' includes a VCSEL structure.

Specifically, in the embodiment shown in Figure 3C, the light-emitting epitaxial structure 2100-1' on the left may be different from the light-emitting epitaxial structure 2100-2' on the right; in other words, in this embodiment, the light-emitting epitaxial structure 2100' on the left may include an LED structure or a resonant cavity light emitting diode (Resonant Cavity Light Emitting Diode, RCLED) structure.

In one or more embodiments, the electrode structure of the light emitting structure and/or the electrode structure of the light receiving structure of the aforementioned optoelectronic device (e.g., the self-mixing interference sensing device) can be constructed together as one or more common electrodes for being driven/controlled together (e.g., a common driven/controlled mode). When the optoelectronic device (e.g., the self-mixing interference sensing device) is enabled in the common driven/controlled mode, the activation signal for enabling different units of the optoelectronic device can be ignored.

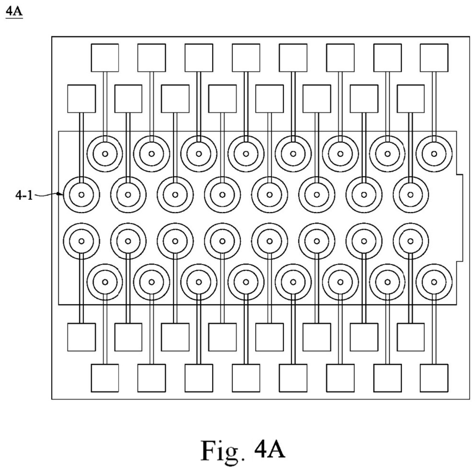

Please refer to Fig. 4A to Fig. 4D, which are top views illustrating packaging structures of optoelectronic devices according to some embodiments.

As shown in Fig. 4A, in some embodiments, the optoelectronic device 4A includes 32 SMI sensing units 4-1 forming an array, wherein the light emitting structure in each SMI sensing unit 4-1 is, for example, a VCSEL semiconductor laser, and the spacing between the SMI sensing units 4-1 is 133 microns, wherein the light emitting wavelength of the VCSEL semiconductor laser is, for example, 940 nanometers. The light outlet aperture of the VCSEL semiconductor laser is 8 to 10 microns.

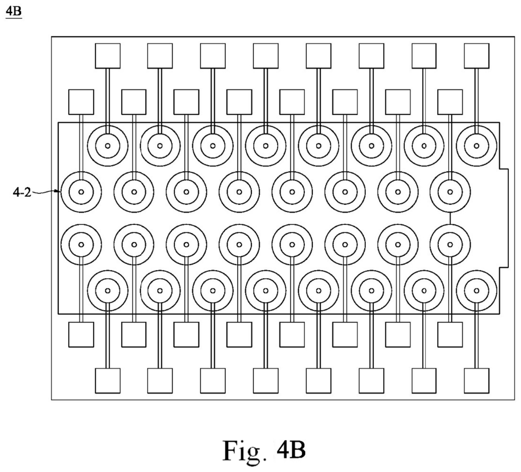

As shown in Fig. 4B, in some embodiments, the optoelectronic device 4B includes 32 SMI sensing units 4-2 forming an array, and the spacing between the SMI sensing units 4-2 is 166 micrometers.

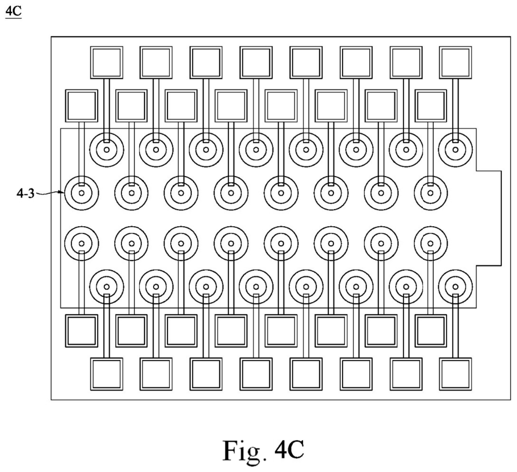

As shown in Fig. 4C, in some embodiments, the optoelectronic device 4C includes 32 SMI sensing units 4-3 forming an array, and the spacing between the SMI sensing units 4-3 is 186 micrometers.

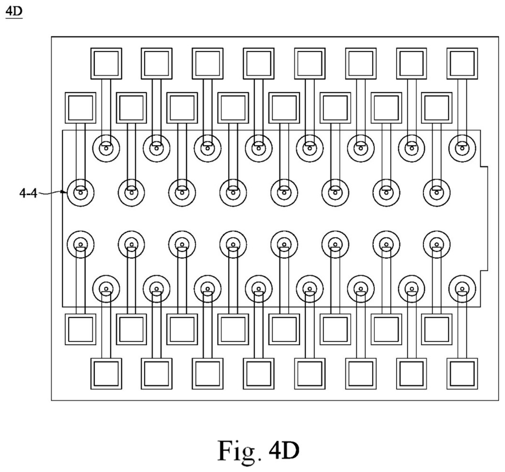

As shown in Fig. 4D, in some embodiments, the optoelectronic device 4D includes 32 SMI sensing units 4-4 forming an array, and the spacing between the SMI sensing units 4-4 is 300 micrometers.

As shown in FIGS. 4A to 4D, in some embodiments, the optoelectronic devices 4A, 4B, 4C, and 4D include multiple SMI sensing units 4-1, 4-2, 4-3, and 4-4 to form an array, and the SMI sensing units 4-1, 4-2, 4-3, and 4-4 have a light-emitting structure (for example, a VCSEL semiconductor laser), wherein each upper electrode (for example, VCSEL-) of each VCSEL semiconductor laser of each SMI sensing unit 4-1, 4-2, 4-3, and 4-4 is extended to each external electrode (represented by a square) through a conductive wiring, and each lower electrode (for example, VCSEL+) of each VCSEL semiconductor laser is connected in common, thereby, each SMI sensing unit of the optoelectronic devices 4A, 4B, 4C, and 4D can be controlled addressably or by zone through each external electrode.

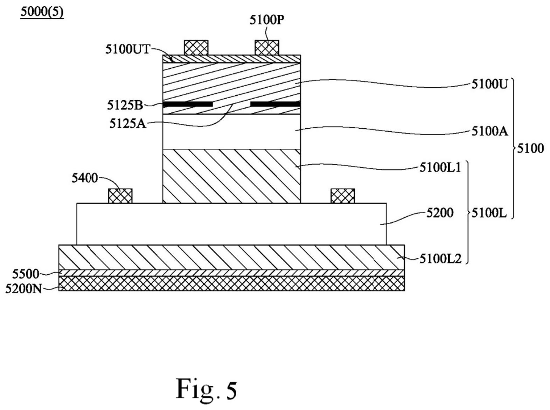

Fig. 5 is a schematic cross-sectional view of a packaging structure of an optoelectronic device according to an embodiment. Referring to Fig. 5, in this embodiment, the optoelectronic unit 5 is a SMI sensing chip with a vertical chip structure.

The optoelectronic unit 5 includes a light emitting structure, a light receiving structure 5200 and a conductive base layer 5500, and the optoelectronic unit 5 is a stacked structure 5000 including a semiconductor epitaxial structure and a conductive structure.

In this embodiment, the light-emitting epitaxial structure 5100 (corresponding to the light-emitting structure of the optoelectronic unit 5) is disposed on the conductive base layer 5500. The stacked structure includes the light-emitting epitaxial structure 5100, which corresponds to the light-emitting structure of the optoelectronic unit 5. In this embodiment, the light-emitting epitaxial structure 5100 may be a vertical cavity surface emitting laser, which may be a stacked epitaxial structure including an upper DBR 5100U, a lower DBR 5100L, and an active structure 5100A located between the upper DBR 5100U and the lower DBR 5100L.

In the embodiment shown in Fig. 5, the conductive structure 5100P contacts the upper DBR 5100U on the upper surface 5100UT of the upper DBR 5100U.

In the embodiment shown in Fig. 5, the light receiving structure 5200 is integrally formed as a part of the lower DBR 5100L of the light emitting epitaxial structure 5100 (e.g., VCSEL). In other words, in this embodiment, the lower DBR 5100L includes a DBR structure 5100L1, a light receiving structure 5200, and a DBR structure 5100L2 stacked in sequence.

In the embodiment shown in Fig. 5, the upper DBR 5100U includes a P-type semiconductor structure, and the lower DBR 5100L includes an N-type semiconductor layer structure. In this embodiment, the conductive structure 5100P serves as a P electrode of the light-emitting epitaxial structure 5100.

In the embodiment shown in Fig. 5, the conductive structure 5200N is located on a side of the conductive base layer 5500 relative to the light receiving structure 5200, and is electrically connected to the light receiving structure 5200 through the conductive base layer 5500. In one embodiment, the light receiving structure 5200 may be a photodiode, such as an avalanche photodiode or a PIN photodiode. In the embodiment shown in Fig.5, the conductive structure 5200N serves as an N electrode of the light receiving structure 5200.

In the embodiment shown in Fig. 5, the conductive structure 5400 is connected to the upper portion of the light receiving structure 5200 and is electrically connected to the lower DBR 5100L through the light receiving structure 5200. Therefore, the conductive structure 5400 is a common electrode of the epitaxial light emitting structure 5100 and the light receiving structure 5200. In this embodiment, the conductive structure 5400 is both an N electrode of the epitaxial light emitting structure 5100 and a P electrode of the light receiving structure 5200.

In one embodiment, referring to Fig. 5, the light-emitting epitaxial structure 5100 may further include a current confinement layer 5125 located between the upper DBR 5100U and the active structure 5100A, and the current confinement layer 5125 includes a current restriction region 5125B and a current conduction region 5125A surrounded and delimited by the current restriction region 5125B. The active structure 5100A may be a single-layer or multi-layer structure. For example, the active structure 5100A may include at least one quantum well layer. In addition, the active structure 5100A may include at least one current confinement layer and/or at least one tunnel junction structure.

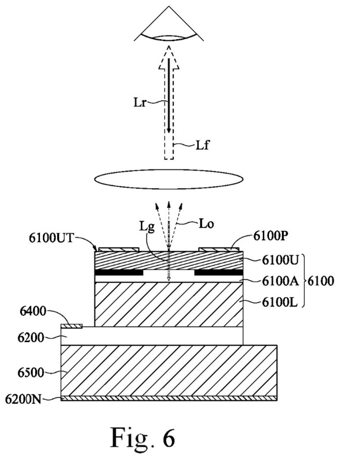

In one embodiment, referring to Fig. 6, which is a schematic diagram of an application of a packaging structure of an optoelectronic device according to one embodiment. In this embodiment, the structure of the optoelectronic device 6 is similar to that of the optoelectronic device 5, and the difference is mainly that in this embodiment, the conductive structure 6400 is located on one side of the light-emitting epitaxial structure 6100, while in the embodiment shown in Fig. 5, the conductive structure 5400 is located on both sides of the light-emitting epitaxial structure 5100. In some embodiments, the conductive structure 5400 is annular. In addition, in the embodiment shown in Fig. 6, the light-emitting epitaxial structure 6100 (corresponding to the light-emitting structure of the optoelectronic unit 6) and the light-receiving structure 6200 are sequentially arranged on the conductive base layer 6500. In this embodiment, the light-emitting epitaxial structure 6100 (corresponding to the light-emitting structure of the optoelectronic unit 6) and the light-receiving structure 6200 are sequentially arranged on the conductive base layer 6500. In this embodiment, the light-emitting epitaxial structure 6100 may be a vertical cavity surface emitting laser, which may be a stacked epitaxial structure, including an upper DBR 6100U, a lower DBR 6100L, and an active structure 6100A located between the upper DBR 6100U and the lower DBR 6100L. In the embodiment shown in Fig. 6, the conductive structure 6100P is on the upper surface 6100UT of the upper DBR 6100U and is electrically connected to the upper DBR 6100U. In the embodiment shown in Fig. 6, the upper DBR 6100U includes a P-type semiconductor structure, and the lower DBR 6100L includes an N-type semiconductor layer structure. In this embodiment, the conductive structure 6100P serves as a P electrode of the light-emitting epitaxial structure 6100. In the embodiment shown in Fig. 6, the conductive structure 6200N is located on a side of the conductive base layer 6500 relative to the light receiving structure 6200, and is electrically connected to the light receiving structure 6200 through the conductive base layer 6500. In one embodiment, the light receiving structure 6200 may be a photodiode, such as an avalanche photodiode or a PIN photodiode. In the embodiment shown in Fig. 6, the conductive structure 6200N serves as the N electrode of the light receiving structure 6200. In the embodiment shown in Fig. 6, the conductive structure 6400 is connected to the upper portion of the light receiving structure 6200 and is electrically connected to the lower DBR 6100L through the light receiving structure 6200. Therefore, the conductive structure 6400 is a common electrode of the epitaxial light emitting structure 6100 and the light receiving structure 6200. In this embodiment, the conductive structure 6400 is both the N electrode of the epitaxial light emitting structure 6100 and the P electrode of the light receiving structure 6200.

Fig. 6 is an illustrative schematic diagram of a packaging structure of an optoelectronic device for eye tracking according to some embodiments, wherein the optoelectronic device 6 is an SMI sensing device, including at least one SMI sensing unit, which can be installed on a head-mounted display, for example. The optoelectronic device 6 can be used in conjunction with a micro-optical device (e.g., microlenses) for eye tracking. The coherent light Lo emitted by the light emitting device (e.g., VCSEL) in the SMI sensing unit is focused and projected by the microlens to become focused light Lf, which is then projected to the eyeball and reflected by the eyeball. The reflected light Lr reflected by the eyeball returns to the resonant cavity in the VCSEL of the SMI sensing unit and generates interference light Lg. The change of the interference light Lg is detected by the receiving device (e.g., APD or PIN) in the SMI sensing unit and the output is calculated to obtain the rotation (movement) offset or speed of the measured eyeball.

According to one embodiment, an SMI sensing device for eye tracking includes a plurality of SMI sensing units distributed in an array, wherein the matching micro-optical device may be a microlens array, and each microlens respectively calibrates the light outlet of the VCSEL of each SMI sensing unit to generate a large field of view (FOV) projected sensing light, for example, a projected sensing light with a FOV of 60*45, but the present application is not limited thereto.

According to one embodiment, the light transmission distance of the SMI sensing device for eye tracking is generally between 25 and 30 mm, and the spot size of the projected sensing light is generally not greater than 200 microns, but the present application is not limited thereto.

It is worth noting that the SMI sensing device shown in one or more embodiments of the present application can also be used to detect information such as rotation (movement) offset or speed of other types of objects to be measured (for example, body movements, car movements, etc.).

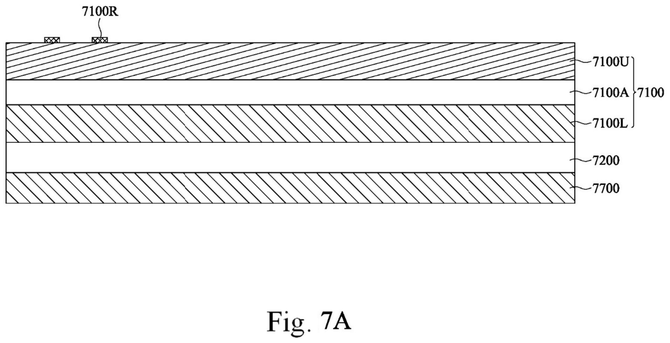

Fig. 7A to 7K are schematic cross-sectional views illustrating multiple steps of a process for manufacturing a packaging structure of an optoelectronic device according to an embodiment.

As shown in Fig. 7A, an epitaxial chip is provided. The epitaxial chip includes a light receiving layer 7200 and a light emitting layer (light emitting epitaxial layer 7100) formed on a conductive base layer 7700, and the light emitting epitaxial layer 7100 is located on the light receiving layer 7200. The light emitting epitaxial layer 7100 includes a first type semiconductor layer 7100U, a second type semiconductor layer 7100L, and an active layer 7100A located between the first type semiconductor layer 7100U and the second type semiconductor layer 7100L.

The first type semiconductor layer 7100U and/or the second type semiconductor layer 7100L may be a multi-layer structure. In the present embodiment, the first type semiconductor layer 7100U is a P-type semiconductor layer, and the second type semiconductor layer 7100L is an N-type semiconductor layer. The light receiving structure 7200 and the light emitting structure (light-emitting epitaxial structure 7100) may be grown on the conductive base layer 7700 by epitaxy. The epitaxy method includes but is not limited to metal organic chemical vapor deposition, hydride vapor phase epitaxy, molecular beam epitaxy, liquid phase epitaxy, etc. The light receiving structure 7200 may be an avalanche photodiode or a PIN photodiode. The conductive base layer 7700 includes but is not limited to III-V materials, whose lattice constant matches the semiconductor stack layer 10. The material of the conductive base layer 7700 in the present embodiment is gallium arsenide (GaAs). In other embodiments, the material of the conductive base layer 7700 may be Indium phosphide (InP), sapphire, gallium nitride (GaN) or silicon carbide (SiC), etc.

Next, referring to Fig. 7A, a ring-shaped electrode structure 7100R is formed on the first type semiconductor layer 7100U of the epitaxial chip, wherein the ring-shaped electrode structure 7100R is electrically connected to the first type semiconductor layer 7100U. The material of the ring-shaped electrode structure 7100R can be a conductive metal.

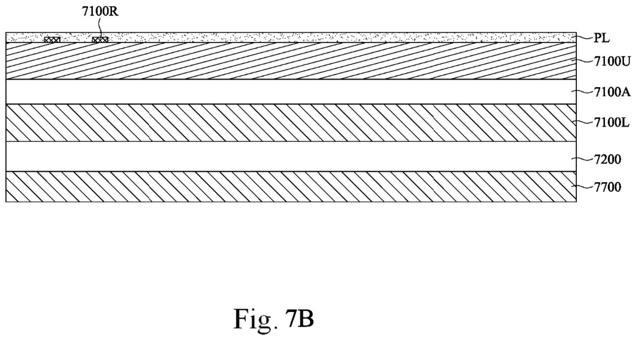

Next, referring to Fig. 7B, a protection layer PL is formed to cover the first type semiconductor layer 7100U of the epitaxial chip, wherein the material of the protection layer PL may be an insulating material, including but not limited to silicon nitride.

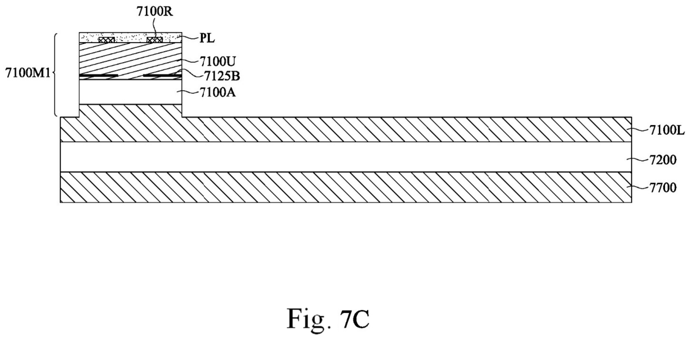

Next, referring to Fig. 7C, an etching process is performed on the semiconductor stacking layer of the epitaxial chip, and a mask with a specific pattern is used to etch away a portion of the first type semiconductor layer 7100U, a portion of the active layer 7100A and a portion of the second type semiconductor layer 7100L and expose the second type semiconductor layer 7100L, thereby forming a mesa structure 7100M1.

Next, as also shown in Fig. 7C, a current confinement layer 7125 is formed in the epitaxial light emitting layer 7100. In this embodiment, the method for forming the current confinement layer 7125 may be to oxidize the material in the region where the current restriction region 7125B is to be formed by an oxidation process. For example, the aluminum content of at least one layer of the first type semiconductor layer 7100U is greater than 97% (defined as the layer to be formed into the current confinement layer 7125) and greater than the aluminum content of the active layer 7100A and the second type semiconductor layer 7100L. Therefore, when the oxidation process is performed, the high aluminum content layer region (defined as the layer to be formed into the current confinement layer 7125) in the epitaxial light emitting layer 7100 is oxidized inward at a higher rate than other regions, thereby forming a current restriction region 7125B with low conductivity in the current confinement layer 7125. Alternatively, a current restriction region 7125B with low conductivity can be formed in the light-emitting epitaxial layer 7100 by an ion implantation process, and the current conduction region 7125A can be defined by a mask at the same time. The ion implantation can be achieved by implanting hydrogen ions (H +), helium ions (He +) or argon ions (Ar +) in the area where the current restriction region 7125B is to be formed. The ion concentration of the current restriction region 7125B is much greater than that of the current conduction region 7125A, so that the current restriction region 7125B has a lower conductivity.

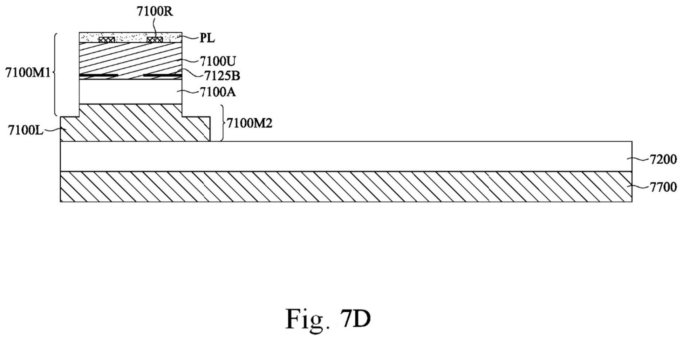

Next, referring to Fig. 7D, an etching process is again performed on the light-emitting epitaxial layer 7100 of the aforementioned epitaxial chip, and a mask with a specific pattern is used to etch away a portion of the second type semiconductor layer 7100L and expose the light receiving layer 7200, thereby forming a mesa structure 7100M2.

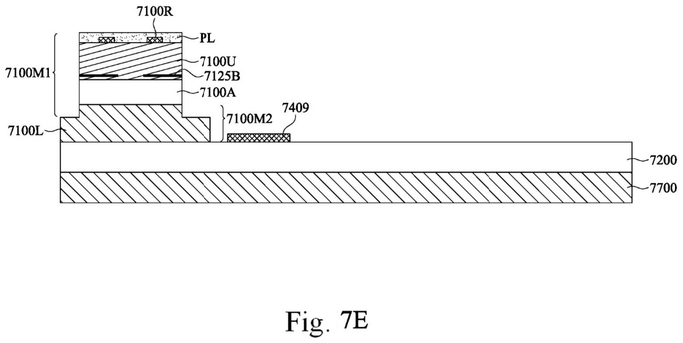

Next, referring to Fig. 7E, an electrode structure 7409 is formed on the light receiving layer 7200 of the epitaxial chip, wherein the electrode structure 7409 is electrically connected to the light receiving layer 7200, and the electrode structure 7409 is also electrically connected to the second type semiconductor layer 7100L through the light receiving layer 7200. The material of the electrode structure 7409 can be a conductive metal.

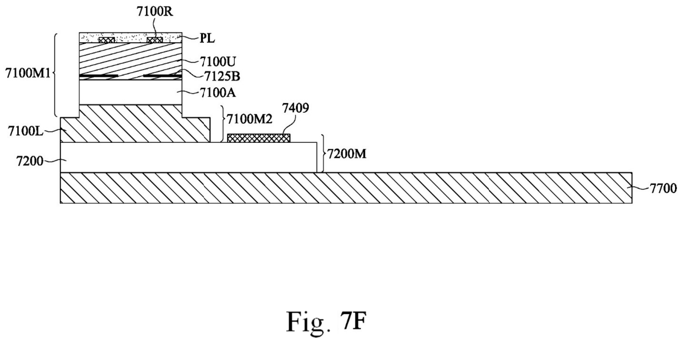

Next, as shown in Fig. 7F, an etching process is performed on the light receiving layer 7200 of the epitaxial chip, and a mask with a specific pattern is used to etch away a portion of the light receiving layer 7200 and expose the conductive base layer 7700, thereby forming a mesa structure 7200M.

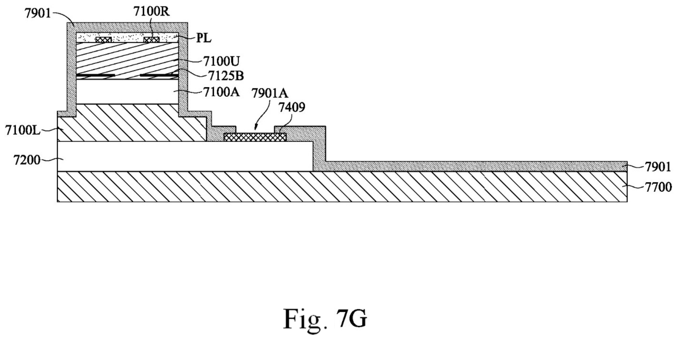

Next, as shown in Fig. 7G, an insulating layer 7901 is formed to cover the light-emitting epitaxial layer 7100, the light-receiving layer 7200 and the conductive base layer 7700. An opening 7901A is further formed in the insulating layer 7901 to expose a portion of the electrode structure 7409.

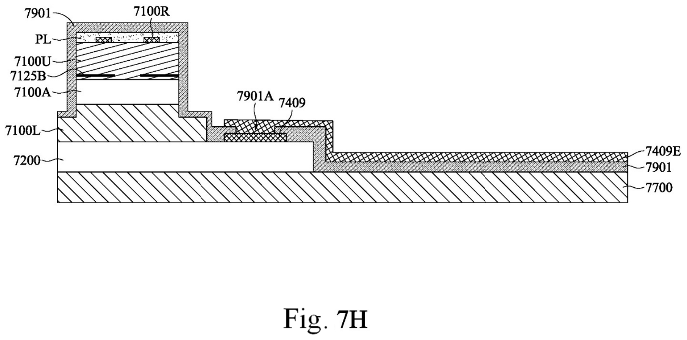

Next, please refer to Figure 7H, an extended electrode 7409E is formed in the opening 7901A and extended to the light receiving layer 7200 and the conductive base layer 7700 of the epitaxial chip, so that the electrode structure 7409 is electrically connected to the light receiving layer 7200 and the extended electrode 7409E is electrically connected to the second type semiconductor layer 7100L through the light receiving layer 7200, and the distribution range of the extended electrode 7409E is increased.

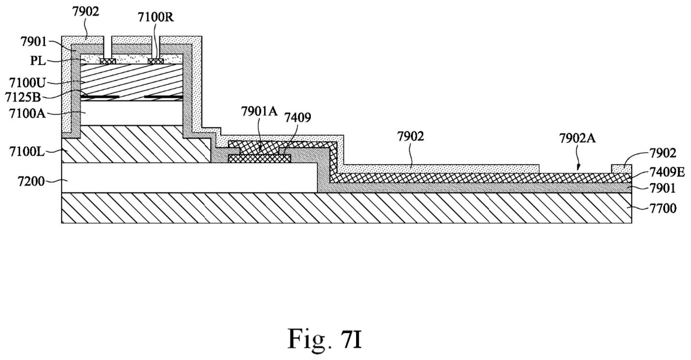

Next, as shown in Fig. 7I, an insulating layer 7902 is formed again to cover the epitaxial light emitting layer 7100, the light receiving layer 7200 and the conductive base layer 7700. An opening 7902A is further formed in the insulating layer 7902 to expose the ring-shaped electrode structure 7100R of the first type semiconductor layer 7100U located in the epitaxial light emitting layer 7100 and a portion of the extended electrode 7409E located on the conductive base layer 7700.

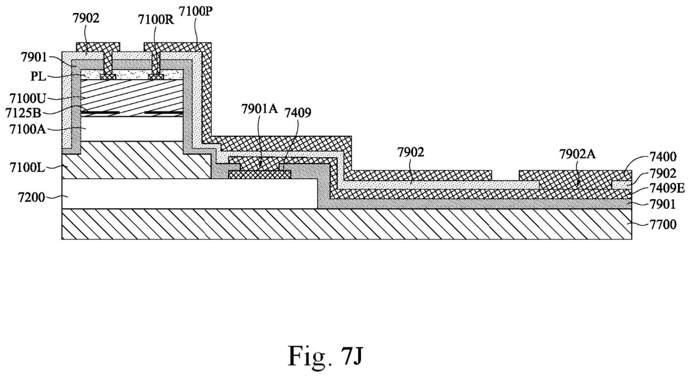

Next, as shown in Fig. 7J, a conductive structure 7100P is formed to be electrically connected to the ring-shaped electrode structure 7100R of the first type semiconductor layer 7100U of the light-emitting epitaxial layer 7100, and extends to the insulating layer 7902 located on the light receiving layer 7200 and the conductive base layer 7700. In addition, an opening 7902A of the conductive structure 7400 located on the conductive base layer 7700 is formed. In this embodiment, the conductive structure 7400 is electrically connected to the light receiving structure 7200 through the electrode structure 7409 and the extended electrode 7409E, and is electrically connected to the second type semiconductor layer 7100L through the light receiving structure 7200. Therefore, the conductive structure 7400 is a common electrode of the light-emitting epitaxial structure 7100 and the light receiving structure 7200. In this embodiment, the conductive structure 7400 is simultaneously an N electrode of the light-emitting epitaxial structure 7100 and a P electrode of the light receiving structure 7200.

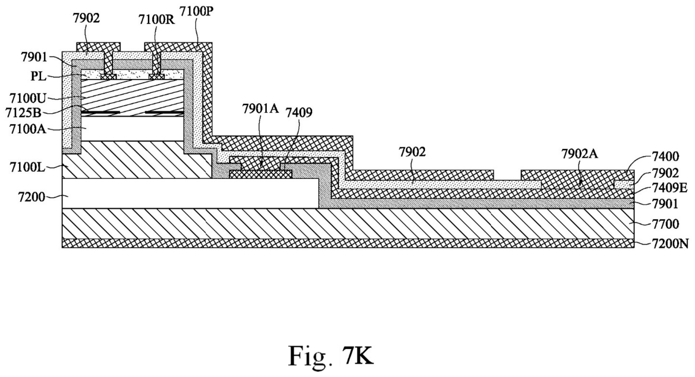

Finally, as shown in Fig. 7K, a conductive structure 7200N is formed on the other side of the conductive base layer 7700 relative to the light-emitting epitaxial layer 7100. The conductive structure 7200N is electrically connected to the light receiving layer 7200 through the conductive base layer 7700.

Typically, multiple vertical cavity surface emitting laser chips (VCSEL chips) are produced separately through the singulation process on the same epitaxial wafer (epi-wafer).

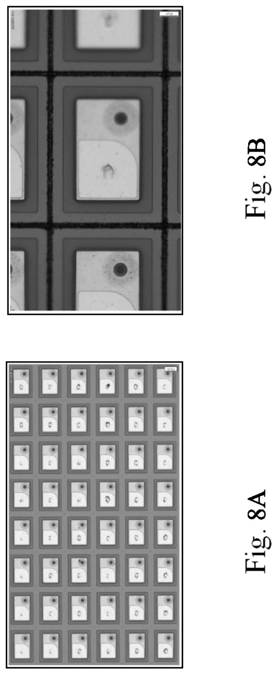

Fig. 8A is a top view of a portion of a VCSEL wafer taken by an optical microscope. Fig. 8B is a top view of a portion of a VCSEL wafer taken by an optical microscope. The magnification of the optical microscope in Fig. 8B is greater than that in Fig. 8A. Referring to Fig. 8A, the VCSEL wafer includes an array-forming 48 VCSEL units on a GaAs wafer.

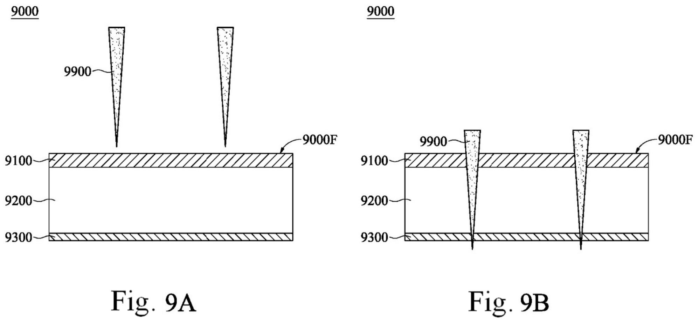

FIGS. 9A and 9B are schematic diagrams showing a conventional VCSEL die singulation process using an ablation laser or a cutting machine 9900 from the front side 9000F of a thinned VCSEL wafer 9000, wherein a cutting street of about 30 microns to 40 microns in width is required to be retained in the VCSEL wafer 9000. It should be noted that by reducing the size of the cutting street, the number of chips (dies) cut from the VCSEL wafer 9000 can be increased, thereby reducing the overall production cost.

The VCSEL wafer 9000 includes a bottom metal layer 9300, a thinned wafer layer 9200 on the bottom metal layer 9300, and an epitaxial layer 9100 on the thinned wafer layer 9200.

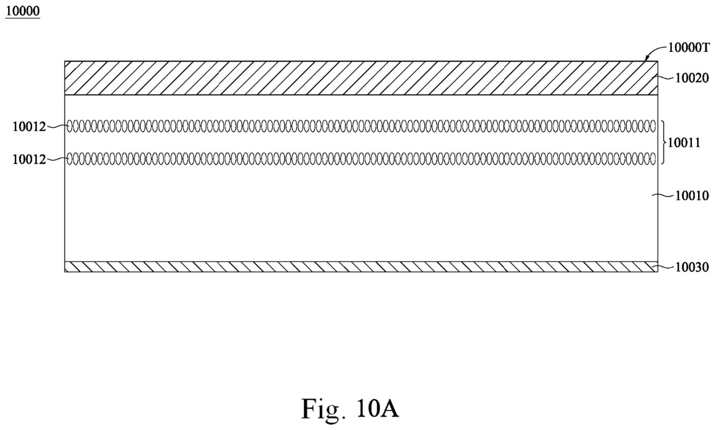

FIGS. 10A to 10C are schematic diagrams illustrating a process method for singulating a thinned VCSEL wafer to cut out a plurality of crystal grains according to an embodiment. According to the method shown in Fig. 10A to Fig. 10C, the width of the cutting street can be reduced to 20 microns or less. In the present embodiment, a process method for singulating an epitaxial wafer 10000 is provided, wherein the epitaxial wafer 10000 comprises a semiconductor stacking layer 10020 (e.g., a VCSEL stacking layer), a base layer 10010, and a metal layer 10030, wherein the base layer 10010 is located between the semiconductor stacking layer 10020 and the metal layer 10030, and the base layer 10010 can be a growth wafer layer of the semiconductor stacking layer 10020 (e.g., a growth wafer of the VCSEL stacking layer). Generally speaking, in order to facilitate the effective singulation process, the base layer 10010 can be a growth wafer layer after thinning. In addition, the base layer 10010 can be made of glass (such as silicon-based glass or sapphire glass) or a III-V compound. In some embodiments, the III-V compound is GaAs, InP or GaSb.

In this embodiment, the singulation process method includes a processing step, a cutting step and a splitting step, and each step is described below.

Processing steps: Please refer to Fig. 10A. A portion of the inner area of the base layer 10010 is processed from the upper surface 10000T of the epitaxial wafer 10000 (for example, a VCSEL epitaxial wafer) using a stealth dicing process technology, and a processing area 10011 is formed in the portion of the inner area of the base layer 10010. The processing area 10011 includes at least one row of breaking points 10012, and the extension direction of the at least one row of breaking points 10012 is substantially parallel to the extension direction of the lower surface 10000B of the epitaxial wafer 10000, and the distance between the processing area 10011 and the upper surface 10000T of the epitaxial wafer 10000 is generally not more than 60 microns. In other words, in this embodiment, the region within a depth range of 60 microns from the upper surface 10000T of the epitaxial wafer 10000 is processed by the stealth cutting process, so that the crystal phase in the processing region 10011 in the base layer 10010 changes and a breaking point 10012 (or a structural weakening point) is generated. In some embodiments, the invisible cutting process is achieved by laser, and the wavelength of the laser is 1064 nanometers. In some embodiments, the upper surface 10000T of the epitaxial wafer 10000 is flat. It should be noted that the position of the breaking point 10012 must avoid the semiconductor stacking layer 10020 of the epitaxial wafer to avoid affecting the performance of the semiconductor laser.

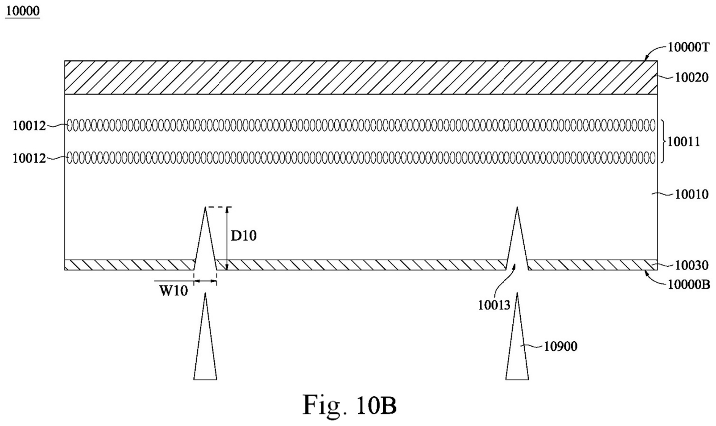

Cutting step: Please refer to Fig. 10B. Using laser lift-off technology or wheel cutting technology (e.g., using ablation laser or cutting machine 10900) to cut the metal layer 10030 and another part of the base layer 10010 from the lower surface 10000B of the epitaxial wafer 10000, and forming a cutting street 10013 (cutting groove) in the metal layer 10030 and the other part of the base layer 10010. The cutting street 10013 has a cutting width W10 and a cutting depth D10. The cutting width W10 is less than 20 microns, and the cutting depth D10 is 30 microns, but the present application is not limited thereto.

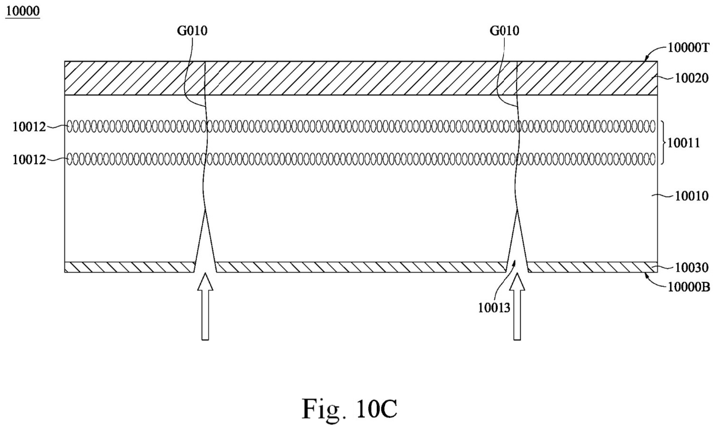

Splitting step: Please refer to Fig. 10C. Using the splitting technology on the cutting street 10013, the epitaxial wafer is split into multiple dies (chips). **In** this embodiment, a splitting force (for example, using a splitting fixture, as shown by the arrows in the figure) is applied to each groove (cutting street 10013) to form a crack G010 extending from the groove tip of each groove to the upper surface 10000T of the epitaxial wafer 10000, so as to split the epitaxial wafer 10000 into multiple VCSEL grains (chips). **In** this embodiment, the fixture can be fixed to a specific part of the epitaxial wafer 10000, and an external force can be applied to split the epitaxial wafer 10000 into multiple semiconductor lasers.

According to the singulation method of this embodiment, for the epitaxial wafer 10000 of the same size, a narrower width of the cutting street 10013 can be obtained, and more semiconductor lasers can be cut out, thereby reducing the overall production cost.

**In** some embodiments, in the aforementioned step of forming the processing area 10011, a plurality of first processing areas are formed on the base layer 10010 along the length direction of the top view of the epitaxial wafer 10000, and a plurality of second processing areas are formed along the width direction of the top view of the epitaxial wafer 10000. Each first processing area includes at least one row of first breaking points, and each second processing area includes at least one row of second breaking points. Furthermore, the extension direction of the at least one row of first breaking points is substantially parallel to the length direction of the top view of the epitaxial wafer 10000, and the extension direction of the at least one row of second breaking points is substantially parallel to the width direction of the top view of the epitaxial wafer 10000. That is, in this embodiment, the stealth cutting process technology can be used to process multiple parts of the epitaxial wafer 10000 (simultaneously or in batches), and multiple processing areas 10011 are formed in the length direction and the width direction, and each processing area 10011 includes at least one row of breaking points 10012. Furthermore, according to the thickness of the base layer 10010, multiple rows of breaking points 10012 can be formed in the same processing area. For example, when the thickness of the base layer 10010 increases, the number of rows of the breaking points 10012 can be further increased to more effectively control the direction in which the crack G010 extends.

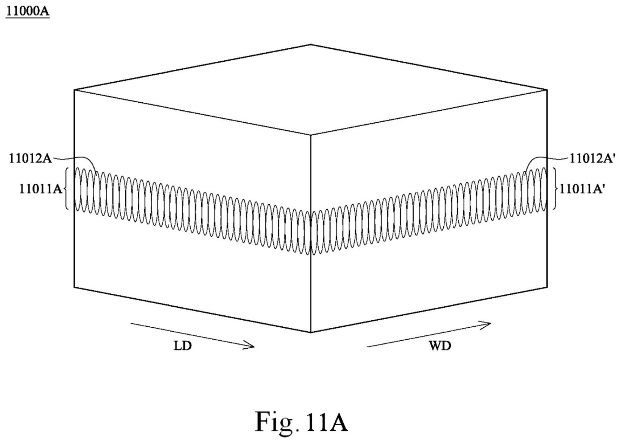

Fig. 11A to 11D are schematic perspective views illustrating processing steps of a method for singulating an epitaxial wafer according to some embodiments.

As shown in Fig. 11A, in this embodiment, each first processing area 11011A of the epitaxial wafer 11000A includes a row of first breaking points 110 12A, and each second processing area 11011A' includes a row of second breaking points 11012A'. The extension direction of the row of first breaking points 11012A is substantially parallel to the length direction LD of the top view of the epitaxial wafer 11000A, and the extension direction of the row of second breaking points 110 12A' is substantially parallel to the width direction WD of the top view of the epitaxial wafer 11000A.

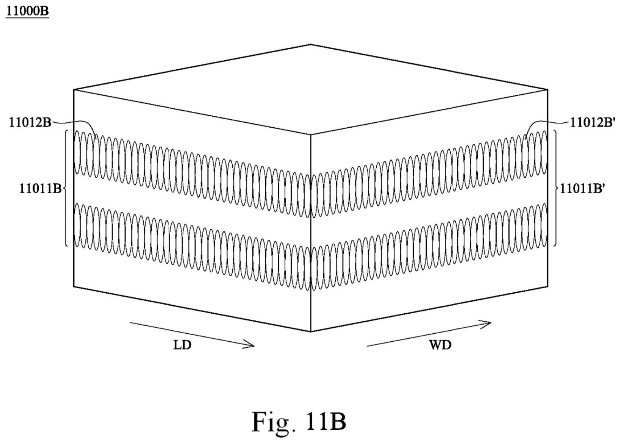

As shown in Figure 11B, in this embodiment, each first processing area 11011B of the epitaxial wafer 11000B includes two rows of first breaking points 11012B, and each second processing area 11011B' includes two rows of second breaking points 11012B'. The extension direction of each row of first breaking points 11012B is substantially parallel to the length direction LD of the top view of the epitaxial wafer 11000B, and the extension direction of each row of second breaking points 11012B' is substantially parallel to the width direction WD of the top view of the epitaxial wafer 11000B.

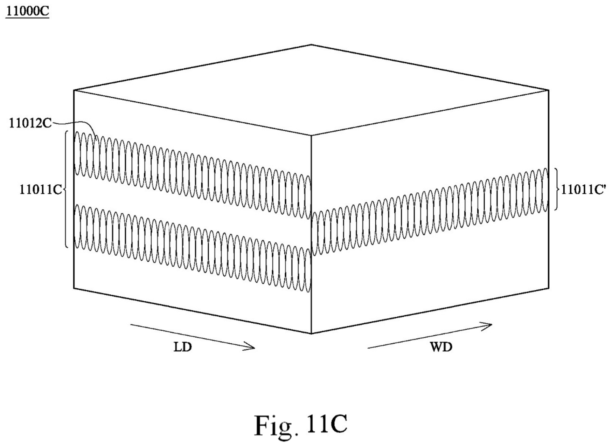

As shown in Fig. 11C, in the present embodiment, each first processing area 11011C of the epitaxial wafer 11000C includes two rows of first breaking points 11012C, and each second processing area 11011C' includes a row of second breaking points 11012C'. The extension direction of each row of first breaking points 11012C is substantially parallel to the length direction LD of the top view of the epitaxial wafer 11000C, and the extension direction of the row of second breaking points 11012C' is substantially parallel to the width direction LD of the top view of the epitaxial wafer 11000C. In some embodiments, the number of rows of the first breaking points 11012C and the number of rows of the second breaking points 11012C' may also be different.

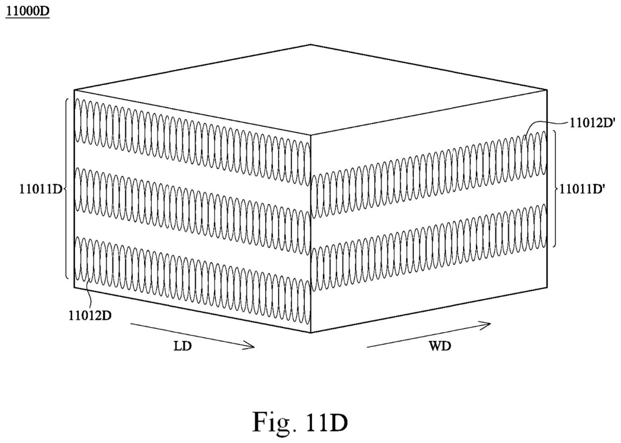

As shown in Figure 11D, in this embodiment, each first processing area 11011D of the epitaxial wafer 11000D includes three rows of first breaking points 11012D, and each second processing area 11011D' includes two rows of second breaking points 11012D'. The extension direction of each row of first breaking points 11012D is substantially parallel to the length direction LD of the top view of the epitaxial wafer 11000D, and the extension direction of each row of second breaking points 11012D' is substantially parallel to the width direction WD of the top view of the epitaxial wafer 11000D.

As shown in Fig. 11C and Fig. 11D, in some embodiments, the first row of breaking points 11012C, 110 12D and the second row of breaking points 11012C', 11012D' are arranged alternately.

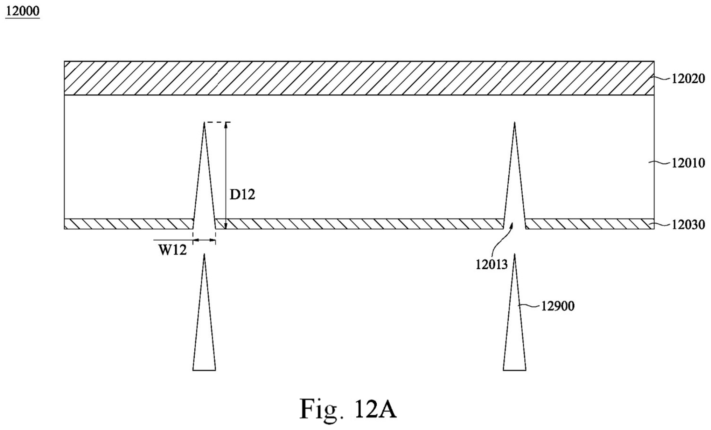

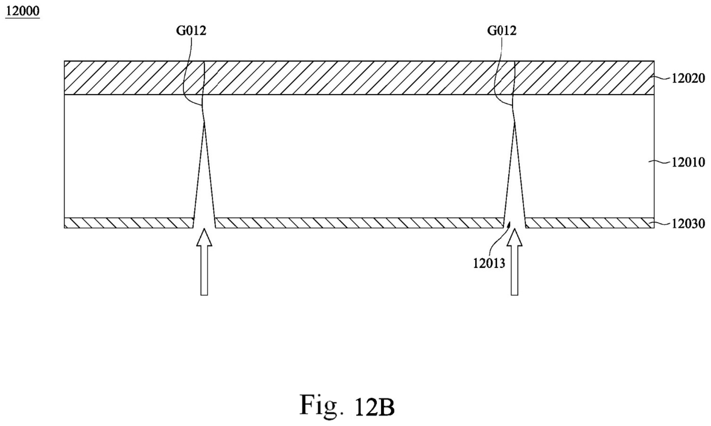

FIGS. 12A and 12B are schematic diagrams showing a process method for singulating a thinned VCSEL wafer to cut out a plurality of dies according to an embodiment. According to the method shown in FIGS. 12A and 12B, the width of the cutting street 12013 can be reduced to 10 microns or less.

In the present embodiment, a method for performing a singulation process on an epitaxial wafer is provided, wherein the epitaxial wafer 12000 comprises a semiconductor stacking layer 12020 (e.g., a VCSEL stacking layer), a base layer 12010 and a metal layer 12030, the base layer 12010 is located between the semiconductor stacking layer 12020 and the metal layer 12030, and the base layer 12010 may be a growth wafer layer of the semiconductor stacking layer 12010 (e.g., a growth wafer of the VCSEL stacking layer).

In this embodiment, the singulation method includes a cutting step and a splitting step, and each step is described below.

Cutting step: using laser stripping technology or wheel cutting technology (for example: use ablation laser or cutting machine 12900) to cut the metal layer 12030 and a portion of the base layer 12010 from the lower surface of the epitaxial wafer 12000, and form a cutting street 12013 in the metal layer 12030 and the portion of the base layer 12010. The cutting street 12013 has a cutting width W12 and a cutting depth D12. The cutting width W12 is less than 10 microns, and the cutting depth D12 generally does not exceed 90 microns.

Splitting step: using a splitting technique (eg, using a splitting tool, as indicated by the arrows in the figure) on the cutting street 12030 to split the epitaxial wafer 12000 into a plurality of semiconductor lasers.

Please refer to Fig. 12A. In this embodiment, a dicing process (eg, using an ablation laser or a dicing machine 12900) is performed on the back side of the thinned epitaxial wafer 12000 and grooves (cutting streets 12013) are formed in the thinned epitaxial wafer 12000.

Please refer to Fig. 12B. In this embodiment, a cleaving force is provided to form cracks G012 extending from the vertices of each groove to the front side of the epitaxial wafer 12000, thereby splitting the epitaxial wafer 12000 into a plurality of VCSEL dies (chips).

According to the method for singulating the epitaxial wafer 12000 in some embodiments of the present invention, the cutting width D12 can be reduced to less than 10 microns.

According to the singulation method of this embodiment, for an epitaxial wafer of the same size, a narrower cutting street width can be obtained, and more semiconductor lasers can be cut out, thereby reducing the overall production cost.

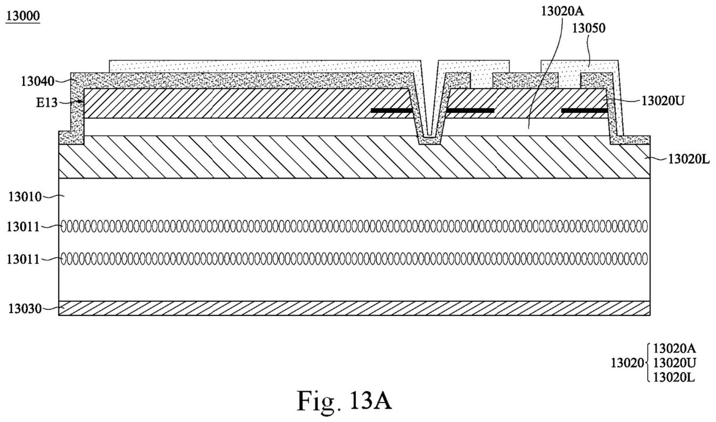

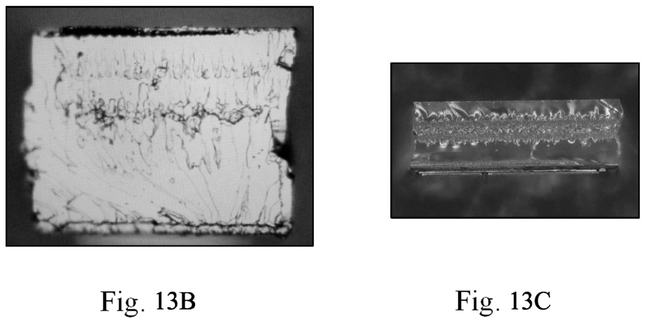

Please refer to FIGS 13A to 13C. Fig. 13A is a schematic cross-sectional view of a VCSEL chip 13000 according to an embodiment. FIGS. 13B and 13C are cross-sectional images of a VCSEL chip taken by an optical microscope, wherein the VCSEL chip is cut from a VCSEL wafer.

As shown in FIGS. 13A to 13C, in this embodiment, the semiconductor laser includes a base layer 13010, an epitaxial structure 13020 located on the base layer 13010, an insulating layer 13030, a first electrode 13040, and a second electrode 13050. The epitaxial structure 13020 includes an upper reflector 13020U, a lower reflector 13020L, and an active region 13020A between the reflector 13020U and the lower reflector 13020L. The upper reflector 13020U, the active region 13020A and the lower reflector 13020L are stacked on the base layer 13010. The second electrode 13050 is on the epitaxial structure 13020 and electrically connected to the semiconductor layer of the upper reflector 13020U. The first electrode 13040 is on the base layer 13010 and electrically connected to the semiconductor layer of the lower reflector 13020L. The second electrode 13050 includes at least one metal layer and a P-type contact layer, connected to the P-type semiconductor layer of the upper reflector 13020U, and the first electrode 13040 includes at least one metal layer connected to the base layer 13010 and electrically connected to the N-type semiconductor layer of the lower reflector 13020L. The insulating layer 13030 is located between the epitaxial structure 13020 and the second electrode 13050, and extends to the side surface E13 of the epitaxial structure 13020 to prevent the second electrode 13050 from directly contacting the active area 13020A and the lower reflector 13020L. The side surface of the base layer 13010 has at least one row of breaking points 13011. As shown in Fig. 13A and Fig. 13B, in this embodiment, the side surface of the base layer 13010 has two rows of breaking points 13011, and the breaking points 13011 are generated by using the singulation process of the above-mentioned embodiment.

In one or more embodiments, as shown in Fig. 13A, the upper reflector 13020U is a multilayer structure, the lower reflector 13020L is a multilayer structure, and at least one or both of the upper reflector 13020U and the lower reflector 13020L include a distributed Bragg reflector (DBR) structure.

In some embodiments, the semiconductor laser may be a vertical chip structure VCSEL or a flip chip VCSEL.

Please refer to Fig. 13B. In this embodiment, the semiconductor laser is a VCSEL with a vertical chip structure. For a VCSEL with a vertical chip structure, the base layer is a growth substrate; in other words, in this embodiment, the semiconductor stacking layer is directly formed on the base layer by a semiconductor epitaxial process. In this embodiment, the breaking point is formed in the base layer as the growth substrate.

Please refer to Fig. 13C. In this embodiment, the semiconductor laser is a flip-chip VCSEL. For a flip-chip VCSEL, the base layer is a bonding substrate. In other words, in this embodiment, the semiconductor stacking layer is first formed on the growth substrate through an epitaxial semiconductor process, and then transferred to the base layer through a subsequent layer. In this embodiment, the breaking point is formed in the base layer as the bonding substrate.

Generally speaking, multiple VCSEL chips are produced by singulation of the same VCSEL epitaxial wafer (epi-wafer), and the optoelectronic properties of all chips are first tested in the epitaxial wafer state before the singulation process. Then, the optoelectronic properties of each VCSEL chip produced by the epitaxial wafer after the singulation process are tested again. After the singulation process, because the appearance and structure of all the singulated chips are similar, it is difficult to trace the appearance of each chip in the epitaxial wafer state. Therefore, it is not easy to understand the optoelectronic properties of each chip in the epitaxial wafer state before the singulation process, and it is not easy to trace the test results of any singulated chip back to the test results of the same chip in the epitaxial wafer state before singulation.

The present application provides a manufacturing method to form a plurality of pattern structures with different shapes on each chip before performing a singulation process, and each chip has a corresponding set of pattern structures. Therefore, after the singulation process, the position of each chip in the epitaxial wafer state can be traced through the set of pattern structures each chip has.

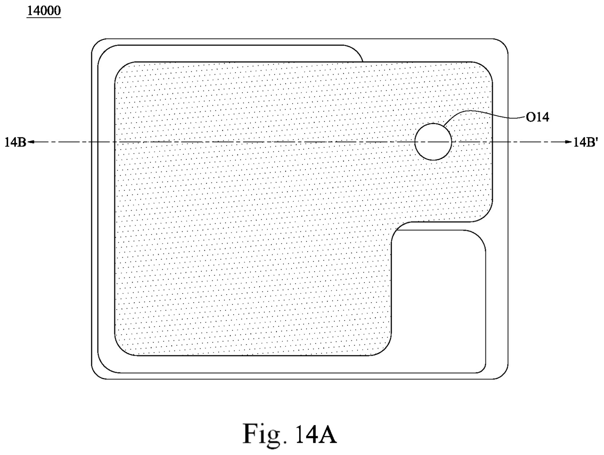

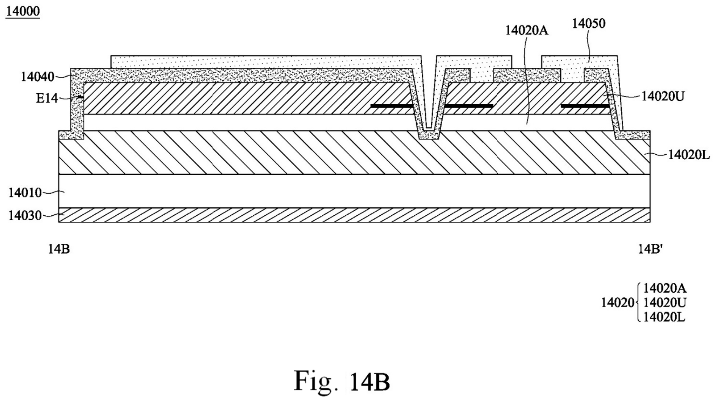

Fig. 14A and Fig. 14B are different schematic diagrams of a VCSEL chip 14000 according to an embodiment. Fig. 14A is a top view of a VCSEL chip 14000 according to an embodiment. Fig. 14B is a cross-sectional schematic diagram of a cross section along the line 14B-14B' of Fig. 14A. The structure of the VCSEL chip 14000 is a stacked structure, which includes a base layer 14010, an epitaxial structure 14020 located on the base layer 14010, an insulating layer 14040, an electrode 14050, and an electrode 14030.

In one or more embodiments, as shown in Fig. 14B, the epitaxial structure 14020 includes an upper reflector 14020U, a lower reflector 14020L, and an active region 14020A located between the upper reflector 14020U and the lower reflector 14020L. The upper reflector 14020U, the active region 14020A, and the lower reflector 14020L are stacked on a base layer 14010. In this embodiment, as shown in Fig. 14B, the base layer 14010 is a growth substrate on which the epitaxial structure 14020 grows, for example, the lower reflector 14020L, the active region 14020A, and the upper reflector 14020U can be epitaxially grown on the base layer 14010.

In this embodiment, as shown in Fig. 14B, the base layer 14010 includes a semiconductor layer, such as a GaAs layer, an InP layer, and/or the like.

In one or more embodiments, the base layer 14010 may include a support substrate adhered to the VCSEL stack structure/epitaxial structure.

In one or more embodiments, as shown in Fig. 14B, the upper reflector 14020U is a multilayer structure, the lower reflector 14020L is a multilayer structure, and at least one or both of the upper reflector 14020U and the lower reflector 14020L include a distributed Bragg reflector (DBR) structure.

In one or more embodiments, as shown in Fig. 14B, the upper reflector 14020U and the lower reflector 14020L include semiconductor layers. In this embodiment, as shown in Fig. 14B, the upper reflector 14020U includes a P-type semiconductor layer and the lower reflector 14020L includes an N-type semiconductor layer, but the present application is not limited thereto. In some embodiments, the upper reflector 14020U includes an N-type semiconductor layer and the lower reflector 14020L includes a P-type semiconductor layer.

In this embodiment, as shown in Fig. 14B, the upper reflector 14020U includes a P-doped reflector, such as a P-doped distributed Bragg reflector (P-doped DBR, PDBR), for example, the upper reflector 14020U includes a group of alternatingly stacked P-doped GaAs (P-GaAs) layers and P-doped AlGaAs (P-AlGaAs) or a group of alternatingly stacked P-doped AlGaAs with a low aluminum percentage (low Al P-AlGaAs) and P-doped AlGaAs with a high aluminum percentage (high Al P-AlGaAs).

In this embodiment, as shown in Figure 14B, the lower reflector 14020L includes an N-doped reflector, such as an N-doped distributed Bragg reflector (N-doped DBR, NDBR), for example, the lower reflector 14020L includes a group of alternatingly stacked N-doped GaAs (N-GaAs) layers and N-doped AlGaAs (N-AlGaAs) or a group of alternatingly stacked N-doped AlGaAs with a low aluminum percentage (low Al N-AlGaAs) and N-doped AlGaAs with a high aluminum percentage (high Al N-AlGaAs).

In this embodiment, the N-doped semiconductor layer may be doped with Te, Se or other N-type dopants, and the P-doped semiconductor layer may be doped with C or other P-type dopants.

In one or more embodiments, the DBR structure is formed by a plurality of thin films of alternating materials of different refractive indices, wherein the optical thickness of each thin film is substantially equal to m*1/4 of the emission wavelength, where m is an odd number. The DBR structure includes at least one pair of optical thin films (DBR pair), one of which has a higher refractive index than the other.

In one or more embodiments, the active region 14010A includes a multiple quantum well (MQW) structure.

In one or more embodiments, as shown in Fig. 14B, the epitaxial structure 14020 further includes a current confinement layer 14104, which is selectively located between the active region 14020A and the upper reflector 14020U or between the active region 14020A and the lower reflector 14020L. The current confinement layer 14104 includes a current restriction region 14104B and a current conduction region 14104A surrounded by the current restriction region 14104B. The current conduction region 14104A has a higher conductivity than the current restriction region 14104B, so that the current can be concentrated in the current conduction region 14104A. In one or more embodiments, the current confinement layer 14104 includes aluminum oxide in the current restriction region 14104B.

In one or more embodiments, as shown in Fig. 14A and Fig. 14B, the electrode 14050 is on the epitaxial structure 14020 and electrically connected to the semiconductor layer of the upper reflector 14020U. The electrode 14050 has a light outlet 014 (as shown in Fig. 14A), corresponding to the current conduction region 14104A of the current confinement layer 14104. The electrode 14030 is on the base layer 14010 and electrically connected to the semiconductor layer of the lower reflector 14020L. For example, in the embodiment shown in Fig. 14B, the electrode 14050 includes at least one metal layer and a P-type contact layer, connected to the upper The P-type semiconductor layer of the reflector 14020U, and the electrode 14030 includes at least one metal layer connected to the base layer 14010 and electrically connected to the N-type semiconductor layer of the lower reflector 14020L.

**In** one or more embodiments, as shown in Fig. 14B, the insulating layer 14040 is located between the epitaxial structure 14020 and the electrode 14050, and extends to the side E14 of the epitaxial structure 14020 to prevent the electrode 14050 from directly contacting the active region 14020A and the lower reflector 14020L. The insulating layer 14040 is electrically insulating, and the insulating layer 14040 includes an inorganic or organic insulating material. In this embodiment, as shown in Fig. 14B, the insulating layer 14040 includes a silicon oxide layer, but the present application is not limited to this embodiment.

**Table 1A**

| Decimal Number | Ternary code using pattern codes |
|---|---|
| 0 | 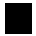 |
| 1 | 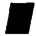 |
| 2 | 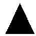 |
| 3 | 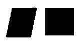 |
| 4 | 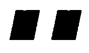 |
| 5 | 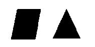 |
| ... | ... |
| 998 | 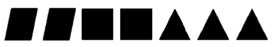 |

**Table 1B**

| Group A |
|---|
| 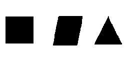 |

Tables 1A and 1B are tables of decimal numbers and ternary codes using pattern codes. In one or more embodiments, as shown in Tables 1A and 1B, pattern codes of different shapes are provided to represent decimal values. For example, as shown in Tables 1A and 1B, the pattern codes of group A include pattern codes of three shapes, namely square, parallelogram and triangle. In this embodiment, as shown in Tables 1A and 1B, the pattern codes of the three shapes in group A represent three numbers in the ternary system, for example, the pattern code of the square represents the number "0", the pattern code of the parallelogram represents the number "1", and the pattern code of the triangle represents the number "2". Therefore, referring to Tables 1A and 1B, the decimal number "998" can be converted into the ternary number "1100222", and the ternary number "1100222" can be converted into the ternary number "1100222" by the pattern code of group A " 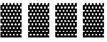 ▲ ▲ ▲". It should be noted that the present application is not limited to the ternary number system, and in one or more embodiments, group A may be a set of pattern codes having N different shapes to represent decimal values, where N is a positive integer greater than 1.

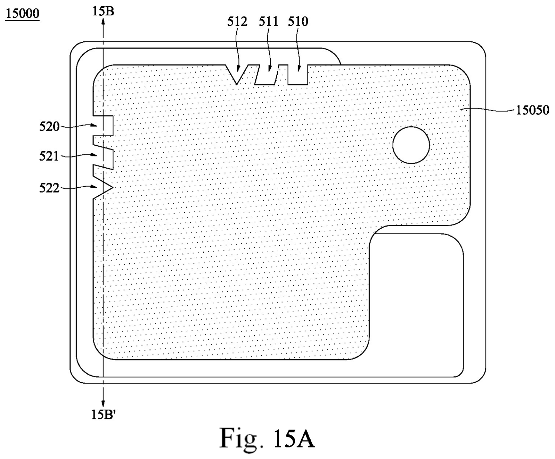

Fig. 15A is a top view of a VCSEL chip 15000 with pattern coding according to an exemplary embodiment. Referring to Table 1A, Table 1B and Fig. 15A, in one or more embodiments, as shown in Fig. 15A, the electrode 15050 reveals at least one set of patterns 510, 511, 512 on the epitaxial structure 15020, and the set of patterns can be coded with the pattern of group A to provide identification of the VCSEL chip 15000. For example, the identification can be the position of the VCSEL chip 15000 on the epitaxial wafer, the serial number or production date of the VCSEL chip 15000, or any other specific information of the VCSEL chip 15000.

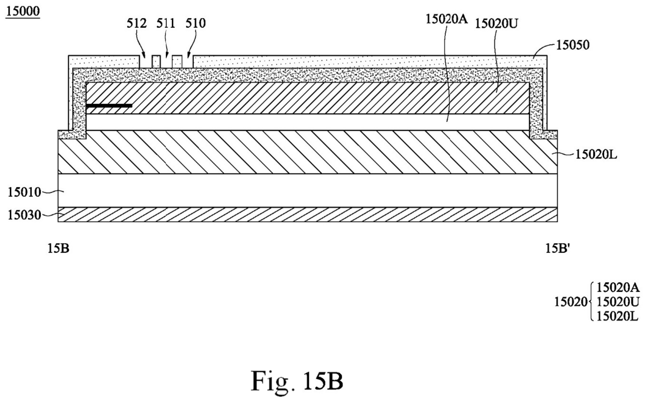

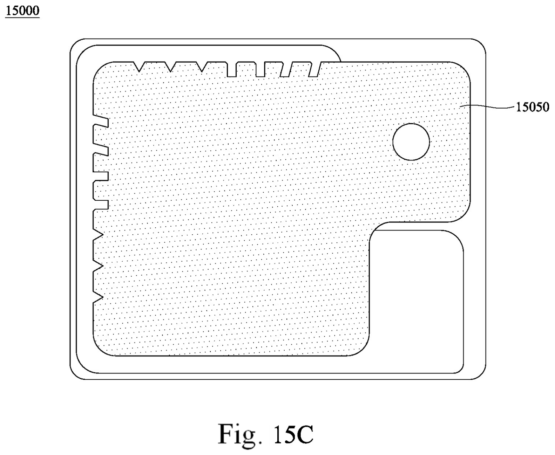

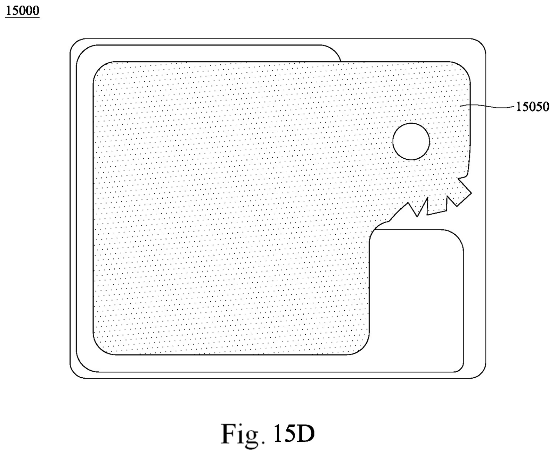

Referring to Table 1A, Table 1B and Fig. 15A and Fig. 15B, in this embodiment, as shown in Fig. 15A and Fig. 15B, patterns 512, 511, 510 are arranged in sequence from right to left along the horizontal direction, and the shape of pattern 510 is a square pattern code, the shape of pattern 511 is a parallelogram pattern code, and the shape of pattern 512 is a triangle pattern code. Therefore, in this embodiment, as shown in Fig. 15, the group of patterns 512, 511, 510 are arranged and represented by the pattern code of group A as "▲ 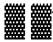 ", and according to Table 1A and Table 1B, the set of patterns 512, 511, 510 can be the decimal number "22".

FIGS. 15A and 15B are different schematic diagrams of a VCSEL chip according to one or more embodiments. Fig. 15B is a cross-sectional schematic diagram showing a cross section along the line 15B-15B' of Fig. 15A. Fig. 15C and 15D are top views of a VCSEL chip according to one or more embodiments.

**In** one or more embodiments, as shown in Fig. 15A and Fig. 15C to Fig. 15D, the electrode has one or more groups of patterns on the epitaxial structure 15020. For example, in one embodiment, as shown in Fig. 15A, the electrode 15050 has two groups of patterns on the epitaxial structure 15020, which are a first group of patterns 510, 511, 512 and a second group of patterns 520, 521, 522. **In** this embodiment, as shown in Fig. 15A, the patterns 520, 521, 522 are arranged along a direction different from the patterns 510, 511, 512 (in this embodiment, a vertical direction).

**In** one or more embodiments, as shown in Fig. 15A and Fig. 15B, the pattern of the electrode 15050 may be an opening structure of the electrode 15050. For example, as shown in Fig. 15B, patterns 520, 521, and 522 are opening structures at different positions of the electrode 15050. These opening structures 520, 521, and 522 with different shapes may be made during the manufacturing process of the VCSEL chip 15000 (i.e., made in an epitaxial wafer state before the singulation process).

**In** one or more embodiments, as shown in Fig. 15C, the electrode 15050 has two sets of patterns, and each set includes more than one pattern (eg, seven patterns).

**In** one or more embodiments, as shown in Fig. 15D, the electrode 15050 has at least one set of patterns, and each set of patterns may be located in a corner region of the electrode 15050.

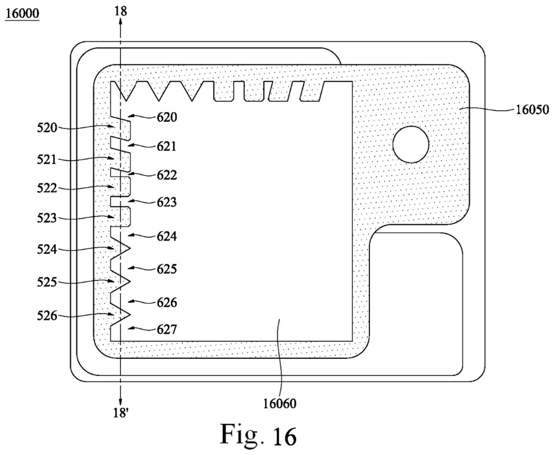

Fig. 16 is a top view of a VCSEL chip according to an embodiment. **In** one or more embodiments, as shown in Fig. 16, the stacked structure of the VCSEL chip 16000 further includes an insulating layer 16060 covering the electrode 16050, and the insulating layer 16060 on the electrode 16050 may form at least one opening having a set of pattern structures 620-627, as shown in Fig. 16. Therefore, a set of patterns 520-526 corresponding to the pattern structures 620-627 of the opening of the insulating layer 16060 may be revealed on the electrode 16050.

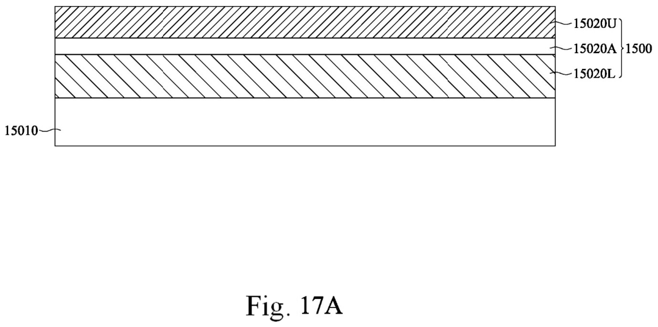

FIGS. 17A to 17F are schematic cross-sectional views illustrating multiple steps of a manufacturing process of the VCSEL chip 15000 shown in Fig. 15B according to one embodiment.

Referring to Fig. 17A, a stacked structure 1500 including a second type semiconductor layer 15020L, an active layer 15020A, and a first type semiconductor layer 15020U is epitaxially grown on a growth substrate 15100. The stacked structure 1500 may be formed on the growth substrate 15100 by an epitaxial process; the epitaxial process may be, but is not limited to, metal-organic chemical vapor deposition (MOCVD), hydride vapor phase epitaxy (HVPE), molecular beam epitaxy (MBE), liquid phase epitaxy (LPE), etc. In this embodiment, as shown in Fig. 17A, the material of the growth substrate 15100 is GaAs. In other embodiments, the material of the growth substrate 15100 may be InP, a sapphire substrate, GaN, SiC, etc.

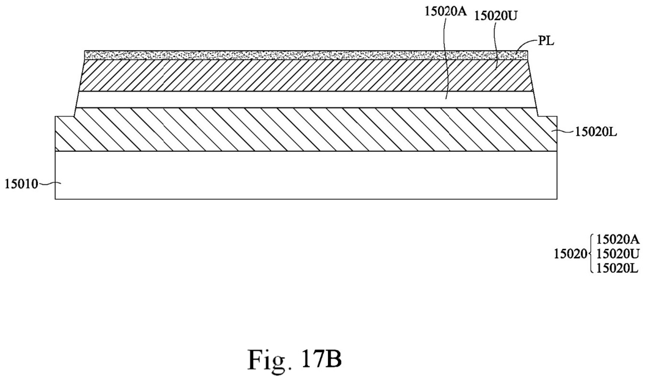

Next, as shown in Fig. 17B, a protection layer PL is formed on the stacked structure 1500, and then an etching process is performed to remove a portion of the first type semiconductor layer 15020U and a portion of the active structure 15020A to expose a portion of the surface of the second type semiconductor layer 15020L and form an epitaxial structure 15020. In this embodiment, the protection layer PL is electrically insulating.

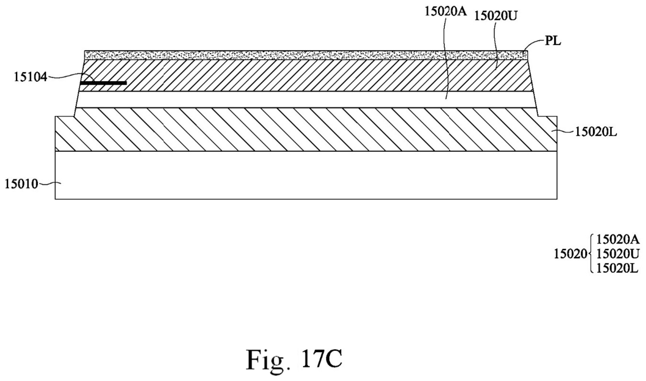

Next, as shown in Fig. 17C, a current confinement layer 15104 is formed in the epitaxial structure 15020. In this embodiment, the current restriction region of the current confinement layer 15104 is formed by an oxidation process. For example, the first type semiconductor layer 15020U includes a plurality of AlGaAs layers, one or more of which have a higher aluminum content than the other layers, and then the current confinement layer 15104 can be formed by an oxidation process on the layer or layers having a higher aluminum content.

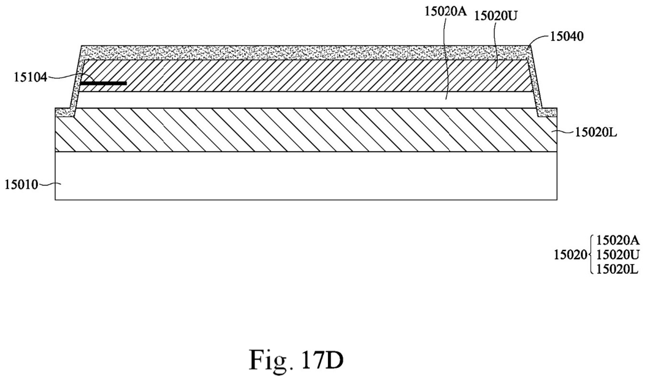

Next, as shown in Fig. 17D, an insulating layer 15040 is provided to cover the epitaxial structure 15020, and the insulating layer 15040 has an opening (not shown) to expose a portion of the upper surface of the epitaxial structure 15020 .

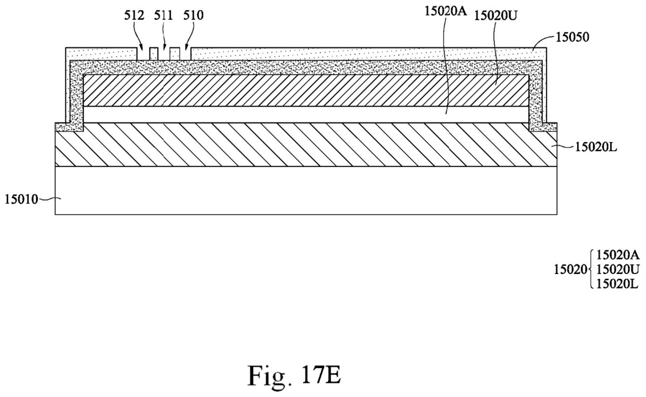

Next, as shown in Figure 17E, a metal layer having pattern structures 520, 521, and 522 is formed on the insulating layer 15040 (for example, using etching and mask processing) and fills the openings of the insulating layer 15040 to electrically connect the first type semiconductor layer 15020U, thereby forming an electrode 15050 having a set of pattern structures 520, 521, and 522.

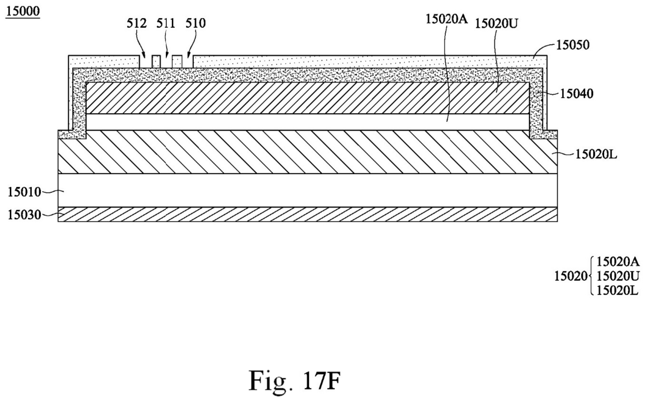

Next, as shown in Fig. 17F, the growth substrate 15100 is thinned and then a metal layer is formed on the thinned growth substrate 15100 to form an electrode 15030, thereby forming a VCSEL chip as shown in FIGS. 15A and 15B .

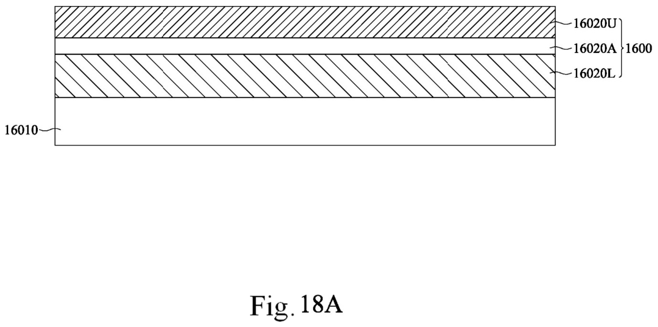

FIGS. 18A to 18G are schematic cross-sectional views showing multiple steps of a manufacturing process of a VCSEL chip along line 18 - 18' in Fig. 16 according to an embodiment.

Referring to Fig. 18A, a stacked structure 1600 including a second type semiconductor layer 16020L, an active layer 16020A, and a first type semiconductor layer 16020U is epitaxially grown on a growth substrate 16100. The stacked structure 1600 may be formed on the growth substrate 16100 by an epitaxial process; the epitaxial process may be, but is not limited to, metal organic chemical vapor deposition, hydride vapor phase epitaxy, molecular beam epitaxy, liquid phase epitaxy, etc. In this embodiment, as shown in Fig. 18A, the material of the growth substrate 16100 is GaAs. In other embodiments, the material of the growth substrate 16100 may be InP, a sapphire substrate, GaN, SiC, etc.

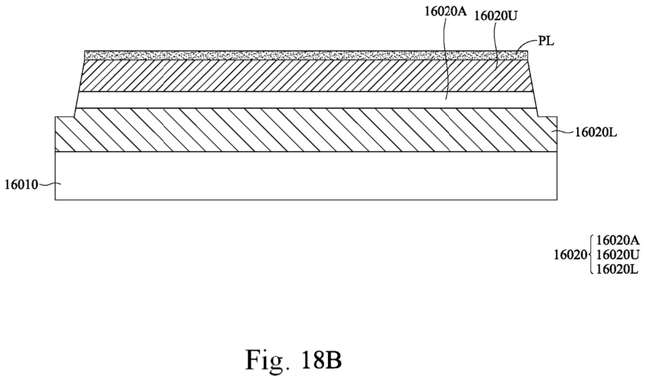

Next, as shown in Fig. 18B, a protection layer PL is formed on the stacked structure 1600, and then an etching process is performed to remove a portion of the first type semiconductor layer 16020U and a portion of the active structure 16020A to expose a portion of the surface of the second type semiconductor layer 16020L and form an epitaxial structure 16020.

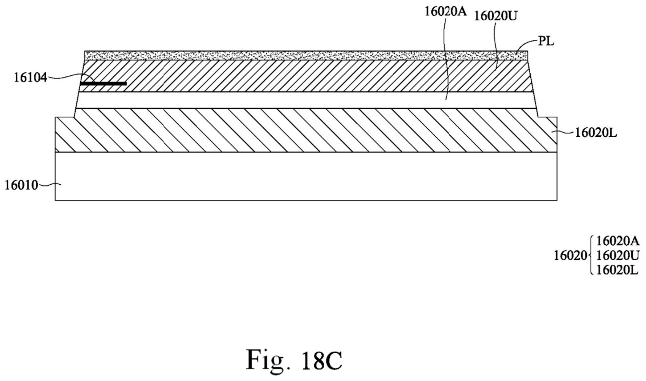

Next, as shown in Fig. 18C, a current confinement layer 16104 is formed in the epitaxial structure 16020. **In** this embodiment, the current restriction region of the current confinement layer 16104 is formed by an oxidation process. For example, the first type semiconductor layer 16020U includes a plurality of AlGaAs layers, one or more of which have a higher aluminum content than the other layers, and then the current confinement layer 16104 can be formed on the layer or layers having a higher aluminum content by an oxidation process.

For example, the aluminum content of at least one layer of the first type semiconductor layer 16020U is greater than 97% (defined as the layer predetermined to form the current confinement layer 16104) and greater than the aluminum content of the active layer 16020A and the second type semiconductor layer 16020L. Therefore, when the oxidation process is performed, the high aluminum content layer region (defined as the layer predetermined to form the current confinement layer 16104) in the epitaxial structure 16020 is oxidized from the side to the inside at a higher rate than other regions, thereby forming a current restriction region with low conductivity in the current confinement layer 16104. Alternatively, a current restriction region with low conductivity can be formed in the epitaxial structure 16020 by an ion implantation process, and the above-mentioned current conduction region can be defined by a mask at the same time. Ion implantation can be achieved by implanting hydrogen ions (H+), helium ions (He+), or argon ions (Ar+), etc. in the region predetermined to form the current restriction region. The ion concentration of the current restriction region is much greater than that of the current conduction region, so that the current restriction region has a lower conductivity.

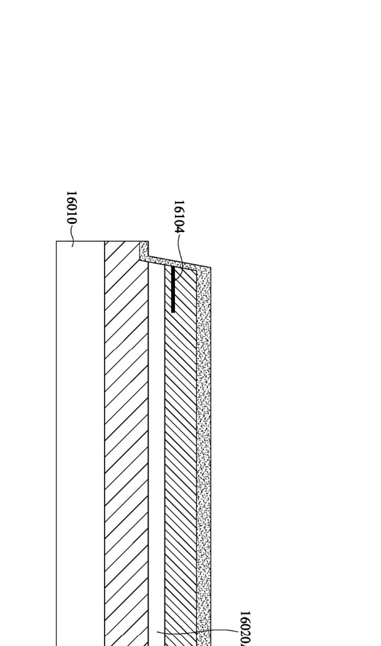

Next, as shown in Fig. 18D, an insulating layer 16040 is provided to cover the epitaxial structure 16020, and the insulating layer 16040 has an opening (not shown) to expose a portion of the upper surface of the epitaxial structure 16020.

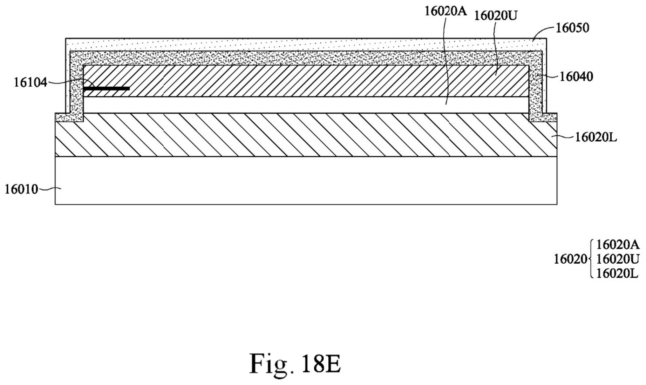

Next, as shown in Fig. 18E, a metal layer is formed on the insulating layer 16040 and fills the openings to electrically connect the first type semiconductor layer 16020U, thereby forming an electrode 16050.

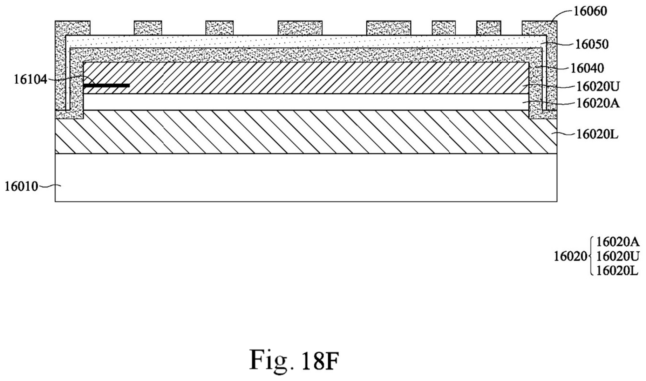

Next, as shown in Fig. 18F, an insulating layer 16060 having an opening (the opening has a group of pattern structures 620-627) is provided to cover the electrode 16050. As shown in Fig. 18F and Fig. 16, the opening with the pattern structure 620-627 is formed on the electrode 16050. Therefore, a group of patterns 520-526 can be exposed on the electrode 16050, corresponding to the pattern structure 620-627 of the opening of the insulating layer 16060.

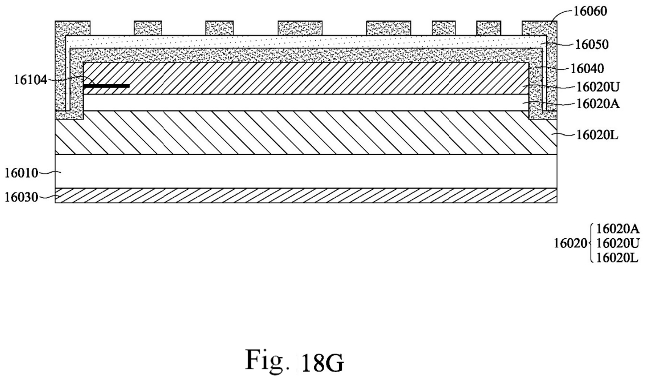

Next, as shown in Fig. 18G, the growth substrate 16100 is thinned and a metal layer is formed on the thinned growth substrate 16100 to form an electrode 16030, thereby forming a VCSEL chip, as shown in Fig. 16.

**In** one or more embodiments, the pattern code may be formed on a side surface E14 of the epitaxial structure 14020 (as shown in Fig. 14B), but the present application is not limited to this embodiment.

Therefore, according to some embodiments, after a semiconductor laser package with a pattern structure leaves the factory, if defects occur later, the position of the semiconductor laser package in the epitaxial wafer state, the production date, or the production batch number can be understood through the specific arrangement and combination of the pattern structure on the semiconductor laser chip, thereby achieving a traceability effect.

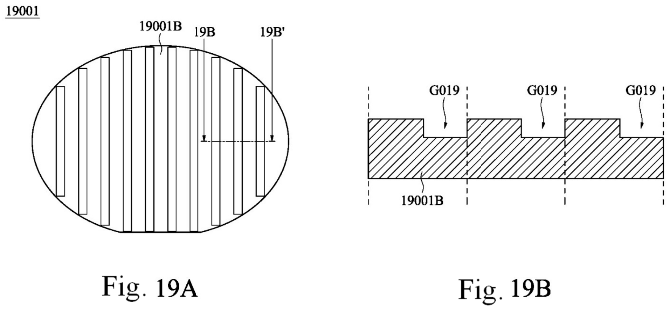

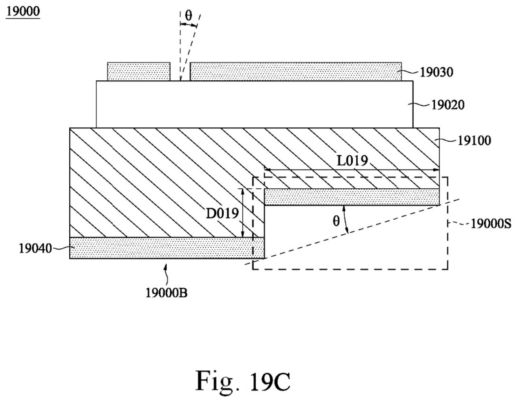

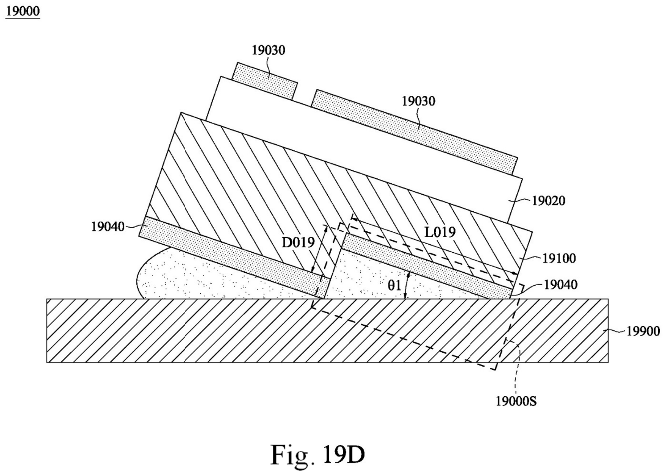

Fig. 19A is a schematic diagram showing the bottom/back side of an epitaxial wafer 19001 (e.g., a VCSEL wafer) of an optoelectronic device according to an embodiment. Fig. 19B is a schematic diagram showing a cross-sectional view along the line 19B-19B' of Fig. 19A. Fig. 19C is a schematic diagram showing a cross-sectional view of a semiconductor laser chip 19000 (e.g., a VCSEL chip) cut from the epitaxial wafer 19001 of the optoelectronic device shown in Fig. 19A according to an embodiment. Fig. 19D is a schematic diagram showing a cross-sectional view of the semiconductor laser chip 19000 (e.g., a VCSEL chip) of Fig. 19C being soldered to a carrier 19900.

Referring to FIGS. 19A and 19B, a plurality of strip grooves G019 are formed on the back side of an epitaxial wafer 19001 (e.g., a VCSEL wafer) of an optoelectronic device by etching. **In** some embodiments, after etching a portion of the base layer 19100 of the epitaxial wafer 19001 on the back side 19001B (i.e., the base layer 19100 side of the epitaxial wafer 19001) of the optoelectronic device, a semiconductor laser chip 19000 (e.g., a VCSEL chip) having a plurality of base layers 19100 with a stepped structure 19000S can be obtained by using the aforementioned single-piece process method of the epitaxial wafer 19001.

Referring to FIGS. 19B and 19C, due to the etched strip grooves G019 on the back side 19001B of the epitaxial wafer 19001 of the optoelectronic device (for example, a VCSEL wafer), the bottom of the VCSEL chip generated after the singulation process retains a step structure 19000S having an etched pattern. Specifically, in one embodiment, the semiconductor laser chip 19000 includes a base layer 19100 and a semiconductor stack layer 19020 formed on the base layer 19100. The base layer 19100 has a stepped structure 19000S on one side relative to the semiconductor stack layer 19020. Then, the semiconductor laser chip 19000 (for example, a VCSEL chip) is further formed with an upper electrode 19030 and a lower electrode 19040. The upper electrode 19030 is formed on the semiconductor stack layer 19020 of the semiconductor laser chip 19000, and the lower electrode 19040 is formed on the bottom surface 19000B of the semiconductor laser chip 19000. The upper electrode 19030 is electrically connected to the first type semiconductor layer of the semiconductor stack layer 19020, and the lower electrode 19040 is electrically connected to the second type semiconductor layer of the semiconductor stack layer 19020 through the base layer 19100.

Refer to the embodiments shown in Fig. 19C and Fig. 19D. **In** the embodiment shown in Fig. 19D, due to the step structure with an etching pattern at the bottom of the semiconductor laser chip 19000 (for example, a VCSEL chip), the semiconductor laser chip 19000 (for example, a VCSEL chip) can be soldered obliquely on the carrier 19900, so that the light emission direction can be changed. That is, when the semiconductor laser chip 19000 is mounted on the carrier 19900 (for example, a circuit board) by solder, the light emission direction of the laser light emitted from the semiconductor laser chip 19000 is not parallel to the normal direction of the carrier 19900 (the angle between the light emission direction of the laser light and the normal direction of the carrier 19900 is θ, i.e., the angle is tilted at the aforementioned θ angle). In other words, in addition to using an optical element in the light emitting sensor package to change the light emission direction according to the aforementioned embodiment, the step structure formed at the bottom of the semiconductor laser chip 19000 can also be used to change the light emission direction.

Continuing to refer to the embodiments shown in Fig. 19B and Fig. 19C, the etching pattern of the semiconductor laser chip 19000 (for example, a VCSEL chip) substantially retains the same or similar width L019 and depth D019 of the groove as those of the epitaxial wafer 19001 type. Therefore, the angle of change in the light emitting direction of the semiconductor laser package can be pre-set in advance by forming the width L019 and depth D019 of the etching pattern of the groove on the bottom surface of the base layer 19100 when the epitaxial wafer of the optoelectronic device is subjected to the etching process.

**In** some embodiments, the depth D019 is between 10 micrometers and 300 micrometers, depending on the size of the semiconductor laser and the desired change in the light emitting direction of the semiconductor laser.

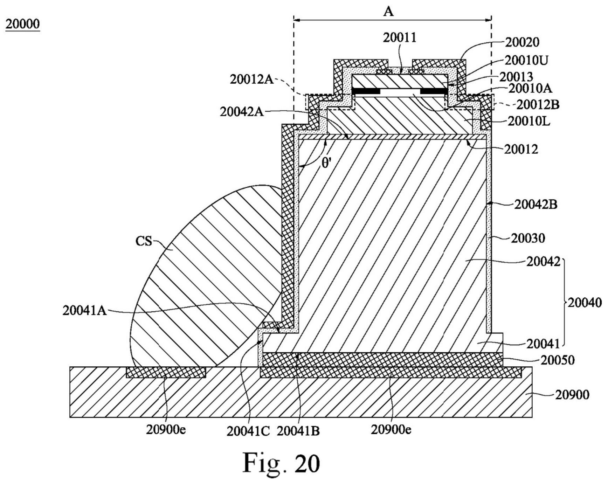

Fig. 20 is a cross-sectional view showing that the VCSEL chip 20000 is mounted on the carrier 20900 and soldered to the electrode pad 20900e of the carrier 20900. Referring to Fig. 20, the upper electrode layer (first electrode structure 20020) of the VCSEL chip 20000 extends to the sidewall of the VCSEL chip 20000 and/or the sidewall of the base layer 20040, thereby expanding the electrode area of the VCSEL chip 20000, so that it can be stably soldered to the carrier 20900. In addition, the plane size A of the VCSEL chip 20000 can be reduced, thereby additionally increasing the utilization rate of the VCSEL wafer.

Fig. 20 shows a cross-sectional schematic diagram of a VCSEL chip 20000 mounted on a carrier board 20900 and soldered to the electrode pad 20900e of the carrier board 20900.

Please refer to Fig. 20. **In** this embodiment, the upper electrode layer (first electrode structure 20020) of the VCSEL chip 20000 extends to the sidewall of the VCSEL chip 20000 and/or the sidewall of the base layer 20040, thereby expanding the electrode area of the VCSEL chip 20000, so that it can be stably soldered to the carrier 20900. **In** addition, the plane size A of the VCSEL chip 20000 can be reduced, thereby additionally increasing the utilization rate of the VCSEL wafer. In one or more embodiments, the carrier 20900 can be a circuit board, a ceramic substrate, etc.

**In** one or more embodiments, the VSCEL chip 20000 may include a single VCSEL structure, a plurality of VCSEL structures arranged in an array, or a plurality of the aforementioned self-mixing interference sensing units arranged in an array.

**In** this embodiment, the VSCEL chip 20000 includes: a base layer 20040, a semiconductor stack layer 20010, a first electrode structure 20020, a second electrode structure 20050 and an insulating layer 20030.

The semiconductor stacking layer 20010 is located on the base layer 20040, and the semiconductor stacking layer 20010 has a first surface 20011, a second surface 20012 and a side surface 20013. The second surface 20012 is opposite to the first surface 20011, and the side surface 20013 is located between the first surface 20011 and the second surface 20012. The semiconductor stacking layer 20010 includes a first type semiconductor layer 20010U, a second type semiconductor layer 20010L and an active layer 20010A. The active layer 20010A is located between the first type semiconductor layer 20010U and the second type semiconductor layer 20010L.

The base layer 20040 is located on one side of the second type semiconductor layer 20010L relative to the first type semiconductor layer 20010U. The base layer 20040 can be a growth substrate for the semiconductor stacking layer 20010, that is, the semiconductor stacking layer 20010 is directly grown on the base layer 20040. The base layer 20040 is conductive, and has a bottom 20041 and a plateau portion 20042 extending from the bottom 20041. The plateau portion 20042 has a plateau surface 20042A (connected to the second surface 20012) and a plateau side surface 20042B. The plateau side surface 20042B is connected to the plateau surface 20042A. The bottom 20041 has a bottom first surface 20041A, a bottom second surface 20041B, and a bottom side surface 20041C. The bottom first surface 20041A is connected to the plateau side surface 20042B, the bottom second surface 20041B is opposite to the bottom first surface 20041A, and the bottom side surface 20041C is located between the bottom first surface 20041A and the bottom second surface 20041B.

The insulating layer 20030 is located on the first surface 20011 and extends through the side surface 20013, the platform surface 20042A, and the plateau side surface 20042B to the bottom first surface 20041A. The insulating layer 20030 has an opening 20031, and the opening 20031 is located on the first surface 20011. The first electrode structure 20020 is located in the opening 20031 and contacts the first type semiconductor layer 20010U. The first electrode structure 20020 is further located on the first surface 20011 and extends through the side surface 20013, the platform surface 20042A, and the plateau side surface 20042B to the bottom first surface 20041A. The insulating layer 20030 further extends through the bottom first surface 20041A to the bottom side surface 20041C.

The second type semiconductor layer 20010L in the semiconductor stack layer 20010 further includes plateau portions 20012A and 20012B extending laterally and distributed on the platform surface 20042A, and the insulating layer 20030 and the first electrode structure 20020 are further located on the surfaces of the plateau portions 20012A and 20012B. The second electrode structure 20050 is located on the bottom second surface 20041B.

Therefore, when the VSCEL chip 20000 is subsequently electrically bonded to the electrode pad 20900e on the carrier 20900, since the first electrode structure 20020 extends to the plateau side surface 20042B of the plateau, the bonding area between the electrode structure 20020 on one side of the VSCEL chip 20000 and the bonding structure CS (for example, solder paste) bonded to the carrier 20900 can be increased without increasing the size of the VSCEL chip 20000. **In** this way, when the VSCEL chip 2000 is packaged, the chip size can be reduced while maintaining the spacing between the electrode pads 20900e of the carrier 20900.

In some embodiments, the height of the plateau 20042 is 70 to 90 microns.

In some embodiments, the plateau side surface 20042B of the plateau portion 20042 has an angle θ' relative to the platform surface 20042A, and the angle θ' has an angular distribution range of 90 degrees to 120 degrees.

In one or more embodiments, the optoelectronic module includes a light emitting device, a light receiving device, and a driver chip electrically connected to the light emitting device and/or the light receiving device.

In one or more embodiments, the light emitting device includes at least one semiconductor light source, such as a semiconductor laser, such as a VCSEL structure.

In one or more embodiments, the light receiving device includes at least one semiconductor sensor, such as a single-photon avalanche diode (SPAD).

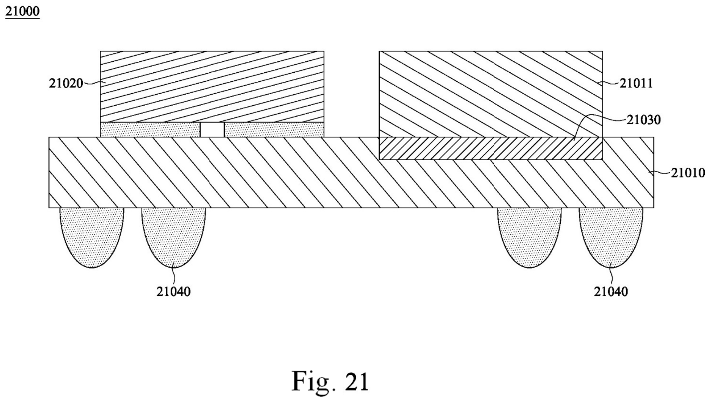

Fig. 21 is a cross-sectional view of an optoelectronic module 21000 that can be applied as a time-of-flight ranging module according to an embodiment. The optoelectronic module 21000 includes a light emitting device 21020 mounted on a driver chip 21010, and the driver chip 21010 has one or more SPADs 21030.

Referring to this embodiment, as shown in Fig. 21, the optoelectronic module 21000 further includes a lens group 21011, which is installed on the area of the SPAD 21030. In this embodiment, as shown in Fig. 21, when the optoelectronic module 21000 is applied as a time-of-flight ranging module, the driver chip 21010 provides an electrical signal, voltage or current to drive the light emitting device 21020 to emit light to an object and drive the SPAD 21030 to receive the light reflected from the object. In addition, the light emitted by the light emitting device 21020 can be a patterned light source with the pattern as a spot, a line, flood pattern, or a mixture of two or more of the above-mentioned patterns illuminating within a Field of Illumination (FOI).

Still referring to the embodiment, as shown in Fig. 21, a ball grid array (BGA) structure 21040 can be located on the back side 21010B of the driver chip 21010 (on the side opposite to the light emitting device 21020 and the SPAD 21030) for electrical connection with a circuit board, such as a printed circuit board (PCB).

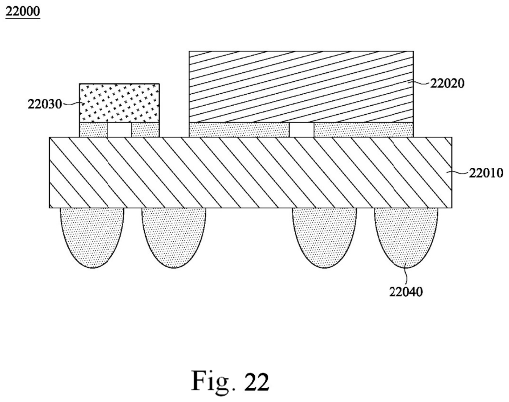

Fig. 22 is a cross-sectional schematic diagram of a transmitter module 22000 according to an embodiment, wherein the transmitter module 22000 integrates a flip-chip light emitting device 22020, a passive component 22030, and a driver chip 22010. The light emitting device 22020 can be directly mounted on the driver chip 22010, or the light emitting device 22020 can be mounted on a carrier and the carrier is mounted on the driver chip 22010. The driver chip 22010 provides an electrical signal, voltage or current to drive the light emitting device 22020 as a light source and electrically connects with the printed circuit board through the BGA structure 22040. The light source can be a patterned light source with the pattern as a spot, a line, flood pattern, or a mixture of two or more of the above-mentioned patterns with a FOI. One or more passive components 22030 are used together with the driver chip 22010 to adjust the electrical signal.

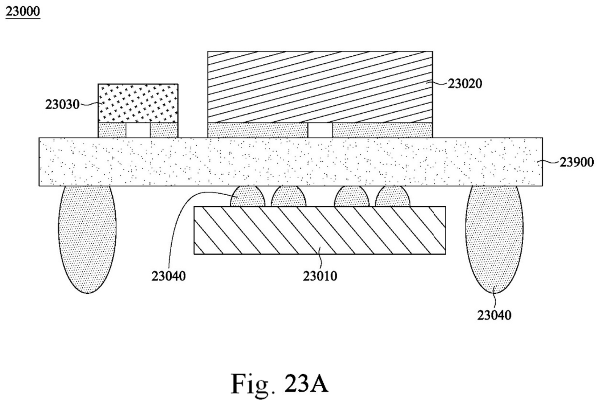

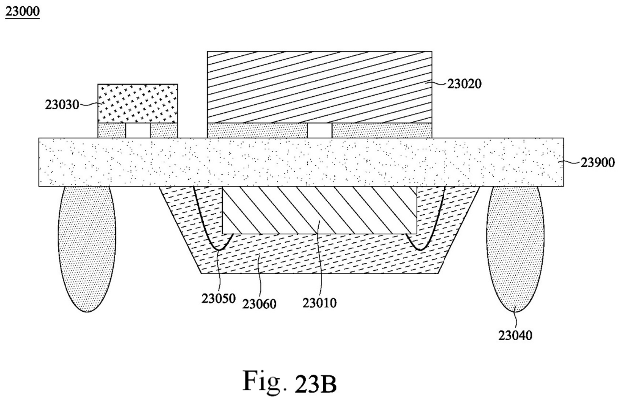

Fig. 23A is a schematic cross-sectional view of a transmitter module according to an embodiment. Fig. 23B is a schematic cross-sectional view of a transmitter module according to an embodiment. **In** one or more embodiments, as shown in Fig. 23A and Fig. 23B, a transmitter module 23000 is provided, and the transmitter module 23000 integrates a light emitting device 23020, a passive component 23030, a driver chip 23010, and a carrier 23900. The light emitting device 23020, the passive component 23030, and the driver chip 23010 are mounted on the carrier 23900. The light emitting device 23020, the passive component 23030, and the driver chip 23010 can be mounted on the same side or different sides of the carrier 23900. The carrier 23900 provides electrical distribution by multiple via holes and multiple metal layers between components (including the diver chip 23010, the light emitting device 23020 and the passive component 23030) and is electrically connected to the printed circuit board through the BGA structure 23040. The driver chip 23900 provides an electrical signal, voltage or current to drive the light emitting device 23020 as a light source. The light source can be a patterned light source with the pattern as a spot, a line, flood pattern, or a mixture of two or more of the above-mentioned patterns with a FOI. In this embodiment, as shown in Fig. 23A, the driver chip 23010 is electrically connected to the carrier 23900 through the BGA structure 23040. In one or more embodiments, the driver chip 23010 is electrically connected to the carrier 23900 by wire bonding, as shown in Fig. 23B, and a molding material 23060 is required to cover the driver chip 23010 and the metal wire 23050 to protect the metal wire 23050.

In some embodiments, a bottom filler glue may be included between the driver chip 23010 and the carrier board 23900. The bottom filler glue covers BGA structure 23040.

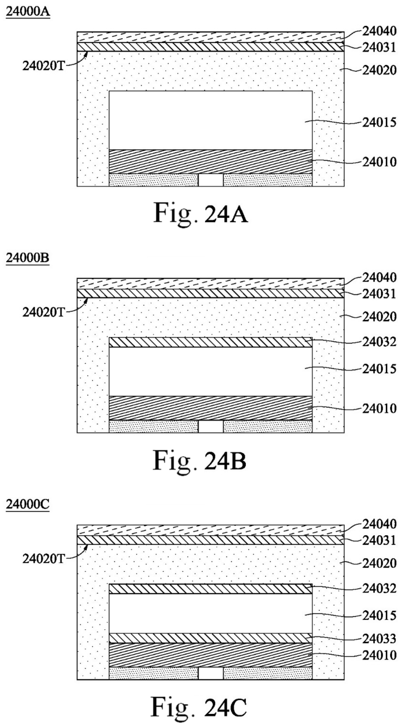

In one or more embodiments, the light emitting device includes a semiconductor layer, a spacer layer, a patterned layer and a cover layer, as shown in Fig. 24A to Fig. 24C. Fig. 24A is a cross-sectional schematic diagram of a light emitting device according to an embodiment. Fig. 24B is a cross-sectional schematic diagram of a light emitting device according to an embodiment. Fig. 24C is a cross-sectional schematic diagram of a light emitting device according to an embodiment. The spacer layer surrounds the VCSEL chip and is similar to a chip scale package (CSP). The patterned layer includes one or more kinds of optics such as meta surfaces, photonic crystals, micro lens arrays or diffractive optical elements (DOEs), etc. In one embodiment, as shown in Fig. 24A, the light emitting device 24000A includes a semiconductor layer 24010, a transparent substrate 24015, a spacer layer 24020, a first patterned layer 24031 and a cover layer 24040. The first patterned layer 24031 is formed on the upper surface 24020T of the spacer layer 24020, and then the cover layer 24040 is formed on the first patterned layer 24031. The cover layer 24040 is used to prevent scratches, moisture or solvents from damaging the first patterned layer 24031. In one or more embodiments, the light emitting device integrates a meta-surface optical element to shorten the optical focal length, thereby reducing the height of the entire package.

In one or more embodiments, the patterned layer may be a single layer or multiple layers and formed between different interfaces, as shown in FIGS. 24A to 24C. In one embodiment, as shown in Fig. 24B, the light emitting device 24000B includes a semiconductor layer 24010, a transparent substrate 24015, a spacer layer 24020, a first patterned layer 24031, a second patterned layer 24032, and a cover layer 24040. In one embodiment, as shown in Fig. 24C, the light emitting device 24000C includes a semiconductor layer 24010, a transparent substrate 24015, a spacer layer 24020, a first patterned layer 24031, a second patterned layer 24032, a third patterned layer 24033, and a cover layer 24040. The first patterned layer 24031 is formed on the spacer layer 24020. The second patterned layer 24032 is formed between the transparent substrate 24015 and the spacer layer 24020. The third patterned layer 24033 is formed between the transparent substrate 24015 and the semiconductor layer 24010. It should be noted that the transparent substrate 24015 is transparent to the light of the light emitting device 24000, so the object under the transparent substrate 24015 does not need to be clearly seen by the naked eye, and can be UV light, visible light or infrared light, but the present application is not limited thereto.

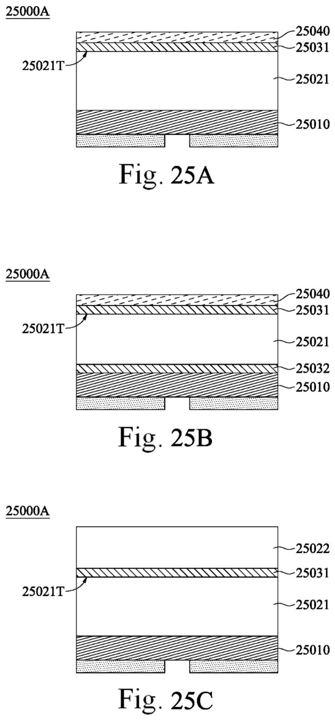

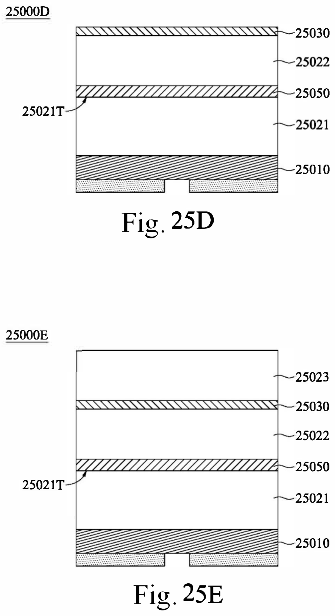

In one or more embodiments, as shown in FIGS. 25A to 25E, the light emitting device may integrate one or more patterned layers and be formed at different interfaces. Fig. 25A is a cross-sectional schematic diagram of a light emitting device according to one embodiment. Fig. 25B is a cross-sectional schematic diagram of a light emitting device according to one embodiment. Fig. 25C is a cross-sectional schematic diagram of a light emitting device according to one embodiment. Fig. 25D is a cross-sectional schematic diagram of a light emitting device according to one embodiment. Fig. 25E is a cross-sectional schematic diagram of a light emitting device according to one embodiment.

In one embodiment, as shown in Fig. 25A, the light emitting device 25000A includes a semiconductor layer 25010, a first transparent substrate 25021, a first patterned layer 25031, and a cover layer 25040. The first transparent substrate 25021 is located on the semiconductor layer 25010, the first patterned layer 25031 is formed on the upper surface 25021T of the first transparent substrate 25021, and the cover layer 25040 is located on the first patterned layer 25031.

In one embodiment, as shown in Fig. 25B, the light emitting device 25000B includes a semiconductor layer 25010, a first transparent substrate 25021, a first patterned layer 25031, a second patterned layer 25032, and a cover layer 25040. The first transparent substrate 25021 is located on the semiconductor layer 25010, the second patterned layer 25032 is formed between the first transparent substrate 25021 and the semiconductor layer 25010, the first patterned layer 25031 is formed on the upper surface 25021T of the first transparent substrate 25021, and the cover layer 25040 is located on the first patterned layer 25031.

In one embodiment, as shown in Fig. 25C, the light emitting device 25000C includes a semiconductor layer 25010, a first transparent substrate 25021, a second transparent substrate 25022, and a first patterned layer 25031. The first transparent substrate 25021 is located on the semiconductor layer 25010, the first patterned layer 25031 is formed between the two transparent substrates (the first transparent substrate 25021 and the second transparent substrate 25022), and the adhesive layer may be further located on one side of the first patterned layer 25031.

In one or more embodiments, as shown in FIGS. 25C to 25E, the light emitting device may include stacked transparent substrates, and the subsequent layer may be interposed between the stacked transparent substrates.

In this embodiment, as shown in Fig. 25C, the light emitting device 25000C includes a semiconductor layer 25010, a first transparent substrate 25021, a first patterned layer 25031, and a second transparent substrate 25022. The light emitting device 25000C has a second transparent substrate 25022 stacked on the first patterned layer 25031. In some embodiments, the first patterned layer 25031 may be formed on the first transparent substrate 25021 or the second transparent substrate 25022. Another adhesive layer may be further located between the first transparent substrate 25021 and the second transparent substrate 25022.

According to one or more embodiments, as shown in Fig. 25D, the light emitting device 25000D includes a semiconductor layer 25010, a first transparent substrate 25021, an adhesive layer 25050, a second transparent substrate 25022, and a patterned layer 25030. The first transparent substrate 25021 is located on the semiconductor layer 25010, the second transparent substrate 25022 is bonded to the first transparent substrate 25021 by the adhesive layer 25050, and the patterned layer 25030 is formed on the second transparent substrate 25022.

In one or more embodiments, as shown in Fig. 25E, the light emitting device 25000E includes a semiconductor layer 25010, a first transparent substrate 25021, an adhesive layer 25050, a second transparent substrate 25022, a patterned layer 25030, and a third transparent substrate 25023. The first transparent substrate 25021 is located on the semiconductor layer 25010. The second transparent substrate 25022 is bonded to the first transparent substrate 25021 using the adhesive layer 25050, and the patterned layer 25030 is formed on the second transparent substrate 25022, and the third transparent substrate 25023 covers the patterned layer 25030 to prevent scratches, moisture or solvents, so that the optical function of the patterned layer 25030 will not be affected by damage.

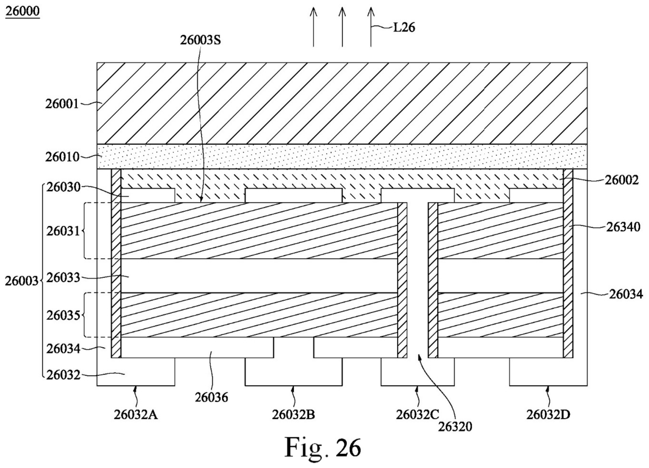

Fig. 26 is a schematic cross-sectional view of a laser element according to an embodiment. In one or more embodiments, the light emitting device may be a laser element, as shown in Fig. 26. Referring to this embodiment, as shown in Fig. 26, the laser element 26000 includes a transparent substrate 26001, an adhesive layer 26002, a laser unit 26003, and a plurality of first channels 26034. The transparent substrate 26001 includes a conductive layer 26010. For example, the transparent substrate 26001 includes sapphire, glass, or silicon carbide (SiC). In some embodiments, the transparent substrate 26001 is an optical element, and may be patterned to produce a specific optical effect; for example, said optical element can make the optical transmitter to produce a patterned light source with a pattern as a spot, flood or multiple light pattern illuminating within a pre-determinate Field of Illumination (FOI). The conductive layer 26010 includes a transparent conductive oxide or a metal. The transparent conductive oxide may be indium tin oxide (ITO) or indium zinc oxide (IZO). In the present embodiment, the conductive layer 26010 is disposed between the transparent substrate 26001 and the adhesive layer 26002.

One side of the adhesive layer 26002 is attached to the conductive layer 26010, and the other side thereof is attached to a light-emitting side 26003S of the laser unit 26003. For example, the adhesive layer 26002 may be benzocyclobutene (BCB), silicon dioxide or a transparent conductive oxide.

The laser unit 26003 includes a front conductive structure 26030, a first type semiconductor stack 26031, an active layer 26033, a second type semiconductor stack 26035, an insulating layer 26036, and a back conductive structure 26032. The back conductive structure 26032 includes conductive electrodes 26032C and 26032D separated from each other. The first type semiconductor and the second type semiconductor herein respectively refer to semiconductors with different electrical properties. If a semiconductor uses holes as a majority carrier, it is a P-type semiconductor, and if the semiconductor uses electrons as a majority carrier, it is an N-type semiconductor. For example, the first type semiconductor stack 26031 is an N-type semiconductor stack, and the second type semiconductor stack 26035 is a P-type semiconductor stack, and vice versa. The active layer 26033 is located between the first type semiconductor layer 26031 and the second type semiconductor layer 26035, and includes a p-n junction to generate a depletion region for electron-hole recombination to emit light. In some embodiments, the active layer 26033 is formed of multiple quantum wells, which has better luminous efficiency than the p-n junction, but it is not limited thereto. In one embodiment, the materials of the first type semiconductor layer 26031, the second type semiconductor layer 26035 and the active layer 26033 include III-V compound semiconductors, such as GaAs, InGaAs, AlGaAs, AlInGaAs, GaP, InGaP, AlInP, AlGaInP, GaN, InGaN, AlGaN, AlInGaN, AlAsSb, InGaAsP, InGaAsN, AlGaAsP, etc. In the embodiments of the present application, unless otherwise specified, the chemical formula includes "compounds that conform to stoichiometry" and "compounds that do not conform to stoichiometry", wherein "compounds that conform to stoichiometry" are, for example, compounds in which the total element content of group III elements is the same as the total element content of group V elements, whereas "compounds that do not conform to stoichiometry" are, for example, compounds in which the total element content of group III elements is different from the total element content of group V elements. For example, the chemical formula of AlGaAs means that it contains group III elements aluminum (Al) and/or gallium (Ga), and group V elements arsenic (As), wherein the total element content of group III elements (aluminum and/or gallium) may be the same as or different from the total element content of group V elements (arsenic). In addition, if the compounds represented by the chemical formulas are stoichiometric compounds, AlGaAs represents Alₓ₁Ga₍₁₋ₓ₁₎As, where 0≦x1≦1; AlInP represents Alₓ₂In₍₁₋ₓ₂₎P, where 0≦x2≦1; AlGaInP represents (Al_{y1}Ga_{(1-y1)})₁₋ₓ₃Inₓ₃P, where 0≦x3≦1, 0≦y1≦1; AlGaN represents Alₓ₄Ga₍₁₋ₓ₄₎N, where 0≦x4≦1; AlAsSb represents AlAsₓ₅Sb₍₁₋ₓ₅₎, where 0≦x5≦1; InGaP represents Inₓ₆Ga₁₋ₓ₆P, where 0≦x6≦1; InGaAsP represents Inₓ₆Ga₁₋ₓ₆As_{1-y2}P_{y2}, where 0≦x6≦1, 0≦y2≦1; InGaAsN represents Inₓ₈Ga₁₋ₓ₈As_{1-y3}N_{y3}, where 0≦x8≦1, 0≦y3≦1; AlGaAsP represents Alₓ₉Ga₁₋ₓ₉As_{1-y4}P_{y4}, where 0≦x9≦1, 0≦y4≦1; InGaAs represents Inₓ₁₀Ga₁₋ₓ₁₀As, where 0≦x10≦1. According to the material of the active layer 26033, when the material of the semiconductor layers 26031 and 26035 is AlGaAs series, the active layer 26033 can emit infrared light with a peak wavelength between 700nm and 1700nm. When the materials of the semiconductor layers 26031 and 26035 are AlGaInP series, the active layer 26033 can emit red light with a peak wavelength between 610nm and 700nm, or yellow light with a peak wavelength between 530nm and 570nm. When the materials of the semiconductor layers 26031 and 26035 are InGaN series, the active layer 26033 can emit blue light or deep blue light with a peak wavelength between 400nm and 490nm, or green light with a peak wavelength between 490nm and 550nm. When the materials of the semiconductor layers 26031 and 26035 are AlGaN series, the active layer 26033 can emit ultraviolet light having a peak wavelength between 250nm and 400nm.

In this embodiment, the first type semiconductor layer 26031 and the second type semiconductor layer 26035 include a DBR structure, so that the light emitted by the active layer 26033 can be reflected back and forth between the two DBR structures to form coherent light, and then the coherent light is emitted from the direction of the first type semiconductor layer 26031 to form laser light L26.

In this embodiment, as shown in Fig. 26, the insulating layer 26036 is located between the back conductive structure 26032 and the second type semiconductor layer 26035. In one embodiment, the material of the protection layer 26036 includes silicon oxide.

In this embodiment, the contact resistance between the back conductive structure 26032 and the second type semiconductor layer 26035 is lower than 10⁻⁴ Ωcm², and an ohmic contact is formed between the back conductive structure 26032 and the second type semiconductor layer 26035. The formation mechanism of the ohmic contact is that the metal work function must be smaller than the semiconductor work function, so that electrons from the semiconductor to the metal and from the metal to the semiconductor can easily jump over this energy level, and the current can be conducted in both directions. For example, the metal component of the second conductive electrode 26032D of the back conductive structure 26032 is mainly titanium aluminum alloy, because titanium can form titanium nitride with the III-V compound (such as aluminum gallium nitride) of the second type semiconductor layer 26035, so that nitrogen atoms on the surface become n-type doped surface, and a good ohmic contact is formed after high temperature annealing, but it is not limited to this.

In this embodiment, as shown in Fig. 26, the first type semiconductor layer 26031 is connected to the front conductive structure 26030, the front conductive structure 26030 is connected to the conductive electrode 26032C via the second channel 26320, the conductive electrode 26032D and the conductive electrode 26032C are separated from each other to avoid short circuit, and the second type semiconductor layer 26035 is connected to the second conductive electrode 260324. In order to prevent the conductive medium filled in the second channel 26320 from contacting with the second type semiconductor layer 26035 of the laser unit 26003 to form a short circuit, the laser unit 26003 further includes an insulating layer 26340 located on the inner wall of the second channel 26320. Through the above conductive structure, the laser unit 26003 receives an external driving voltage/current and generates a laser light L26. The front conductive structure 26030 is located at the light-emitting side 26003S of the laser unit 26003 and is connected to the adhesive layer 26002. Therefore, the laser light L26 emitted by the laser unit 26003 will be output to the outside through the adhesive layer 26002 and the transparent substrate 26001. It should be noted that the transparent substrate 26001 is transparent to the light L26 of the laser unit 26003. Therefore, the object under the transparent substrate 26001 does not need to be clearly seen by the naked eye, and can be UV light, visible light or infrared light, but the present application is not limited thereto.

In one or more embodiments, when the TOF ranging module with the laser element 26000 is applied to a living object (such as a human face or human eye), since the coherent light emitted by the laser element 26000 has a high energy, a corresponding optical element (such as a transparent substrate) is required to process the coherent light and output a laser light L26 of appropriate intensity. In order to effectively monitor whether the laser element 26000 is damaged and to prevent the laser light L26 optically processed by the transparent substrate 26001 from leaking out and directly hitting the human eye, the laser element 26000 of this embodiment has an eye safety monitoring circuit, which can monitor abnormal damage of the light-emitting side 26003S of the laser unit 26003 in real time. The following examples illustrate the working principles of the laser element 26000 of some embodiments.

Still referring to the embodiment, as shown in Fig. 26 in addition to the above semiconductor structure required for emitting the laser light, the laser unit 26003 further includes a back conductive structure 26032. The back conductive structure 26032 includes plural detecting electrodes 26032A, 26032B, and the back conductive structure 26032 and the front conductive structure 26030 are oppositely disposed on two sides of the laser unit 26003. The plurality of first channels 26034 extend from the back conductive structure 26032 and penetrate through the front conductive structure 26030 and the adhesive layer 26002, and is connected to the conductive layer 26010. Namely, in this embodiment, two ends of the first channel 26034 are connected to one of the detecting electrodes 26032A, 26032B and the conductive layer 26010 respectively. In some embodiments, the detecting electrodes 26032A, 26032B separated from each other are electrically connected to the two ends of the conductive layer 26010 through the first channel 26034. Therefore, the detecting electrodes 26032A, 26032B are externally connected to a control circuit, so that a change in a resistance value of the conductive layer 26010 may be monitored in real time. When the laser element is damaged by an external impact, especially when the light-emitting side 26003S is damaged, the conductive layer 26010 is also damaged, so the resistance value becomes large, even causing an open circuit. Thus, the control circuit determines whether to cut off power supply to the laser unit 26003 according to the change in the resistance value of the conductive layer 26010 through the monitoring circuit, so as to prevent the laser light L26 emitted by the laser unit 26003 from being leaked via a rupture of the transparent substrate 26001 and being directly irradiated to the human eye, thereby achieving the effect of monitoring abnormal conditions in real time.

In this embodiment, as shown in Figure 26, in order to prevent the conductive medium filled in the first channel 26034 from contacting the front conductive structure 26030, the first type semiconductor layer 26031 or the second type semiconductor layer 26035 of the laser unit 26003 and forming a short circuit, the laser unit 26003 further includes an insulating layer 26340 located between the inner wall of the laser unit 26003 and the first channel 26034.

In some embodiments, the back conductive structure 26032 includes a plurality of detection electrodes 26032A, 26032B and a plurality of conductive electrodes 26032C, 26032D that are separated from each other and coplanar, as shown in Fig. 6 . Thus, the laser element is suitable for flip chip connection to a carrier, such as the driver chip shown in Fig. 26, without the need for a wire bonding process, thereby saving packaging volume. In one or more embodiments, the back conductive structure 26032 includes a plurality of detection electrodes 26032A, 26032B, and the plurality of detection electrodes 26032A, 26032B extend from the back conductive structure 26032 and penetrate the front conductive structure 26030 and the adhesive layer 26002, and connect the conductive layer 26010.

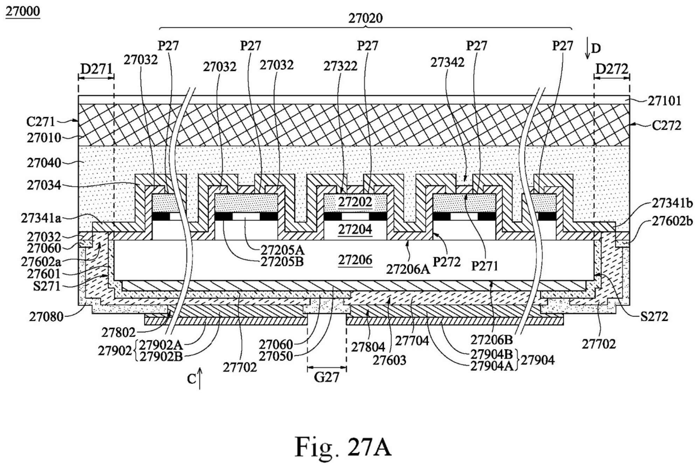

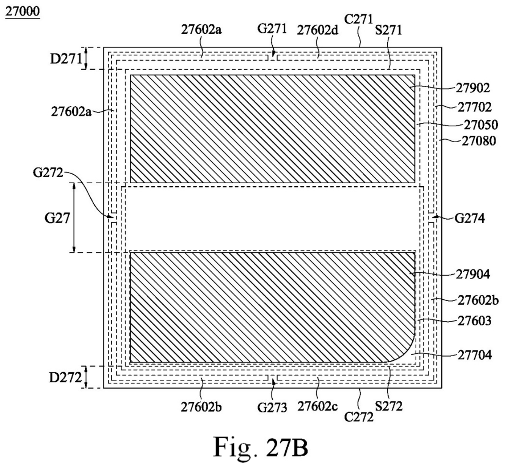

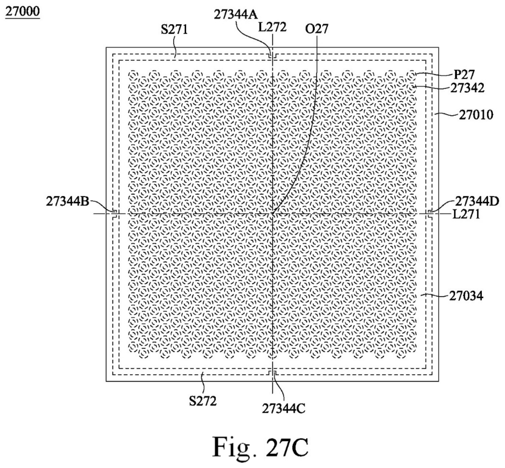

In one or more embodiments, the light emitting device may be a laser element, as shown in FIGS. 27A to 27C. Fig. 27B is a bottom view of the laser element 27000 shown in Fig. 27A (seen from the direction of arrow C in Fig. 27A, i.e., from the direction of the first pad structure 27902 and the second pad structure 27904), and Fig. 27A is a cross-sectional schematic diagram showing a cross section along the line segment AA' in Fig. 27B. Fig. 27C is a top view of the laser element 27000 shown in Fig. 27A, i.e., a view of the laser element 27000 observed from the direction of the transparent substrate 27010 (the direction shown by arrow D in Fig. 27A), and Fig. 27A is a cross-sectional schematic diagram showing a cross section along the line segment B-B' in Fig. 27C.

Fig. 27A is a cross-sectional schematic diagram of a semiconductor light emitting device according to an embodiment. In this embodiment, the semiconductor light emitting device is a laser device 27000 and includes a transparent substrate 27010 and an epitaxial structure 27020 located on one side of the transparent substrate 27010, wherein the epitaxial structure 27020 includes at least one columnar structure P27. In this embodiment, the epitaxial structure 27020 includes a plurality of columnar structures P27. Each columnar structure P27 includes a first semiconductor structure 27202, a current confinement layer 27205, and an active structure 27204 located sequentially on the transparent substrate 27010.

The plurality of columnar structures P27 may be arranged regularly (regular arrangement) or irregularly (random arrangement) on the second semiconductor structure 27206. The so-called regular arrangement means that the plurality of columnar structures P27 have a specific spatial relationship and are arranged in a fixed and repetitive manner. For example, in some regularly arranged columnar structures P27, the spacing between adjacent columnar structures P27 is roughly the same. In other regularly arranged columnar structures P27, the plurality of columnar structures P27 are arranged along a specific direction. Each columnar structure P27 includes an upper surface P271 facing the transparent substrate 27010 and a side surface P272 connecting the upper surface P271 and the second semiconductor structure 27206. In addition, the epitaxial structure 27020 also includes a lower surface 27206B away from the transparent substrate 27010, and the lower surface 27206B is the surface of the second semiconductor structure 27206. In this embodiment, the conductivity type of the first semiconductor structure 27202 is P-type, and the conductivity type of the second semiconductor structure 27206 is N-type. For simplicity of illustration, Fig. 27A only uses five columnar structures P27 as an example. However, in actual VCSEL products, the number of columnar structures P27 can be adjusted according to the current and power requirements of the application, for example, 100 to 1000, but is not limited thereto.

In this embodiment, as shown in Fig. 27A to Fig. 27C, the current confinement layer 27205 may be selectively located between the active structure 27204 and the first semiconductor structure 27202, or between the active structure 27204 and the second semiconductor structure 27206. The current confinement layer 27205 includes a current restriction region 27205B and a current conducting region 27205A surrounded by the current restriction region 27205B. The electrical conductivity is higher than that of the current restriction region 27205B, so that the current is concentrated in the current conduction region 27205A.

In this embodiment, as shown in FIGS. 27A to 27C, the first semiconductor structure 27202 and the active structure 27204 partially cover the second semiconductor structure 27206, and expose one end surface 27206A of the second semiconductor structure 27206. The laser element 27000 further includes a first insulating layer 27032 and a first metal connection layer 27034. The first insulating layer 27032 covers the side surface P272 of the columnar structure P27, the end surface 27206A of the second semiconductor structure 27206, and a portion of the upper surface P271 of the columnar structure P27. The first insulating layer 27032 has a plurality of first openings 27322, exposing a portion of the upper surface P271 from the first insulating layer 27032. The first metal connection layer 27034 is located on the first insulating layer 27032, and is electrically connected to the first semiconductor structure 27202 through the first openings 27322. The first metal connection layer 27034 has a plurality of second openings 27342, so that the light emitted by the active structure 27204 can be emitted from the second openings 27342 to the direction of the transparent substrate 27010 and out of the laser element 27100. In addition, the second semiconductor structure 27206 has a first side S271 and a second side S272 relative to the first side S11. The first metal connection layer 27034 has a first protrusion 27341a extending beyond the first side S271 and a second protrusion 27341b extending beyond the second side S272. The first protrusion 27341a and the second protrusion 27341b can be used for subsequent electrical connection, and the detailed structure and electrical connection method will be described in detail below.

In this embodiment, as shown in Fig. 27A to Fig. 27C, the laser device 27000 further includes an adhesive layer 27040, and the epitaxial structure 27020 is connected to the transparent substrate 27010 via the adhesive layer 27040. A second metal connection layer 27050 is provided on the second semiconductor structure 270206 away from the transparent substrate 27010, and the second metal connection layer 27050 is electrically connected to the second semiconductor structure 27206. The laser device 27000 of the present application includes a second insulating layer 27060, and the second insulating layer 27060 covers the second metal connection layer 27050. The second insulating layer 27060 has two side portions 27060A. Four opening portions (a first opening portion 27602a, a second opening portion 27602b, a third opening portion 27602c, and a fourth opening portion 27602d) further pass through the second insulating layer 27060. The side portion 27060A covers the first side S271 and the second side S272 of the second semiconductor structure 27206. The first opening 27602a further penetrates the first insulating layer 27032 to expose the first protrusion 27341a of the first metal connection layer 27034, and the second opening 27602b further penetrates the first insulating layer 27032 to expose the second protrusion 27341b of the first metal connection layer 27034. The second insulating layer 27060 also has a fifth opening 27603 to expose the second metal connection layer 27050. The laser element 27000 of the present application includes a first electrode 27702 and a second electrode 27704, which are located on the same side of the transparent substrate 27010 and are physically separated from each other.

In this embodiment, as shown in Fig. 27A to Fig. 27C, the laser element 27000 is a flip-chip laser element. The laser element 27000 can be bonded to an external carrier (e.g., a printed circuit board or a driver chip 21010 as shown in Fig. 21) by a flip chip bonding process using solder. The first electrode 27702 is connected to the first metal connection layer 27034 through the first opening 27602a to the fourth opening 27602d, respectively, and is electrically connected to the first semiconductor structure 27202 through the first protrusion 27341a and the second protrusion 27341b of the first metal connection layer 27034. **In** addition, the first electrode 27702 covers the side portion 27060A of the second insulating layer 27060 and extends to cover the second metal connection structure 27050. The second insulating layer 27060 is located between the first electrode 27702 and the second metal connection structure 27050 to avoid forming a short circuit path. The second electrode 27704 is connected to the second metal connection layer 27050 through the fifth opening 27603, thereby making the second electrode 27704 electrically connected to the second semiconductor structure 27206 .

In this embodiment, as shown in Fig. 27A to Fig. 27C, the laser device 27000 of the present application may further include a first pad structure 27902 and a second pad structure 27904, which are respectively located on the first electrode 27702 and the second electrode 27704. The laser device 27000 of the present application further includes a third insulating layer 27080 covering the first electrode 27702 and the second electrode 27704. The third insulating layer 27080 has a first hole 27802 to expose the first electrode 27702 and a second hole 27804 to expose the second electrode 27704; the first pad structure 27902 is electrically connected to the first electrode 27702 through the first hole 27802, and the second pad structure 27904 is electrically connected to the second electrode 27904 through the second hole 27804. In addition, there is a gap G27 between the first pad structure 27902 and the second pad structure 27904 ranging from 10 µm to 200 µm. In this embodiment, from the bottom view of the laser element 27000, the shape of the first pad structure 27902 is different from the shape of the second pad structure 27904 for electrical identification.

In this embodiment, as shown in Fig. 27A to Fig. 27C, the laser element 27000 of the present application may selectively include an anti-reflection structure 27101 located on the transparent substrate 27010 and away from the first electrode 27702 and the second electrode 27704. The anti-reflection structure 27101 may be used to reduce the reflection of the light emitted by the laser element 27000 at the interface between the transparent substrate 27010 and the air, so as to avoid a reduction in the light emitting efficiency of the laser element 27000 or the generation of an unexpected light shape.

In this embodiment, as shown in Fig. 27A to Fig. 27C, the first semiconductor structure 27202 and the second semiconductor structure 27206 include a plurality of layers of different refractive indices that are periodically stacked alternately (for example, AlGaAs layers with high aluminum content and AlGaAs layers with low aluminum content that are periodically stacked alternately) to form a DBR structure, so that the light emitted by the active structure 27204 can be reflected back and forth between the two DBR structures to form coherent light. The reflectivity of the first semiconductor structure 27202 is lower than the reflectivity of the second semiconductor structure 27206, thereby allowing the coherent light to be emitted toward the transparent substrate 27010. The materials of the first semiconductor structure 27202, the second semiconductor structure 27206 and the active structure 27204 include group III and V compound semiconductors, such as AlGaInAs series, AlGaInP series, AlInGaN series, AlAsSb series, InGaAsP series, InGaAsN series and AlGaAsP series, such as AlGaInP, GaAs, InGaAs, AlGaAs, GaAsP, GaP, InGaP, AlInP, GaN, InGaN or AlGaN compounds. In the embodiments of the present application, unless otherwise specified, the chemical expressions include "compounds that conform to stoichiometry" and "compounds that do not conform to stoichiometry", wherein "compounds that conform to stoichiometry" are, for example, compounds in which the total element content of group III elements is the same as the total element content of group V elements, whereas "compounds that do not conform to stoichiometry" are, for example, compounds in which the total element content of group III elements is different from the total element content of group V elements. For example, the chemical formula of the AlGaInAs series means that it contains the group III elements aluminum (Al) and/or gallium (Ga) and/or indium (In), and the group V element arsenic (As), wherein the total element content of the group III elements (aluminum and/or gallium and/or indium) can be the same as or different from the total element content of the group V elements (arsenic). In addition, if the compounds represented by the chemical formulas are stoichiometric compounds, the AlGaInAs series represents (Al_{y1}Ga_{(1-y1)})₁₋ₓ₁Inₓ₁As, where 0≦x1≦1, 0≦y1≦1; the AlGaInP series represents (Al_{y2}Ga_{(1-y2)})₁₋ₓ₂ Inₓ₂P, where 0≦x2≦1, 0≦y2≦1; the AlInGaN series represents (Al_{y3}Ga_{(1-y3)})₁₋ₓ₃ Inₓ₃ N, where 0≦x3≦1, 0≦y3≦1; the AlAsSb series represents AlAsₓ₄Sb₍₁₋ₓ₄₎, where 0≦x4≦1; and the InGaAsP series represents Inₓ₅Ga₁₋ₓ₅As_{1-y4}P_{y4}, where 0≦x5≦1, 0≦y4≦1; the InGaAsN series represents Inₓ₆Ga₁₋ₓ₆As_{1-y5}N_{y5}, where 0≦x6≦1, 0≦y5≦1; the AlGaAsP series represents Alₓ₇Ga₁₋ₓ₇As_{1-y6}P_{y6}, where 0≦x7≦1, 0≦y6≦1.

Depending on the material, the active structure 27204 can emit infrared light with a peak wavelength between 700nm and 1700nm, red light with a peak wavelength between 610nm and 700nm, yellow light with a peak wavelength between 530nm and 570nm, green light with a peak wavelength between 490nm and 550nm, blue light or deep blue light with a peak wavelength between 400nm and 490nm, or ultraviolet light with a peak wavelength between 250nm and 400nm. In this embodiment, the peak wavelength of the active structure 27204 is infrared light between 750nm and 1200nm.

The material of the current confinement layer 27205 can be the above-mentioned III-V semiconductor material. In the present embodiment, as shown in Fig. 27A to Fig. 27C, the material of the current confinement layer 27205 is AlGaAs, and the active structure 27204, the first semiconductor structure 27202, and the second semiconductor structure 27206 are made of a material containing aluminum. The aluminum content of the current confinement layer 27205 is greater than the aluminum content of the active structure 27204, the first semiconductor structure 27202, and the second semiconductor structure 27206. For example, the aluminum content of the current confinement layer 27205 is greater than 97%. In the present embodiment, the oxygen content of the current restriction region 27205B of the current confinement layer 27205 is greater than the oxygen content of the current conducting region 27205A, so that the current restriction region 27205B has a lower conductivity than the current conducting region 27205A. The adhesive layer 27040 is a material having a high transmittance to the light emitted by the active structure 27204, such as a transmittance greater than 80%. The material of the subsequent layer 27040 is an insulating material, such as benzocyclobutene resin (BCB), epoxy resin, polyimide, spin-on glass (SOG), silicone or octafluorocyclobutane (Perfluorocyclobutane, PFCB).

In the present embodiment, as shown in FIGS. 27A to 27C, the first insulating layer 27032, the second insulating layer 27060 and the third insulating layer 27080 are made of non-conductive materials. The non-conductive materials include organic materials or inorganic materials. The organic materials include Su8, benzocyclobutene (BCB), perfluorocyclobutane (PFCB), epoxy resin, acrylic resin, cyclic olefin copolymer (COC), polymethyl methacrylate (PMMA), polyethylene terephthalate (PET), polycarbonate (PC), polyetherimide or fluorocarbon polymer. The inorganic materials include silicone or glass, aluminum oxide (Al2O3), silicon nitride (SiNx), silicon oxide (SiOx), titanium oxide (TiOx), or magnesium fluoride (MgFx). In one embodiment, the first insulating layer 27032, the second insulating layer 27060 and/or the third insulating layer 27080 include one or more layers (e.g., a Bragg reflector (DBR) structure formed by alternately stacking two sub-layers, such as a SiOx sub-layer and a TiOx sub-layer).

In the present embodiment, as shown in FIGS. 27A to 27C, the materials of the first metal connection layer 27034 and the second metal connection layer 27050 may include metals, such as aluminum (Al), silver (Ag), chromium (Cr), platinum (Pt), nickel (Ni), germanium (Ge), beryllium (Be), gold (Au), titanium (Ti), tungsten (W) or zinc (Zn). The materials of the first electrode 27702 and the second electrode 27704 may be metal materials, such as gold (Au), tin (Sn), titanium (Ti) or alloys thereof. In the present embodiment, the first electrode 27702 may be a multi-layer electrode structure, for example, it may include a titanium (Ti) layer and a gold (Au) layer which are arranged sequentially in the direction away from the transparent substrate 27010. The second electrode 27704 has the same material and structural composition as the first electrode 27702. The material of the first pad structure 27902 and the second pad structure 27904 is a metal material, such as gold (Au), tin (Sn), titanium (Ti), copper (Cu), nickel (Ni), platinum (Pt) or alloys thereof. The material of the first electrode 27702 is different from that of the first pad structure 27902, and the material of the second electrode 27704 is different from that of the second pad structure 27904. For example, the first pad structure 27902 and the second pad structure 27904 contain an element, while the first electrode 27702 and the second electrode 27704 do not contain the element, so as to prevent the external (tin-containing) solder from damaging the first electrode 27702 and the second electrode 27704 and causing electrical failure during die bonding or under high current operation, thereby further improving the reliability of the laser element 27000 of the present invention. The above-mentioned element can be used to prevent the solder from diffusing into the first electrode 27702 and the second electrode 27704, and the element is, for example, nickel (Ni) and/or platinum (Pt). Specifically, the first pad structure 27902 and the second pad structure 27904 may be multi-layer structures, respectively, and include an intermediate layer 27902A, an intermediate layer 27904A, and an adhesive layer 27902B, and an adhesive layer 27904B arranged sequentially in the direction away from the transparent substrate 27010. The materials of the intermediate layers 27902A and 27904A are different from the first electrode 27702 and the second electrode 27704, thereby preventing solder (for example, tin or gold-tin alloy (AuSn)) from diffusing into the first electrode 27702 and the second electrode 27704. Therefore, the materials of the intermediate layers 27902A and 27904A preferably include metal elements other than gold (Au), tin (Sn) and copper (Cu), such as nickel (Ni) and/or platinum (Pt). The materials of the adhesive layers 27902B and 27904B include metal materials with high ductility, such as gold (Au). In this embodiment, the materials of the intermediate layers 27902A and 27904A are platinum (Pt) and nickel (Ni) stacked in sequence in the direction away from the transparent substrate 27010, and the materials of the adhesive layers 27902B and 27904B are gold (Au). In other words, in the direction away from the transparent substrate 27010, the first pad structure 27902 and the second pad structure 27904 include a nickel layer, a platinum layer, and a gold layer.

Referring to FIGS. 27A and 27B, the transparent substrate 27010 has a central region and a peripheral region surrounding the central region. The second insulating layer 27060 has plural opening portions, such as a first opening portion 27602a, a second opening portion 27602b, a third opening portion 27602c, and a fourth opening portion 27602d, distributed within the peripheral region of the substrate 27010. Furthermore, there are four spacing intervals G271-G274 between the four openings. More specifically, the first opening portions 27602a and the fourth opening portion 27602d are separated by the first spacing G271, the first opening portion 27602a and the second opening portion 27602b are separated by the second spacing G272, the second opening portions 27602b and the third opening portion 27602c are separated by the third spacing G273, and the third opening portions 27602c and the fourth opening portion 27602d are separated by the fourth spacing G274.

In addition, as shown in Fig. 27C, in this embodiment, the first metal connection layer 27034 is formed with a plurality of marking structures 27344A-27344D to facilitate mechanical recognition and subsequent packaging processes. The marking structures 27344B, 27344D are opposite to each other and connected to define the line L1, and the marking structures 27344A, 27344C are opposite to each other and connected to define the line L2. The line L1 and the line L2 are intersected at a central point BO. Referring FIGS. 27B and 27C, the marking structure 27344A corresponds to the first spacing G271, the marking structure 27344B corresponds to the second spacing G272, the marking structure 27344C corresponds to the third spacing G273, and the marking structure 27344D corresponds to the fourth spacing G274. It should be noted that the dotted lines in Fig. 27B and Fig. 27C indicate that the structure cannot be directly observed from the bottom view/top view, and only the outline of the dotted lines can be seen.

In this embodiment, the second type semiconductor structure 27206 may be located on the middle area of the transparent substrate 27010. In one embodiment, the distance from any side of the second type semiconductor structure 27206 to a border of the adjacent transparent substrate 27010 is substantially equal, allowing the first pad structure 27902 and the second pad structure 27904 (or the first electrode 27702 and the second electrode 27704) to be located symmetrically to the line L1, which facilitates the structural design of the subsequent packaging process and increases the effective area. As shown in Fig. 27B, from the direction of the second semiconductor structure 27206 of the laser element 27000 toward the active structure 27204, the transparent substrate 27010 has a first boundary C271 adjacent to the first side S271 and a second boundary C272 opposite to the first boundary C271 and adjacent to the second side S272. The first side surface C271 and the second side surface C272 are opposite to each other and are respectively arranged on the side of the transparent substrate 27010. The difference between the first distance D271 between the first side S271 and the first boundary C271 and the second distance D272 between the second side S272 and the second boundary C272 is less than 30% of the first distance D271; that is, the difference between the first distance D271 and the second distance D272 is 0≦(D271-D272)/D271<30%. In another embodiment, 0≦(D271-D272)/D271<20%. Preferably, 0≦(D271-D272)/D271<15%. In another embodiment, 1%<(D271-D272)/D271<10%. In this embodiment, the first distance D271 is equal to the second distance D272.

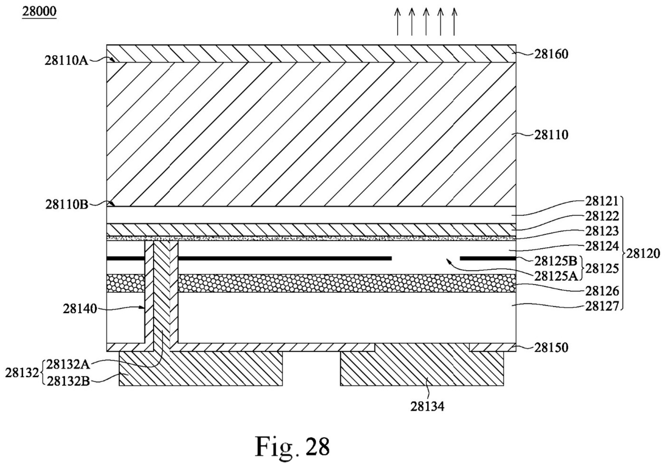

In one or more embodiments, the light emitting device may be a semiconductor light emitting element 28000, as shown in Fig. 28.

Please refer to Fig. 28, which is a cross-sectional schematic diagram of a semiconductor light emitting device 28000 according to an embodiment. The semiconductor light emitting device 28000 of this embodiment is a laser diode, and includes a base 28110, an epitaxial stack 28120 formed on the base 28110, and a first electrode structure 28132 and a second electrode structure 28134 located on the epitaxial stack 28120. The base 28110 is a gallium arsenide (GaAs) substrate with high transmittance, and has a first surface 28110A and a second surface 28110B. The light emitting surface of the semiconductor light emitting device 28100 (in the direction indicated by the arrow in Fig. 28) is defined as the first surface 28110A. The epitaxial stack 28120 It is located on the second surface 28110B of the base 28110 and sequentially includes a first semiconductor structure 28121, a second semiconductor structure 28122, an intermediate layer 28123, a third semiconductor structure 28124, an active structure 28126 and a fourth semiconductor structure 28127 .

In this embodiment, as shown in Fig. 28, the base 28110 includes a dopant so as to have a p-type or n-type conductivity type. Alternatively, in another embodiment, the base 28110 does not include any dopant or the base 28110 is an undoped base layer. The first semiconductor structure 28121 is a semiconductor material that does not include a dopant, thereby reducing the problem of light absorption by the dopant. The second semiconductor structure 28122, the intermediate layer 28123, the third semiconductor structure 28124 and the fourth semiconductor structure 28127 are semiconductor materials including dopants. The second semiconductor structure 28122, the intermediate layer 28123 and the third semiconductor structure 28124 have the same conductivity type, and the third semiconductor structure 28124 (or the second semiconductor 28122 or the intermediate layer 28123) has a different conductivity type from that of the fourth semiconductor structure 28127. In this embodiment, the conductivity type of the second semiconductor structure 28122, the intermediate layer 28123 and the third semiconductor structure 28124 is p-type, and the conductivity type of the fourth semiconductor structure 28127 is n-type. In another embodiment, the conductivity type of the second semiconductor structure 28122, the intermediate layer 28123 and the third semiconductor structure 28124 is n-type, and the conductivity type of the fourth semiconductor structure 28127 is p-type. The first electrode structure 28132 and the second electrode structure 28134 are located on the fourth semiconductor structure 28127. The dopant may include beryllium, magnesium, zinc, carbon, silicon or antimony.

Referring to the embodiment as shown in Fig. 28, the third semiconductor structure 28124 or the fourth semiconductor structure 28127 optionally includes a current confinement layer 28125. Alternatively, in this embodiment, the current confinement layer 28125 is formed in the third semiconductor structure 28124 or the fourth semiconductor structure 28127. The current confinement layer 28125 includes a current restriction region 28125B and a current conduction region 28125A surrounded and defined by the current restriction region 28125B.

In the present embodiment, as shown in Fig. 28, the semiconductor light emitting device 28000 further includes a recess structure 28140 and a protective layer 28150. The recess structure 28140 is formed in the epitaxial stack 28120. Specifically, in the present embodiment, the recess structure 28140 is formed in the fourth semiconductor structure 28127, the active structure 28126, and the third semiconductor structure 28124. In other words, in the present embodiment, the recess structure 28140 penetrates the fourth semiconductor structure 28127, the active structure 28126, and the third semiconductor structure 28124 to expose the intermediate layer 28123. The protective layer 28150 fills the recess structure 28140 and is located between the first electrode structure 28132 and the fourth semiconductor structure 28127. The first electrode structure 28132 has a first portion 28132A and a second portion 28132B. The first portion 28132A fills the recessed structure 28140 and contacts the intermediate layer 28123 and is electrically connected to the intermediate layer 28123. The second portion 28132B extends from the first portion 28132A and is located on the protection layer 28150. The second electrode structure 28134 is disposed on the fourth semiconductor structure 28127 and is electrically connected to the fourth semiconductor structure 28127.

In this embodiment, as shown in Fig. 28, the semiconductor light emitting device 28000 optionally further includes an optical element 28160 covering the first surface 28110A of the base 28110. For example, the optical element 28160 may be an anti-reflection element to further reduce the reflection of the light emitted by the semiconductor light emitting device 28000 at the interface between the base 28110 and the air, so as to avoid a reduction in the light emitting efficiency of the semiconductor light emitting device 28000 or to prevent the interference between the interface reflected light and the light emitted from the semiconductor device 28000.

In this embodiment, as shown in Fig. 28, the first semiconductor structure 28121, the second semiconductor structure 28122, the third semiconductor structure 28124, and the fourth semiconductor structure 28127 may respectively include a plurality of film layers of different refractive indices that are periodically stacked alternately (e.g., AlGaAs layers with high aluminum content and AlGaAs layers with low aluminum content that are periodically stacked alternately) to form a distributed Bragg reflector (DBR), so that the light emitted from the active structure 28126 can be reflected in the Bragg reflector to form coherent light. The reflectivity of the first semiconductor structure 28121, the second semiconductor structure 28122, and the third semiconductor structure 28124 is lower than the reflectivity of the fourth semiconductor structure 28127, thereby allowing the coherent light to be emitted toward the base 28110. The materials of the first semiconductor structure 28121, the second semiconductor structure 28122, the third semiconductor structure 28124, the fourth semiconductor structure 28127 and the active structure 28126 include III-V compound semiconductors, such as: AlGaInAs series, AlGaInP series, AlInGaN series, AlAsSb series, InGaAsP series, InGaAsN series, AlGaAsP series, etc., such as AlGaInP, GaAs, InGaAs, AlGaAs, GaAsP, GaP, InGaP, AlInP, GaN, InGaN, AlGaN, etc. In the embodiments of the present application, unless otherwise specified, the above chemical expressions include "compounds that meet stoichiometric measurements" and "compounds that do not meet stoichiometric measurements", wherein "compounds that meet stoichiometric measurements" are, for example, compounds in which the total element content of the III-group elements is the same as the total element content of the V-group elements, whereas "compounds that do not meet stoichiometric measurements" are, for example, compounds in which the total element content of the III-group elements is different from the total element content of the V-group elements. For example, the chemical formula of AlGaInAs series means that it contains Group III elements aluminum (Al) and/or gallium (Ga) and/or indium (In), and Group V elements arsenic (As), wherein the total element content of Group III elements (aluminum and/or gallium and/or indium) may be the same as or different from the total element content of Group V elements (arsenic). In addition, if the compounds represented by the chemical formulas are stoichiometric compounds, the AlGaInAs series means (Al_{y1}Ga_{(1-yl)})₁₋ₓ₁Inₓ₁As, wherein 0≦x1≦1, 0≦y1≦1; the AlGaInP series means (Al_{y2}Ga_{(1-y2)})₁₋ₓ₂ Inₓ₂P, where 0≦x2≦1, 0≦y2≦1; AlInGaN series represents (Al_{y3}Ga_{(1-y3)})₁₋ₓ₃Inₓ₃N, where 0≦x3≦1, 0≦y3≦1; AlAsSb series represents AlAsₓ₄Sb₍₁₋ₓ₄₎, where 0≦x4≦1; InGaAsP series represents Inₓ₅Ga₁₋ₓ₅As_{1-y4}P_{y4}, where 0≦x5≦1, 0≦y4≦1; InGaAsN series represents Inₓ₆Ga₁₋ₓ₆As_{1-y5}N_{y5}, where 0≦x6≦1, 0≦y5≦1; the AlGaAsP series represents Alₓ₇Ga₁₋ₓ₇As_{1-y6}P_{y6}, where 0≦x7≦1, 0≦y6≦1.

Depending on different materials, the active structure 28126 can emit infrared light with a peak wavelength between 700nm and 1700nm, red light with a peak wavelength between 610nm and 700nm, yellow light with a peak wavelength between 530nm and 570nm, green light with a peak wavelength between 490nm and 550nm, blue light or deep blue light with a peak wavelength between 400nm and 490nm, or ultraviolet light with a peak wavelength between 250nm and 400nm. In this embodiment, the peak wavelength of the active structure 28126 is infrared light between 750nm and 2000nm.

The current confinement layer 28125 can be formed by oxidation process or ion implantation process. In the present embodiment, when the first semiconductor structure 28121, the second semiconductor structure 28122, the third semiconductor structure 28124, the active structure 28126 and the fourth semiconductor structure 28127 include multiple film layers and all include aluminum, the aluminum content of one or more layers in the third semiconductor structure 28124 can be designed to be greater than 97% (defined as the current confinement layer 28125) and greater than the aluminum content of the active structure 28126, other film layers of the third semiconductor structure 28124, the second semiconductor structure 28122, the first semiconductor structure 28121 and the fourth semiconductor structure 28127. Thus, after the oxidation process, the layer or portions of these layers with an aluminum content greater than 97% will be oxidized to form a current restriction region 28125B (e.g., aluminum oxide), and the unoxidized portion will be the current conduction region 28125A. During the oxidation process, oxygen passes through the recessed structure 28140 and the epitaxial stack 28120 to undergo an oxidation reaction.

The materials of the first electrode structure 28132 and the second electrode structure 28134 include metal materials, such as gold (Au), tin (Sn), titanium (Ti), copper (Cu), silver (Ag), germanium (Ge), platinum (Pt), palladium (Pd), nickel (Ni) or their alloys.

In this embodiment, as shown in Fig. 28, the material of the intermediate layer 123 is different from those of the first semiconductor structure 28121, the second semiconductor structure 28122 and the third semiconductor structure 28124. The intermediate layer T may be single-layer or multi-layer and serves as an etch stop layer for controlling the depth of the recess 28140. The intermediate layer 28123 includes a semiconductor material, for example, GaAs or InGaP, and has a thickness that is an odd-number multiple of ¼n of the peak wavelength of light emitted by the active structure 28126, where n is a refractive index. In one embodiment, because the material of the intermediate layer 28123 is different from those of the first semiconductor structure 28121, the second semiconductor structure 28122 and the third semiconductor structure 28124, the optical characteristics (for example, reflectance and threshold current (Iₜₕ)) of the semiconductor light emitting element 28000 are affected. Therefore, the thickness of the intermediate layer 28123 is designed to be between 0.05 um and 0.5 um. In one embodiment, the intermediate layer 28123 may possibly reduce lateral current spreading, and thus the second type semiconductor layer 28122 may be further used as a current spreading layer in addition to optical property considerations. When the intermediate layer 123 is multi-layer (for example, including two layers, wherein the first layer is InGaP and the second layer is GaAs), the total thickness of the multiple layers is between 0.05um and 0.5um.

In one embodiment, as shown in Fig. 28, when the first semiconductor structure 28121, the second semiconductor structure 28122, and the third semiconductor structure 28124 are all distributed Bragg reflectors (DBRs), the number of pairs of periodically alternately stacked film layers in the first semiconductor structure 28121 may be greater than, equal to, or less than that of the second semiconductor structure 28122, and/or the number of pairs of periodically alternately stacked film layers in the first semiconductor structure 28121 may be greater than, equal to, or less than that of the third semiconductor structure 28124. In one embodiment, the number of pairs of film layers in the second semiconductor structure 28122 is less than that of the third semiconductor structure 28124. In one embodiment, the number of pairs of film layers in the first semiconductor structure 28121 may be 5 to 15 pairs, the number of pairs of film layers in the second semiconductor structure 28122 may be 2 to 5 pairs, and the number of pairs of film layers in the third semiconductor structure 28124 may be 5 to 15 pairs.

In one embodiment, as shown in Figure 28, based on the requirements of optical properties, the sum of the number of film layer pairs of the first semiconductor structure 28121, the second semiconductor structure 28122 and the third semiconductor structure 28124 is less than the number of film layer pairs of the fourth semiconductor layer 28127. For example, the sum of the number of film layer pairs of the first semiconductor structure 28121, the second semiconductor structure 28122 and the third semiconductor structure 28124 is 15 to 25 pairs, and the number of film layer pairs of the fourth semiconductor layer 28127 is 30 to 60 pairs.

In one embodiment, as shown in Fig. 28, the P-type semiconductor layer has a lower doping concentration than the N-type semiconductor layer in process technology, and the sum of the number of film layers of the second semiconductor structure 28122 and the third semiconductor structure 28124 is less than the number of film layers of the fourth semiconductor layer 28127 in design. Thus, the conductivity type of the first semiconductor structure 28122 and the third semiconductor structure 28124 may be designed as P-type, and the conductivity type of the fourth semiconductor structure 28127 may be designed as n-type, thereby reducing the series resistance and enhancing luminous efficiency of the overall semiconductor light emitting element 28000.

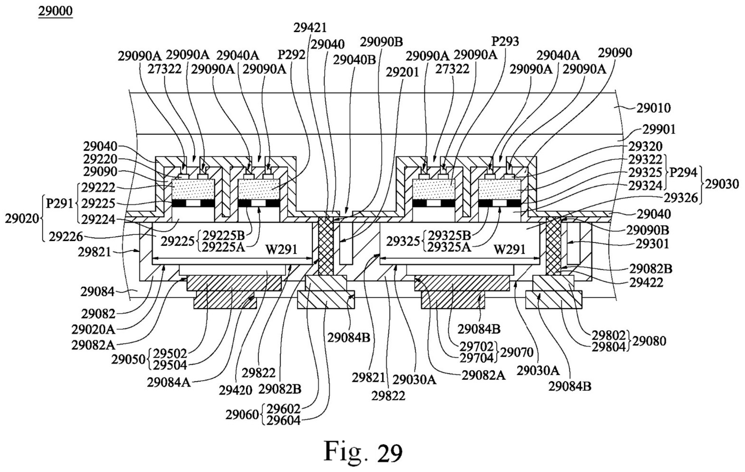

Please refer to the cross-sectional schematic diagram of Fig. 29, which is a cross-sectional schematic diagram of a semiconductor light emitting device 29000 according to an embodiment. The semiconductor light emitting device 29000 of this embodiment includes a base 29010, and an epitaxial structure 29020 and an epitaxial structure 29030 located on one side of the base 29010. The epitaxial structure 29020 and the epitaxial structure 29030 are spaced apart by a predetermined distance and do not contact each other, but the present invention is not limited thereto. The semiconductor light emitting device 29000 also includes a metal connection layer 29040 located between the epitaxial structure 29020 and the base 29010, and between the epitaxial structure 29030 and the base 29010. The semiconductor light emitting element 29000 also includes an electrode structure 29050, an electrode structure 29060, an electrode structure 29070 and an electrode structure 29080. The electrode structure 29050 and the electrode structure 29060 are located on a surface 29020A of the epitaxial structure 29020 away from the base 29010, and the electrode structure 29070 and the electrode structure 29080 are located on a surface 29030A of the epitaxial structure 29030 away from the base 29010. The electrode structure 29050 and the electrode structure 29060 are respectively connected to a semiconductor layer having the same conductivity type, and the electrode structure 29070 and the electrode structure 29080 are respectively connected to a semiconductor layer having the same conductivity type.

The epitaxial structure 29020 includes multiple (two in the embodiment shown in Fig. 29, but the present invention is not limited thereto) epitaxial columnar structures P291, P292 and a platform structure 29226, and the epitaxial structure 29030 includes multiple (two in the embodiment shown in Fig. 29, but the present invention is not limited thereto) epitaxial columnar structures P293, P294 and a platform structure 29326; wherein the epitaxial columnar structures P291, P292 and the epitaxial columnar structures P293, P294 have the same or substantially the same structure. In the present embodiment, each epitaxial columnar structure P291 (P292) includes a semiconductor structure 29222, a current confinement layer 29225 and an active structure 29224 which are sequentially located on the base 29010. A plurality of epitaxial columnar structures P291 and P292 are located between the platform structure 29226 and the base 29010, and are arranged regularly or irregularly. Similarly, the epitaxial columnar structure P293 (P294) of the epitaxial structure 29030 includes a semiconductor structure 29322, a current confinement layer 29325 and an active structure 29324 which are sequentially located on the base 29010, and a plurality of epitaxial columnar structures P293 and P294 are arranged regularly or irregularly on the platform structure 29326. The term "regular arrangement" used in the present application means that a plurality of epitaxial columnar structures have a specific spatial relationship and are arranged in a fixed and repetitive manner. In some regularly arranged epitaxial columnar structures, the spacing between adjacent epitaxial columnar structures is substantially the same; in other regularly arranged epitaxial columnar structures, multiple epitaxial columnar structures are arranged along a specific direction. In the present application, the current confinement layer 29225 or the current confinement layer 29325 can be respectively arranged between the active structure 29224 and the semiconductor structure 29222, and between the active structure 29324 and the semiconductor structure 29322, as in the embodiment shown in Fig. 29; alternatively, the current confinement layer 29225 and 29325 may also be selectively disposed between the active structure 29224 and the platform structure 29226, and between the active structure 29324 and the platform structure 29326. In one embodiment, current confinement layers 29225 and 29325 are disposed between the active structure 29224 and the semiconductor structure 29222, between the active structure 29324 and the semiconductor structure 29322, between the active structure 29224 and the platform structure 29226, and between the active structure 29324 and the platform structure 29326, that is, multiple current confinement layers may be disposed in the epitaxial structure 29020 and/or the epitaxial structure 29020. The platform structure 29226 and the platform structure 29326 have semiconductor structures, and the semiconductor structure of the platform structure 29226 and the semiconductor structure of the platform structure 29326 have substantially the same structure. In the present embodiment, the semiconductor structure 29222 and the semiconductor structure 29322 have the same conductivity type (e.g., P-type), and the semiconductor structure of the platform structure 29226 and the semiconductor structure of the platform structure 29326 have the same conductivity type (e.g., N-type), and the semiconductor structure 29222 and the semiconductor structure of the platform structure 29226 have opposite conductivity types, and the semiconductor structure 29322 and the semiconductor structure of the platform structure 29326 have opposite conductivity types. In the present embodiment, the platform structure 29226 has a width W291, and the platform structure 29326 has a width W292 that is the same as the width W291. In other embodiments, the width W291 may be greater than or less than the width W292.

Please refer to Fig. 29. In the present embodiment, the epitaxial columnar structures P291, P292 and the epitaxial columnar structures P293, P294 have corresponding contact structures 29220 and contact structures 29320 on their surfaces close to the base 29010. The contact structures 29220 and 29320 are, for example, multi-layer metal structures. The contact structures 29220 or 29320 as multi-layer metal structures in contact with the P-type semiconductor structure may be Ti/Pt/Au. The contact structures 29220 or 29320 as multi-layer metal structures in contact with the N-type semiconductor structure may be Au/GeAu/Au, but the present invention is not limited thereto. The contact structures 29220 and 29320 are connected to the semiconductor structure 29222 and the semiconductor structure 29322, respectively. From a top view, the contact structures 29220 and 29320 are ring-shaped.

Please refer to Fig. 29. The semiconductor light emitting element 29000 of the present embodiment further includes an insulating layer 29090, which covers the side and a portion of the upper surface of each epitaxial columnar structure P291, P292, and covers the side and a portion of the upper surface of each epitaxial columnar structure P293, P294. The insulating layer 29090 is transparent to the light emitted from each epitaxial columnar structure. Specifically, the insulating layer 29090 has a plurality of insulating layer openings 29090A, thereby exposing the contact structure 29220 on the epitaxial structure 29020 and the contact structure 29320 on the epitaxial structure 29030. In the present embodiment, the insulating layer opening 29090A is in the shape of a ring when viewed from above. The metal connection layer 29040 covers the insulating layer 29090. In the present embodiment, the metal connection layer 29040 is located between the epitaxial structure 29020 and the epitaxial structure 29030. The metal connection layer 29040 is electrically connected to the contact structure 29220 and the contact structure 29330 through the insulating layer opening 29090A. The metal connection layer 29040 has a plurality of connection layer openings 29040A, and the connection layer openings 29040A are located on the epitaxial columnar structures P291, P292, P293, and P294, so that the light emitted by the active structures 29224 and 29324 can be emitted toward the base 29010 through the connection layer openings 29040A. Referring to Fig. 29, the semiconductor light emitting element 29000 of this embodiment further includes a spacer 29040B located between the epitaxial columnar structure P292 and the epitaxial columnar structure P293 and separating the connection layer 29040 therebetween, and the spacer 29040B is a schematic cross-sectional structure of a long groove structure between the connection layer 29040 in the light emitting area 29000A and the connection layer 29040 in the light emitting area 29000B. The semiconductor light emitting element 29000 of this embodiment further includes an adhesive layer 29901, and the epitaxial structure 29020 and the epitaxial structure 29030 are bonded to the base 29010 via the adhesive layer 29901. The base 29010 and the adhesive layer 29901 are transparent to the light emitted from each epitaxial columnar structure. The insulating layer 29090 also has a plurality of insulating layer openings 29090B. When viewed from above, the insulating layer openings 29090B are, for example, circular, and the metal connection layer 29040 fills in between to form conduction with the underlying structure, as will be described in more detail below.

Refering to Fig.29, the semiconductor light emitting device 29000 of this embodiment has an electrode connection layer 29420 and an electrode connection layer 29520 respectively located on the side of the platform structure 29226 and the platform structure 29326 away from the base 29010, and the electrode connection layer 29420 and the electrode connection layer 29520 are respectively electrically connected to the semiconductor structure 29226 and the semiconductor structure 29326. The semiconductor light emitting device 29000 includes an insulating layer 29082, and the insulating layer 29082 covers the side and part of the surface of the electrode connection layer 29420 and the electrode connection layer 29520, and covers the side and part of the surface of the platform structure 29226 and the platform structure 29326. Specifically, the insulating layer 29082 has a side portion 29821, an upper portion 29822 and a plurality of openings 29082A, wherein the electrode connection layer 29420 and the electrode connection layer 29520 are exposed through the openings 29082A and are electrically connected to the electrode structure 29050 and the electrode structure 29070 through the openings 29082A. The epitaxial structure 29020 has a through hole 29201 penetrating the platform structure 29226, the epitaxial structure 29030 has a through hole 29301 penetrating the platform structure 29326. The insulating layer 29082 is filled in the through hole 29201 and the through hole 29301, and the insulating layer 29082 also includes a plurality of openings 29082B respectively located in the through hole 29201 and the through hole 29301. The conductive layer 29421 is filled in the opening 29082B in the through hole 29201, the conductive layer 29422 is filled in the opening 29082B in the through hole 29301, and the conductive layer 29421 and the conductive layer 29422 are electrically connected to the metal connection layer 29040 through the insulating layer opening 29090B and the opening 29082B. In this embodiment, the electrode structure 29060 is connected to the conductive layer 29421 and electrically connected to the metal connection layer 29040 on the epitaxial structure 29020; the electrode structure 29080 is connected to the conductive layer 29422 and electrically connected to the metal connection layer 29040 on the epitaxial structure 29030.

Please refer to Fig. 29. The semiconductor light emitting element 29000 of this embodiment also includes an insulating layer 29084, which covers the side 29821 and a portion of the upper portion 29822 of the insulating layer 29082, and has a plurality of openings 29084A and a plurality of openings 29084B corresponding to the plurality of openings 29082A and the plurality of openings 29082B respectively. The electrode structure 29050 and the electrode structure 29070 are electrically connected to the electrode connection layer 29420 and the electrode connection layer 29520 respectively through the opening 29084A, and the electrode structure 29060 and the electrode structure 29080 are electrically connected to the metal connection layer 29040 through the opening 29084B.

Please refer to Fig. 29. In the present embodiment, the conductivity type of the semiconductor structure 29222 and the semiconductor structure 29322 is P-type, and the conductivity type of the semiconductor structure (platform 29226) and the semiconductor structure (platform 29326) is N-type. Since the electrode structure 29060 and the electrode structure 29080 are electrically connected to the metal connection layer 29040, and the metal connection layer 29040 is electrically connected to the semiconductor structure 29222 and the semiconductor structure 29322, the electrode structure 29060 and the electrode structure 29080 are P-electrodes; the electrode structure 29050 and the electrode structure 29070 are electrically connected to the corresponding semiconductor structure, respectively, so the electrode structure 29050 and the electrode structure 29070 are both N-electrodes. The electrical properties of epitaxial structure 29020 are controlled by electrode structure 29050 and electrode structure 29060, and the electrical properties of epitaxial structure 29030 are jointly controlled by electrode structure 29070 and electrode structure 29080, and the electrode structures 29050, 29060, 29070, and 29080 are separated from each other, so epitaxial structure 29020 and epitaxial structure 29030 can be independently controlled; for example, epitaxial structure 29020 or epitaxial structure 29030 can be lit up separately.

For the sake of simplicity, Fig. 29 shows two epitaxial structures (epitaxial structure 29020 and epitaxial structure 29030), and each epitaxial structure includes two epitaxial columnar structures (epitaxial structure 29020 has two epitaxial columnar structures P291 and P292, and epitaxial structure 29030 has two epitaxial columnar structures P293 and P294) as an example. However, in actual product applications, the number of epitaxial structures and epitaxial columnar structures (for example, but not limited to 10 to 1000) can be adjusted according to the current and power requirements of the semiconductor light-emitting element (for example, VCSEL) when it is used. The current confinement layer 29225 includes a current restriction region 29225B and a current conduction region 29225A. The current restriction region 29225B surrounds the current conduction region 29225A. The conductivity of the current conduction region 29225A is higher than that of the current restriction region 29225B, so that the current is concentrated in the current conduction region 29225A. Similarly, the current confinement layer 29325 includes a current restriction region 29325B and a current conduction region 29325A. The current restriction region 29325B surrounds the current conduction region 29325A. The conductivity of the current conduction region 29325A is higher than that of the current restriction region 29325B.

Please refer to Fig. 29. The semiconductor light emitting element 29000 in this embodiment is a flip-chip vertical cavity surface emitting laser (VCSEL) element. The semiconductor light emitting element 29000 may be bonded by solder to an external circuit substrate (such as a printed circuit board).

Please refer to Fig. 29. In this embodiment, the electrode structure 29050 may be a multilayer structure. In the direction away from the base 29010, the electrode structure 29050 may include, for example, a titanium (Ti) layer and a gold (Au) layer, or a titanium (Ti) layer and a platinum (Pt) layer and a gold (Au) layer, or a titanium tungsten (TiW) layer and a gold (Au) layer. The electrode structure 29050 includes an intermediate layer 29502 and an adhesive layer 29504; the electrode structure 29060 includes an intermediate layer 29602 and an adhesive layer 29604; the electrode structure 29070 includes an intermediate layer 29702 and an adhesive layer 29704; and the electrode structure 29080 also includes an intermediate layer 29802 and an adhesive layer 29804. The electrode structures 29050, 29060, 29070 and 29080 may contain at least one element, while the electrode connection layer 29420, 29520 and the conductive layer 29421, 29422 do not contain the element, so as to prevent the external (tin-containing) solder from damaging the electrode connection layer 29420, 29520 and the conductive layer 29421, 29422 and causing electrical failure during die bonding or high current operation, thereby further improving the reliability of the semiconductor light emitting element 29000 of the present application. The above-mentioned element can be used to prevent the solder from diffusing into the electrode connection layer 29420, 29520 and the conductive layer 29421, 29422, and the element is, for example, nickel (Ni) and/or platinum (Pt). Specifically, electrode structure 29050, electrode structure 29060, electrode structure 29070 and electrode structure 29080 may respectively include multiple layers. For example, the materials of intermediate layer 29502, intermediate layer 29602, intermediate layer 29702 and intermediate layer 29802 are different from those of electrode connection layer 29420, electrode connection layer 29520, conductive layer 29421 and conductive layer 29422, thereby preventing solder (for example, tin or gold-tin alloy (AuSn)) from diffusing into electrode connection layer 29420, electrode connection layer 29520, conductive layer 29421 and conductive layer 29422. Therefore, the materials of intermediate layer 29502, intermediate layer 29602, intermediate layer 29702 and intermediate layer 29802 preferably include metal elements other than gold (Au), tin (Sn) and copper (Cu), such as nickel (Ni) and/or platinum (Pt). The adhesive layer 29504, the adhesive layer 29604, the adhesive layer 29704 and the adhesive layer 29804 include a metal material with high ductility, preferably gold (Au). In other words, referring to Fig. 29, in a direction away from the base 29010, the electrode structure 29050, the electrode structure 29060, the electrode structure 29070 and the electrode structure 29080 may include a nickel layer, a platinum layer and a gold layer in sequence, respectively. In another embodiment, the electrode structure 29050, the electrode structure 29060, the electrode structure 29070 and the electrode structure 29080 may include only the adhesive layer 29504, the adhesive layer 29604, the adhesive layer 29704 and the adhesive layer 29804, respectively.

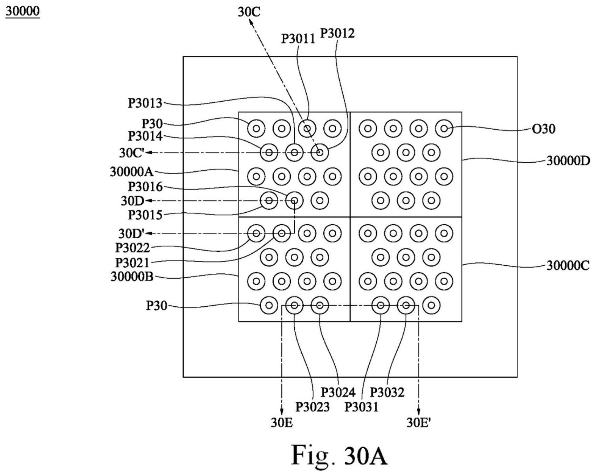

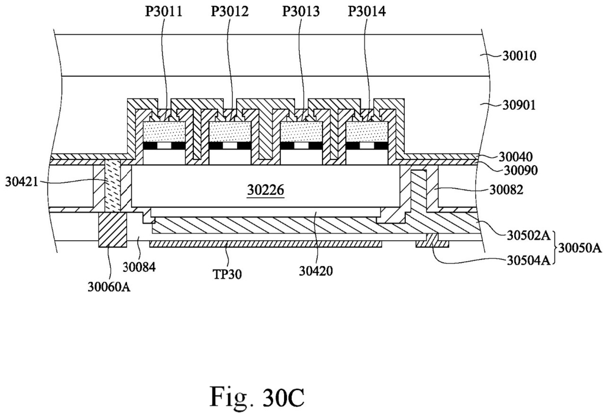

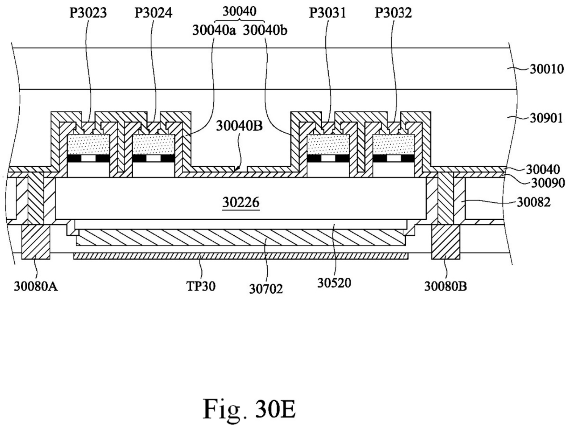

In one or more embodiments, the light emitting device may be a semiconductor light emitting element 30000, as shown in Fig. 30A to Fig. 30E. Please refer to Fig. 30C to Fig. 30E, which show cross-sectional schematic diagrams of different cross sections of the semiconductor light emitting element 30000 of the present application; Fig. 30C schematically illustrates a cross section along 30C-30C' in Fig. 30A. 30D schematically illustrates the cross-sectional structure along line 30D-30D' in Fig. 30A, and Fig. 30E schematically illustrates the cross-sectional structure along line 30E-30E' in Fig. 30A. The semiconductor light emitting element 30000 of this embodiment has a composition similar to that of the semiconductor light emitting element 29000 shown in Fig. 29.

Please refer to Fig. 30A to Fig. 30E, which are respectively a top perspective view, a bottom perspective view and cross-sectional views of a semiconductor light emitting device 30000 according to an exemplary embodiment. In this embodiment, as shown in Fig. 30C, the semiconductor light emitting device 30000 includes a base layer 30010, an adhesive layer 30901, a plurality of epitaxial columnar structures P30 (P3011 to P3014) and a platform structure 30226, wherein the epitaxial columnar structure P30 is formed on the platform structure 30226 and bonded to the base layer 30010 by the adhesive layer 30901. The semiconductor light emitting element 30000 further includes a metal connection layer 30040, which is located between the epitaxial columnar structure P30 and the base layer 30010, and the metal connection layer 30040 is electrically connected to the first semiconductor structure 30222 of each epitaxial columnar structure P30 (P3011~P3014), and the insulating layer 30090 is located between the metal connection layer 30040 and the columnar structure P30.

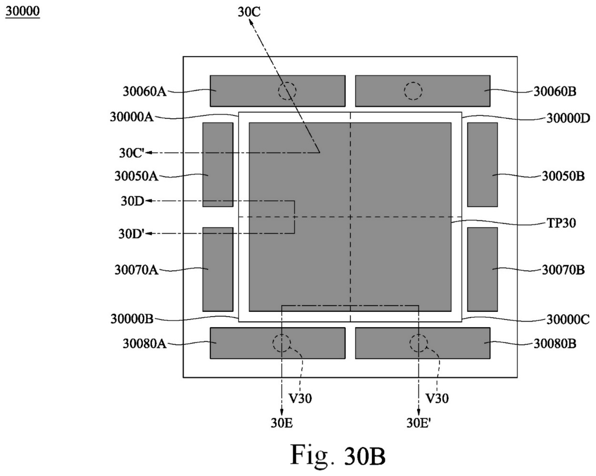

In this embodiment, as shown in Fig. 30B to Fig. 30E, the semiconductor light emitting device 30000 further includes electrode structures 30050A, 30050B, 30060A, 30060B, 30070A, 30070B, 30080A, 30080B. In this embodiment, as shown in Fig. 30B, the electrode structures 30050A, 30050B, 30060A, 30060B, 30070A, 30070B, 30080A, 30080B of the semiconductor light emitting device 30000 are located outside the light emitting regions 30000A, 30000B, 30000C, 30000D, and the electrode structures and the light emitting regions do not overlap with each other. Specifically, in this embodiment, the structure of the semiconductor light emitting device is composed of the structure of the light emitting region and the structure of the non-light emitting region. The structure of the light-emitting area of the semiconductor light-emitting element 30000 includes four light-emitting areas 30000A, 30000B, 30000C, and 30000D, and the structure of the non-light-emitting area of the semiconductor light-emitting element 30000 includes electrode structures 30050A, 30050B, 30060A, 30060B, 30070A, 30070B, 30080A, and 30080B, but the number of light-emitting areas and the number of electrode structures of the present invention are not limited thereto. In this embodiment, as shown in Fig. 30B, the electrode structure 30050A and the electrode structure 30060A located in the outer area of the light-emitting area 30000A are used to control the light-emitting area 30000A; the electrode structure 30070A and the electrode structure 30080A located in the outer area of the light-emitting area 30000B are used to control the light-emitting area 30000B; the electrode structure 30070B and the electrode structure 30080B located in the outer area of the light-emitting area 30000C are used to control the light-emitting area 30000C; the electrode structure 30050B and the electrode structure 30060B located in the outer area of the light-emitting area 30000D are used to control the light-emitting area 30000D. In this embodiment, as shown in Fig. 30B, a plurality of electrode structures 30050A, 30060A, 30070A, 30080A, 30050B, 30060B, 30070B, 30080B are separated from each other.

In this embodiment, the semiconductor light emitting element 30000 may selectively further include a heat conductive structure TP30 located on the back of the plurality of light emitting regions 30000A, 30000B, 30000C, and 30000D, for conducting the heat energy generated by each light emitting region to the outside, so as to increase the heat dissipation effect of the semiconductor light emitting element 30000. The material of the heat conductive structure TP30 may be, for example, a metal heat conductive structure, and the distribution area of the heat conductive structure TP30 covers the corresponding area where all epitaxial columnar structures P30 are located for heat conduction and dissipation of each light emitting region, but the present invention is not limited thereto. In one embodiment, for example, the electrode structure 30060A and the electrode structure 30080A may have an internal connection structure that is electrically conductive to each other, so that the electrode structure 30060A and the electrode structure 30080A form a common electrode structure architecture. In another embodiment, for example, the diagonally located electrode structure 30060A and the electrode structure 30080B, or the diagonally located electrode structure 30060B and the electrode structure 30080A may have an internal connection structure that is electrically conductive to each other to form two electrode structures with different electrical properties, which can further improve the current distribution, but the present invention is not limited to this.

As shown in Fig. 30C, the four epitaxial columnar structures (i.e., corresponding to the light-emitting holes) P301, P302, P303, and P304 of the light-emitting region 30000A are located above the same platform structure 30226, and the electrical control signal passes through the electrode structure 30050A and the electrode structure 30060A located outside the platform structure 30226 to control the light-emitting state of the light-emitting region 30000A. In this embodiment, the electrode structure 30050A is electrically connected to the semiconductor structure (i.e., corresponding to the platform structure 30226) via the electrode connection layer 30420, and the electrode structure 30060A is connected to the conductive layer 30421, thereby electrically connecting to the metal connection layer 30040 of the semiconductor light-emitting element 30000. In this embodiment, the semiconductor light-emitting element 30400 further includes a heat-conducting structure TP30, which is covered on the insulating layer 30084 for conduction and heat dissipation.

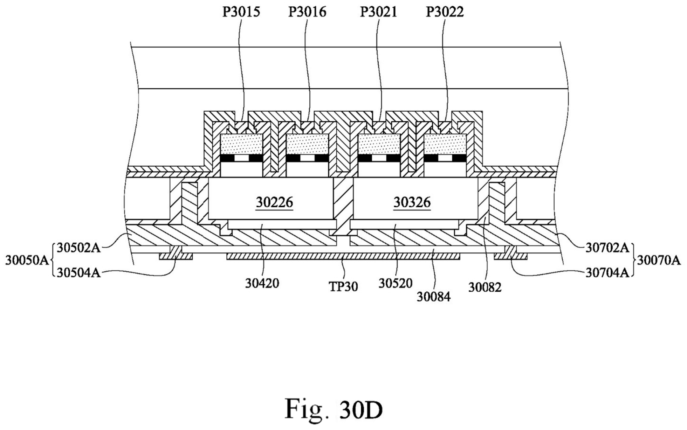

Fig. 30D shows epitaxial columnar structures P3015, P3016, P3021, and P3022 located in different light-emitting regions 30000A and 30000B, wherein the epitaxial columnar structures P3015 and P3016 are located on the platform structure 30226, and the epitaxial columnar structures P3021 and P3022 are located on the platform structure 30326. As shown in Fig. 30D, the electrode structure 30050A and the electrode structure 30070A are electrically connected to the platform structure 30226 and the platform structure 30326, respectively, and the electrode structure 30050A and the electrode structure 30070A are not electrically connected to each other (i.e., the electrode structure 30050A and the electrode structure 30070A are isolated by the insulating layer 30084), so that the electrical control signal can pass through the electrode structure 30050A and the electrode structure 30070A outside the light-emitting area 30000A and the light-emitting area 30000B respectively to control the light-emitting state of the light-emitting area 30000A and the light-emitting area 30000B. Similarly, the heat-conducting structure TP30 is disposed on the insulating layer 30084 and the area covers the area where all the epitaxial columnar structures P30 are located for heat conduction and heat dissipation in each light-emitting area.

In the cross-sectional structure shown in Fig. 30E, the epitaxial columnar structures P3023 and P3024 of the light-emitting region 30000B and the epitaxial columnar structures P3031 and P3032 of the light-emitting region 30000C are located on the same platform structure 30326. As shown in the figure, the electrode structure 30080A and the electrode structure 30080B located outside the light-emitting region 30000B and the light-emitting region 30000C respectively are not electrically connected to each other, so that the light-emitting states of the light-emitting region 30000B and the light-emitting region 30000C can be controlled independently. Similarly, the heat-conducting structure TP30 is disposed on the insulating layer 30084 for heat conduction in the light-emitting region. As shown in Fig. 30E, a spacer 30040B is also formed in the metal connection layer 30040 on the platform structure 30226 to separate the metal connection layer 30040 into mutually separated portions 30040a and 30040b, that is, a groove structure is formed between the portions 30040a and 30040b and a portion of the surface of the insulating layer 30090 is exposed.

Please refer to FIGS. 30A to 30E again. In the present embodiment, the electrode structures 30050A, 30060A, 30070A, 30080A, and 30080B may respectively include an intermediate layer (for example, intermediate layers 30502A and 30702A) and an adhesive layer (for example, adhesive layers 30504A and 30704A).

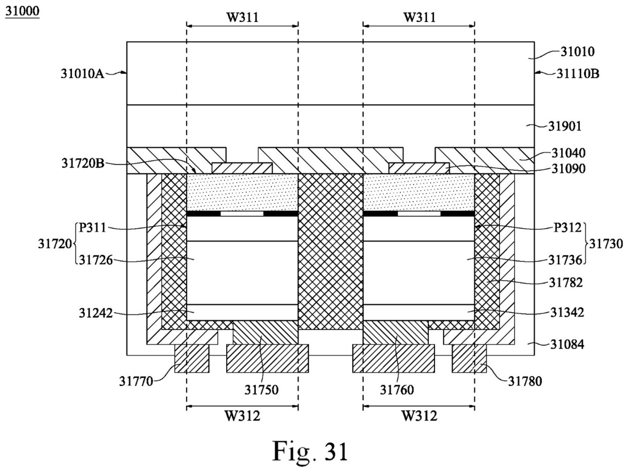

In this embodiment, as shown in Fig. 30A to Fig. 30E, the semiconductor light emitting element 30000 is a flip-chip laser element, and the semiconductor light emitting element 30000 can be subsequently bonded to an external carrier (e.g., a printed circuit board or a driver chip 21010 as shown in Fig. 21) by a flip-chip bonding process using solder. In one or more embodiments, the light emitting device can be a semiconductor light emitting element 31000, as shown in Fig. 31.

According to the present application, the selection and configuration design of the insulating layer material can be used to reduce the overall capacitance of the semiconductor light emitting device, thereby improving the operating efficiency of the semiconductor light emitting device. Please refer to Fig. 31, which is a cross-sectional schematic diagram of a semiconductor light emitting device 31000 according to an embodiment.

As shown in Fig. 31, the semiconductor light emitting device 31000 of the present embodiment further includes a metal connection layer 31040 located between the epitaxial structure 31720 and the substrate 31010, and between the epitaxial structure 31730 and the substrate 31010. As shown in Fig. 31, the semiconductor light emitting device 31000 of the present embodiment further includes an adhesive layer 31901, and the epitaxial structure 31720 and the epitaxial structure 31730 are connected to the substrate 31010 via the adhesive layer 31901. As shown in Fig. 31, the semiconductor light emitting device 31000 of the present embodiment further includes an insulating layer 31090, which covers the side and part of the upper surface of each epitaxial columnar structure P311, P312, and covers the side and part of the upper surface of each epitaxial columnar structure P313, P314. The insulating layer 31090 is transparent to the light emitted from each epitaxial columnar structure. As shown in Fig. 31, the semiconductor light emitting element 31000 of this embodiment further includes an insulating layer 31084, which covers the sides and partial surfaces of the electrode structures 31770 and 31780, and covers the sides and partial surfaces of the platform structures 31226 and 31326. As shown in Fig. 31, the semiconductor light emitting element 31000 of this embodiment has an electrode connection layer The electrode connection layer 31242 and the electrode connection layer 31342 are respectively located on the side of the platform structure 31226 and the platform structure 31326 away from the substrate 31010, and the electrode connection layer 31242 and the electrode connection layer 31342 are respectively electrically connected to the epitaxial structure 31720 and the epitaxial structure 31730.

In the embodiment shown in Fig. 31, the electrode structure 31770 and the electrode structure 31780 in the semiconductor light emitting element 31000 are located outside the epitaxial structure 31720 and the epitaxial structure 31730; that is, in this embodiment, the electrode structure 31770 is located on the side of the epitaxial structure 31720 close to the side 31010A of the base layer 31010, and the electrode structure 31780 is located on the side of the epitaxial structure 31730 close to the side 31010B of the base layer 31010. In this embodiment, the electrode structure 31770 and the electrode structure 31780 are located outside the electrode structure 31750 and the electrode structure 31760, respectively, as shown in Fig. 31. In addition, each electrode structure 31750, 31760 includes an intermediate layer and an adhesive layer. In this embodiment, as shown in Fig. 31, the semiconductor light emitting element 31000 is a flip-chip laser element, which can be subsequently bonded to an external carrier (eg, a printed circuit board or a driver chip 21010 as shown in Fig. 21) using solder by a flip-chip bonding process.

In the embodiment shown in Fig. 31, the epitaxial columnar structures P311 and P312 have a width W311, and the platform structures 31726 and 31736 have a width W312. In some embodiments, the width W311 is smaller than the width W312; in other words, in some embodiments, the platform structures 31726 and 31736 are formed as mesas with their outer sides protruding outside the epitaxial columnar structures P311 and P312, and form a two-stage mesa structure with the epitaxial columnar structures P311 and P312.

Alternatively, as shown in the present embodiment in Fig. 31, the width W312 of the platform structure 31726 and the platform structure 31736 of the semiconductor light emitting element 31000 is equal to or close to the width W311 of the epitaxial columnar structures P311 and P312, that is, the width w312 is equal to the width w311; in other words, in this embodiment, the platform structure 31726 and the platform structure 31736 form a mesa of the same section as the epitaxial columnar structures P311 and P312, and therefore the epitaxial structure 31720 and the epitaxial structure 31730 do not have a two-stage mesa structure.

In the embodiment shown in Fig. 31, since the epitaxial structure 31720 and the epitaxial structure 31730 form mesa structures respectively and the electrode structure 31770 and the electrode structure 31780 are respectively arranged on the outer sides of the epitaxial structure 31720 and the epitaxial structure 31730, the depth and width of the interval between the epitaxial structure 31720 and the epitaxial structure 31730 are higher than those of general semiconductor light emitting elements. Therefore, the present application uses a low dielectric value (low-k) adhesive (e.g., spin-on glass (SOG) adhesive) as the insulating material of the insulating layer 31782 in the semiconductor light emitting element 31000.

Therefore, the glue layer can not only easily fill the gap between the epitaxial structure 31720 and the epitaxial structure 31730, but also can easily fill the gap between the epitaxial structure 31720 and the epitaxial structure 31730. The epitaxial structures 31720, 31730 and the insulating layer 31782 therebetween can form a co-planarized surface 31720B, thereby flattening the entire device surface to facilitate the distribution of the metal layer and reduce the resistance. In addition, the glue layer can also serve as a cushioning layer to protect the chip in the subsequent die attach process. In addition, due to the application of the glue layer, the thickness of the semiconductor light emitting device can be increased, and the overall capacitance value of the semiconductor light emitting device 31000 can be further reduced.

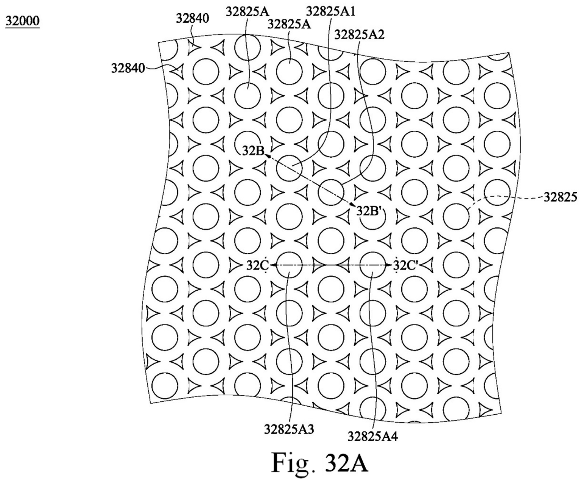

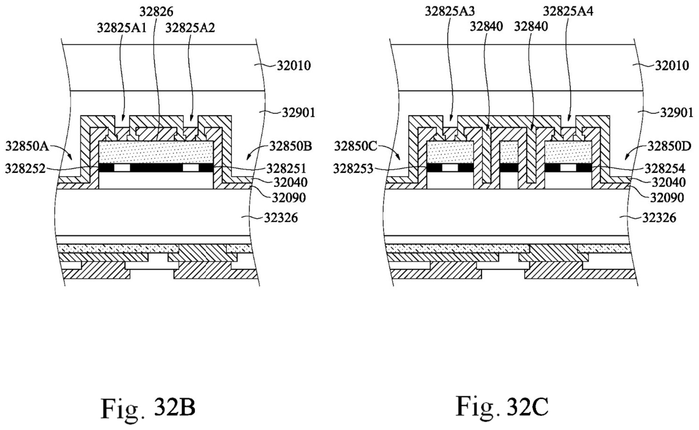

In one or more embodiments, the light emitting device may be a semiconductor light emitting element, as shown in FIGS. 32A to 32C. Fig. 32A is a schematic diagram of a top perspective view of a semiconductor light emitting element 32000 according to an embodiment, and FIGS. 32B and 32C are schematic cross-sectional views along the line segments 32B-32B' and 32C-32C' in Figure 32A, respectively. In this embodiment, as shown in FIGS. 32B and 32C, the semiconductor light emitting element 32000 is a flip-chip laser element, and subsequently the semiconductor light emitting element 32000 may be bonded to an external carrier (e.g., a printed circuit board or a driver chip 21010 as shown in Fig. 21) using solder by a flip-chip bonding process.

Please refer to the embodiment shown in FIGS. 32A to 32C, which are top view schematic diagrams and cross-sectional schematic diagrams of a semiconductor light emitting element 32000 of another embodiment, wherein Fig. 32A is a top perspective schematic diagram of the semiconductor light emitting element 32000, and FIGS. 32B and 32C are cross-sectional schematic diagrams along the sections indicated by the line segments 32B-32B' and 32C-32C' in Fig. 32A, respectively.

According to one or more embodiments of the present application, when forming the light-emitting holes of the semiconductor light-emitting element, the structural design of the light-emitting area can be adjusted to change the positions and number of the light-emitting holes, so as to further increase the density of the light-emitting holes in the light-emitting area and the flexibility of addressing control, wherein the light-emitting holes are formed by, for example, utilizing a wet oxidation process.

In the embodiment shown in Fig. 32A, the semiconductor light emitting device 32000 includes a plurality of light emitting holes 32825A, for example, the openings 32825A1, 32825A2, 32825A3, and 32825A4 shown in Fig. 32B and Fig. 32C, and the light emitting holes 32825A are arranged in an array. In the top view shown in Fig. 32A, the plurality of openings (light emitting holes) 32825A in the semiconductor light emitting device 32000 are arranged in a densest packing manner, for example, the plurality of openings 32825A are arranged in a hexagonal densest packing manner, that is, six adjacent openings 32825A are formed around each opening 32825A, and each opening 32825A is surrounded by six recess structures 32840, wherein the recess structures 32840 are used to perform an oxidation process to form a current restriction region in each current confinement layer 328251-328254 in the semiconductor light emitting device 32000, but the present invention is not limited thereto. In this way, six concave structures are formed in the epitaxial structure around each light-emitting hole, which are evenly distributed (i.e., arranged at 60 degrees around). The wet oxidation process can form a roughly circular opening (i.e., the light-emitting hole of the semiconductor light-emitting element) in the semiconductor light-emitting element epitaxial structure. According to one or more embodiments of the present application, each recessed structure is shared by two adjacent light-emitting holes, so that the multiple light-emitting holes in the semiconductor light-emitting element of the present application can be arranged in the most densely packed manner, thereby reducing the layout space of the light-emitting hole structure in the semiconductor light-emitting element.

As shown in Fig. 32B, in the cross-section shown by the line segment 32B-32B' in Figure 32A, there is no recessed structure between the openings (i.e., light-emitting holes) 32825A1 and 32825A2, that is, the current restriction regions in the current confinement layers 328252 and 328251 are respectively formed by the outer wall surfaces of the recessed structures 32850A and 32850B on both sides of the same platform structure 32826 through a wet oxidation process, thereby making the openings (i.e., light-emitting holes) 32825A1 and 32825A2 located on the same platform structure 32826. As shown in Fig. 32C, in the cross-section shown by the line segment 32C-32C' in Fig. 32A, in addition to the recessed structures 32850C and 32850D on the outside, two recessed structures 32840 are formed between the opening 32825A3 and the adjacent opening 32825A4, that is, the outer wall surface of the recessed structure 32850C and the side wall surface of the recessed structure 32840 are processed by a wet oxidation process to form a current restriction region in the current confinement layer 328253 to define the opening 32825A3; the side wall surface of the recessed structure 32840 and the outer wall surface of the recessed structure 32850D are processed by a wet oxidation process to form a current confinement layer 328254 to define the opening 32825A4. In one embodiment, two adjacent openings may share a concave structure therebetween, or there may be only one concave structure between two adjacent openings, so as to further reduce the distance between the adjacent openings and make the light-emitting holes of the semiconductor light-emitting element more closely arranged.

As shown in Fig. 32B and Fig. 32C, the semiconductor light emitting device 32000 of this embodiment further includes a metal connection layer 32040 located between the platform structure 32326 and the base layer 32010. As shown in Fig. 32B and Fig. 32C, the semiconductor light emitting device 32000 of this embodiment further includes an adhesive layer 32901, and the platform structure 32326 is connected to the base layer 32010 via the adhesive layer 32901. As shown in Fig. 32B and Fig. 32C, the semiconductor light emitting device 32000 of this embodiment further includes an insulating layer 32090, which covers the side and upper surface of the epitaxial structure, and the insulating layer 32090 is transparent to the light emitted from each epitaxial structure.

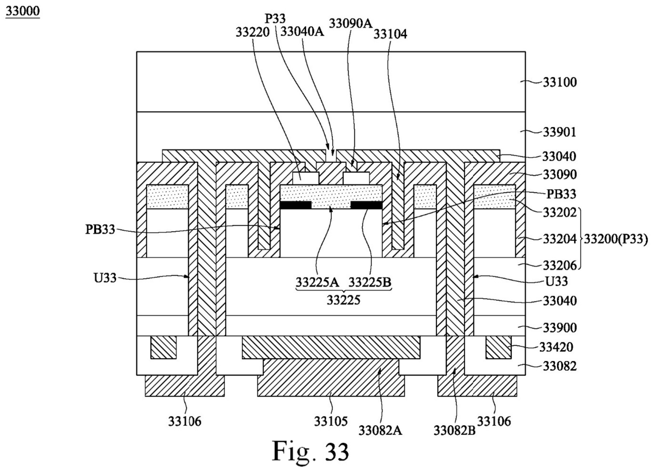

In one or more embodiments, the light emitting device may be a semiconductor light emitting element 33000, as shown in Fig. 33. Fig. 33 is a schematic cross-sectional view of a semiconductor light emitting element according to an embodiment. In this embodiment, a semiconductor light emitting element 33000 is provided. The semiconductor light emitting element 33000 includes a semiconductor stacking layer 33200 formed on a growth substrate 33900, and the semiconductor stacking layer 33200 sequentially includes a semiconductor layer 33206, an active layer 33204, and a semiconductor layer 33202 located on the growth substrate 33900. Next, a portion of the epitaxial columnar structure P33 to be subsequently formed on the semiconductor light emitting element 33000 is formed. The corresponding contact structure 33220 is formed. Then, an insulating layer 33090 is formed on the contact structure 33220 and the semiconductor stack layer 33200 as a protective layer. Then, an etching process is performed to form a through hole U33, thereby exposing the end face of the growth substrate 33900, wherein the shape of the through hole is not limited; in other words, the shape of the through hole can be a circular arc columnar hole, a polygonal columnar hole, or a columnar hole of any shape. Then, an etching process is further performed to form an epitaxial columnar structure P33 and a recessed structure 33104 to expose a portion of the end face of the semiconductor layer 33206, and the epitaxial columnar structure P33 has a side surface PB33.

Next, a current confinement layer is formed in the epitaxial columnar structure P33 using a wet oxidation process. In this embodiment, a current confinement layer 33225 is formed between the semiconductor layer 33202 and the active layer 33204, and the current confinement layer 33225 includes a current restriction region 33225B and a current conduction region 33225A surrounded by the current restriction region 33225B. An insulating layer 33090 is formed in the through hole U33 and the recessed structure 33104, and covers the side surface PB33 of the epitaxial columnar structure P33, the end surface of the semiconductor layer 33206, and the end surface of the growth substrate 33900. Next, an insulating layer opening 33090A is formed in the insulating layer 33090 to expose a portion of the surface of the contact structure 33220, wherein the top view shape of the insulating layer opening 33090A may be, for example, an annular shape, a circular shape, an elliptical shape, a square shape, an irregular shape, etc. In this embodiment, the shape of the insulating layer opening 33090A is ring-shaped when viewed from above, but the present invention is not limited thereto.

Next, a metal connection layer 33040 is formed on the insulating layer 33090. The metal connection layer 33040 covers the insulating layer 33090 and fills the insulating layer opening 33090A to connect with the contact structure 33220, thereby further electrically connecting with the semiconductor layer 33202. The metal connection layer 33040 has a connection layer opening 33040A above the epitaxial columnar structure P33. The position of the connection layer opening 33040A corresponds to the position of the current conduction area 33225A, and exposes the insulating layer 33090 below. Next, the epitaxial columnar structure P33 and the semiconductor layer 33206 are bonded to the substrate 33100 by the adhesive layer 33901. In the present embodiment, the substrate 33100 is a permanent substrate.

Next, a portion of the growth substrate 33900 is removed to expose a portion of the surface of the metal connection layer 33040 and the insulating layer 33090. In the present embodiment, the growth substrate 33900 is, for example, a GaAs substrate. Next, an electrode connection layer 33420 is formed on the substrate 33900. Next, an insulating layer 33082 is formed to cover a portion of the electrode connection layer 33420. A plurality of openings 33082A and 33082B are provided in the insulating layer 33082 to expose at least a portion of the electrode connection layer 33420 and the metal connection layer 33040, respectively.

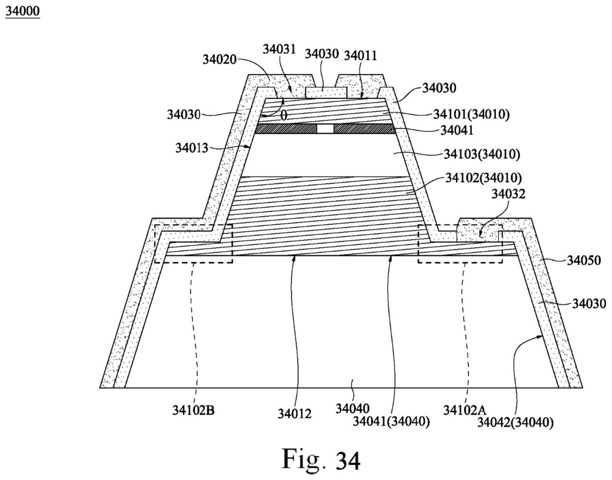

Finally, the openings 33082A and 33082B are filled with conductive materials to form electrode structures 33105 and 33106 of semiconductor light emitting elements, respectively, as shown in Fig. 33. In one or more embodiments, the light emitting device may be a semiconductor laser, as shown in Fig. 34. Please refer to Fig. 34. Fig. 34 is a cross-sectional schematic diagram of a semiconductor laser element 34000 according to an embodiment. The semiconductor laser element 34000 includes a semiconductor stack layer 34010, an electrode structure 34020, an insulating layer 34030, and a base layer 34040. The semiconductor stack layer 34010 includes a first type semiconductor layer 34101, a second type semiconductor layer 34102, and an active layer 34103, wherein the active layer 34103 is located between the first type semiconductor layer 34101 and the second type semiconductor layer 34102. In this embodiment, as shown in Fig. 34, the first type semiconductor layer 34101 is, for example, a P-type semiconductor layer, and the second type semiconductor layer 34102 is, for example, an N-type semiconductor layer, but the present invention is not limited thereto, that is, in another embodiment, the first type semiconductor layer 34101 is, for example, an N-type semiconductor layer, and the second type semiconductor layer 34102 is, for example, a P-type semiconductor layer.

In this embodiment, as shown in Fig. 34, the base layer 34040 may be a semiconductor layer, and may be a growth substrate for the semiconductor stack layer 34010. In one or more other embodiments, the base layer 34040 may also be a packaging substrate for the semiconductor stack layer 34010, that is, the semiconductor stack layer 34010 is first grown on the growth substrate and then transferred to the base layer 34040.

Please refer to the embodiment of Fig. 34 again. The semiconductor laser device 34000 further includes an electrode structure 34050 located on the surface 34011 and the side surface 34013, and the insulating layer 34030 is located between the semiconductor stack layer 34010 and the electrode structure 34050.

In some embodiments, as shown in Fig. 34, the base layer 34040 is conductive or insulating. As shown in Fig. 34, the base layer 34040 has a surface 34041 and a side surface 34042 connected to the surface 34041. The second type semiconductor layer 34102 in the semiconductor stack layer 34010 further includes plateau portions 34102A and 34102B extending laterally and distributed on the surface 34041. The insulating layer 34030 and the electrode structure 34050 are further located on the surface of the plateau portions 34102A and 340102B. The insulating layer 34030 has an insulating layer opening 34032 on the plateau portion 340102A, and the electrode structure 34050 is distributed in the insulating layer opening 34032 and contacts the plateau portion 34102A of the second type semiconductor layer 34102. In the present embodiment, the electrode structure 34050 is not only located in the insulating layer opening 34032 of the insulating layer 34030, but also extends to the side surface 34042 of the base layer 34040. The electrode structure 34020 also extends from the side surface 34013 of the semiconductor stack layer 34010 through the plateau portion 34102B to the side surface 34042 of the base layer 34040. Therefore, according to the semiconductor laser device 34000 of the present embodiment, the respective bonding areas between the electrode structure 34020 and the electrode structure 34050 of the semiconductor laser device 34000 and the carrier (such as a printed circuit board or the driver chip 21010 shown in Fig. 21), by flip-chip bonding or by lateral solder bonding, can be further increased.

The above description of the embodiments of the present application is provided for the purpose of illustration and description. It is not exhaustive and is not intended to limit the embodiments of the present invention to the precise form disclosed in the present application.

It is obvious to those skilled in the art that various modifications, changes or combinations may be made to the above embodiments based on the above description of the embodiments.

## Claims

1. A packaging structure, comprising:
a light-emitting epitaxial structure, comprising an upper distributed Bragg reflector (DBR), an active structure and a lower distributed Bragg reflector stacked in sequence;
a light receiving structure, located under the active structure and contacting the light emitting epitaxial structure;
a first conductive structure, contacting the upper distributed Bragg reflector;
a second conductive structure, contacting the lower surface of the light receiving structure; and
a third conductive structure, contacting the upper surface of the lower distributed Bragg reflector,
wherein the first conductive structure is insulated from the second conductive structure, the first conductive structure is insulated from the third conductive structure, and the second conductive structure is insulated from the third conductive structure,
a transparent substrate, connected to the light-emitting epitaxial structure via a first adhesive layer, wherein the transparent substrate and the first adhesive layer are transparent to the light emitted from the light-emitting epitaxial structure.

2. The package structure according to claim 1, wherein the upper distributed Bragg reflector comprises a P-type semiconductor structure, and the lower distributed Bragg reflector comprises an N-type semiconductor structure.

3. The packaging structure according to claim 2, wherein the first conductive structure is a P-electrode of the light-emitting epitaxial structure.

4. The packaging structure according to claim 2, wherein the second conductive structure is an N-electrode of the light receiving structure.

5. The packaging structure according to claim 2, wherein the third conductive structure is a common electrode of the light-emitting epitaxial structure and the light-receiving structure.

6. The packaging structure according to claim 1, wherein the light receiving structure is integrally formed as a part of the lower distributed Bragg reflector.

7. The packaging structure according to claim 1, wherein the light receiving structure is connected to the lower distributed Bragg reflector through a second adhesive layer.

8. The package structure according to claim 7, wherein the second adhesive layer is conductive.

9. The packaging structure according to claim 8, further comprising another distributed Bragg reflector located under the light receiving structure.

10. A packaging structure, comprising:
a plurality of optoelectronic units, each of which comprising:
a light-emitting epitaxial structure, wherein the light-emitting epitaxial structure comprises an upper distributed Bragg reflector, an active structure and
a lower distributed Bragg reflector stacked in sequence;
a light-receiving structure, located under the active structure and contacts the light-emitting epitaxial structure;
a first conductive structure contacts the upper distributed Bragg reflector;
a second conductive structure contacts the lower surface of the light-receiving structure; and
a third conductive structure contacts the upper surface of the lower distributed Bragg reflector;
wherein the first conductive structure is insulated from the second conductive structure, the first conductive structure is insulated from the third conductive structure, and the second conductive structure is insulated from the third conductive structure;
wherein the third conductive structure is a common electrode of the light-emitting epitaxial structure and the light-receiving structure.

## Amended claims

### Amended claims under Art. 19.1 PCT

1. A packaging structure, comprising:
a light-emitting epitaxial structure, comprising an upper distributed Bragg reflector (DBR), an active structure and a lower distributed Bragg reflector stacked in sequence;
a light receiving structure, located under the active structure and contacting the light emitting epitaxial structure;
a first conductive structure, contacting the upper distributed Bragg reflector;
a second conductive structure, contacting the lower surface of the light receiving structure; and
a third conductive structure, contacting the upper surface of the lower distributed Bragg reflector,
wherein the first conductive structure is insulated from the second conductive structure, the first conductive structure is insulated from the third conductive structure, and the second conductive structure is insulated from the third conductive structure,
a transparent substrate, connected to the light-emitting epitaxial structure via a first adhesive layer, wherein the transparent substrate and the first adhesive layer are transparent to the light emitted from the light-emitting epitaxial structure.

2. The package structure according to claim 1, wherein the upper distributed Bragg reflector comprises a P-type semiconductor structure, and the lower distributed Bragg reflector comprises an N-type semiconductor structure.

3. The packaging structure according to claim 2, wherein the first conductive structure is a P-electrode of the light-emitting epitaxial structure.

4. The packaging structure according to claim 2, wherein the second conductive structure is an N-electrode of the light receiving structure.

5. The packaging structure according to claim 2, wherein the third conductive structure is a common electrode of the light-emitting epitaxial structure and the light-receiving structure.

6. The packaging structure according to claim 1, wherein the light receiving structure is integrally formed as a part of the lower distributed Bragg reflector.

7. The packaging structure according to claim 1, wherein the light receiving structure is connected to the lower distributed Bragg reflector through a second adhesive layer.

8. The package structure according to claim 7, wherein the second adhesive layer is conductive.

9. The packaging structure according to claim 8, further comprising another distributed Bragg reflector located under the light receiving structure.

10. A packaging structure, comprising:
a plurality of optoelectronic units, each of which comprising:
a light-emitting epitaxial structure, wherein the light-emitting epitaxial structure comprises an upper distributed Bragg reflector, an active structure and a lower distributed Bragg reflector stacked in sequence;
a light-receiving structure, located under the active structure and contacts the light-emitting epitaxial structure;
a first conductive structure contacts the upper distributed Bragg reflector;
a second conductive structure contacts the lower surface of the light-receiving structure; and
a third conductive structure contacts the upper surface of the lower distributed Bragg reflector;
wherein the first conductive structure is insulated from the second conductive structure, the first conductive structure is insulated from the third conductive structure, and the second conductive structure is insulated from the third conductive structure;
wherein the third conductive structure is a common electrode of the light-emitting epitaxial structure and the light-receiving structure.

11. The packaging structure according to claim 10, wherein the upper distributed Bragg reflector comprises a P-type semiconductor structure, and the lower distributed Bragg reflector comprises an N-type semiconductor structure.

12. The packaging structure according to claim 11, wherein the first conductive structure is a P-electrode of the light-emitting epitaxial structure.

13. The packaging structure according to claim 11, wherein the second conductive structure is the N-electrode of the light receiving structure.

14. The packaging structure according to claim 10, wherein the light receiving structure is integrally formed as a part of the lower distributed Bragg reflector.

15. The packaging structure according to claim 10, further comprising:
a transparent substrate, connected to the light emitting epitaxial structure by a first adhesive layer,
wherein the transparent substrate and the first adhesive layer are transparent to the light emitted from the light emitting epitaxial structure.

16. The packaging structure according to claim 10, wherein the light receiving structure is connected to the lower distributed Bragg reflector by a second adhesive layer.

17. The packaging structure according to claim 16, wherein the second bonding layer is conductive.

18. The packaging structure according to claim 17, further comprising another distributed Bragg reflector located under the light receiving structure.
